(19) Europäisches Patentamt
European Patent Office
Office européen des brevets

(11) EP 3 125 277 B1

(12) # EUROPEAN PATENT SPECIFICATION

(45) Date of publication and mention of the grant of the patent:
**03.06.2020 Bulletin 2020/23**

(21) Application number: **15769500.8**

(22) Date of filing: **23.03.2015**

(51) Int Cl.:
***C08F 212/14*** (2006.01) ***C08F 12/24*** (2006.01)
***H01L 21/02*** (2006.01) ***H01L 51/00*** (2006.01)
***H01L 51/05*** (2006.01)

(86) International application number:
**PCT/JP2015/058775**

(87) International publication number:
**WO 2015/146926 (01.10.2015 Gazette 2015/39)**

(54) **SEMICONDUCTOR ELEMENT COMPRISING INSULATING LAYER-FORMING COMPOSITION**

HALBLEITERELEMENT ENTHALTEND ISOLIERSCHICHT FORMENDE ZUSAMMENSETZUNG

ÉLÉMENT SEMI-CONDUCTEUR COMPRENANT COMPOSITION DE FORMATION DE COUCHE ISOLANTE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.03.2014 JP 2014064561**

(43) Date of publication of application:
**01.02.2017 Bulletin 2017/05**

(73) Proprietor: **FUJIFILM Corporation**
**Tokyo 106-8620 (JP)**

(72) Inventors:
- **NAGATA, Yuzo**
  **Ashigarakami-gun**
  **Kanagawa 258-8577 (JP)**
- **TAKIZAWA, Hiroo**
  **Ashigarakami-gun**
  **Kanagawa 258-8577 (JP)**
- **TSUCHIMURA, Tomotaka**
  **Ashigarakami-gun**
  **Kanagawa 258-8577 (JP)**
- **TSURUTA, Takuya**
  **Ashigarakami-gun**
  **Kanagawa 258-8577 (JP)**

(74) Representative: **Hoffmann Eitle**
**Patent- und Rechtsanwälte PartmbB**
**Arabellastraße 30**
**81925 München (DE)**

(56) References cited:
**WO-A1-2014/017268** **WO-A1-2014/030441**
**WO-A1-2014/030441** **DE-A1-102010 034 577**
**JP-A- 2013 140 336** **JP-A- 2014 024 999**
**US-B1- 6 686 124**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 125 277 B1

## Description

### BACKGROUND OF THE INVENTION

1. Field of the Invention

The present invention relates to a semiconductor element and an insulating layer-forming composition.

2. Description of the Related Art

Display devices such as a liquid crystal display, an organic EL display, and an electrophoretic type display, or the like devices are provided with a semiconductor element such as a thin film transistor (hereinafter, referred to as "TFT") therein.

The TFT has a structure including a gate electrode, a gate insulating layer, a source electrode, and a drain electrode, in which the source electrode and the drain electrode are connected via a semiconductor layer.

When a voltage is applied to the gate electrode, the flow path (channel) of an electric current is formed at the interface between the semiconductor layer disposed between the source electrode and the drain electrode, and the gate insulating layer adjacent to the semiconductor layer. In other words, an electric current flowing between the source electrode and the drain electrode is controlled in response to an input voltage applied to the gate electrode. In this way, the gate insulating layer provided adjacent to the semiconductor layer has a function of forming the flow path of an electric current together with the semiconductor layer.

Therefore, a gate insulating layer or a gate insulating layer-forming material has become important in order to improve performance of TFTs.

For example, JP2013-102116A discloses an organic thin film transistor insulating layer material including a polymer compound containing a repeating unit having a cyclic ether structure and a repeating unit having an organic group to be eliminated by an acid.

The above-mentioned point that an insulating layer or an insulating layer-forming material is important for improvement of performance is also common to cases other than TFTs, without limitation to TFTs as long as the semiconductor element is a semiconductor element having an insulating layer provided adjacent to a semiconductor layer.

WO 2014/017268 A1 is related to a resin composition and a pattern forming method using the same. The resin composition includes a polymer compound containing a specific repeating unit.

JP 2013-140336 A is related to the process of manufacturing a resin pattern wherein a resin is applied.

US 6,686,124 B1 describes a multifunctional polymer comprising a polymeric chain having chromophore groups and crosslinking sites which is used as a resist material and especially as an underlayer for a bilayer and the top surface imaging strategies.

DE 10 2010 034 577 A1 discloses a process of ultrathin, crosslinkable polymer layers which can be crosslinked by thermal or UV treatment in the layer.

### SUMMARY OF THE INVENTION

In recent years, achieving high performance of display devices or the like has progressed rapidly, and correspondingly achieving such high performance is also required for semiconductor elements used in display devices or the like.

An object of the present invention is to provide a semiconductor element exhibiting high carrier mobility and also an excellent on/off ratio.

Another object of the present invention is to provide an insulating layer-forming composition which is capable of forming an insulating layer having excellent solvent resistance and surface smoothness and also excellent insulating properties.

The present inventors have found that, with respect to a polymer compound having a repeating unit having a hydroxyl group bonded directly to an aromatic ring (phenolic hydroxyl group) and a specific repeating unit having a crosslinkable group capable of undergoing a crosslinking reaction with such a repeating unit, those repeating units are subjected to a crosslinking reaction to give a crosslinked product, whereby it is possible to form a gate insulating layer exhibiting a smooth surface and also high solvent resistance. Further, the present inventors have found that TFTs having a gate insulating layer formed of a crosslinked product of such a polymer compound exhibit high carrier mobility and also an excellent on/off ratio. Moreover, the present inventors have found that a composition containing the above-mentioned polymer compound is capable of forming an insulating layer having an excellent solvent resistance and excellent surface smoothness and is excellent as a composition for forming an insulating layer (gate insulating layer) of TFTs. The present invention has been completed based on these findings.

The above-mentioned objects have been achieved by the following means.

[1] A semiconductor element comprising:

a semiconductor layer; and
an insulating layer adjacent to the semiconductor layer,
in which the insulating layer is formed of a crosslinked product of a polymer compound having a repeating unit (IA) represented by the following General Formula (IA) and a repeating unit (IB) represented by the following General Formula (IB).

3

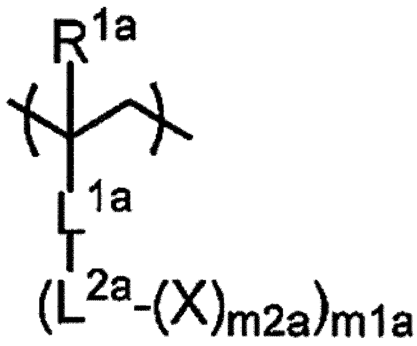

General Formula (IA)

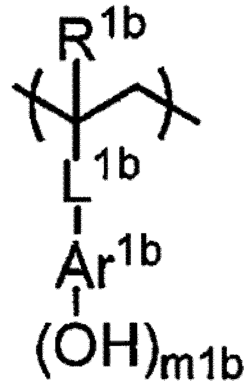

General Formula (IB)

In General Formula (IA), $R^{1a}$ represents a hydrogen atom, a halogen atom, or an alkyl group. $L^{1a}$ and $L^{2a}$ each independently represent a single bond or a linking group. X represents a crosslinkable group which is a hydroxymethyl group or an alkoxymethyl group. m2a represents an integer of 1 to 5, and in a case where m2a is 2 or more, m2a number of X's may be the same or different from each other. m1a represents an integer of 1 to 5, and in a case where m1a is 2 or more, m1a number of $(-L^{2a}-(X)_{m2a})$'s may be the same or different from each other.
In General Formula (IB), $R^{1b}$ represents a hydrogen atom, a halogen atom, or an alkyl group. $L^{1b}$ represents a single bond or a linking group, and $Ar^{1b}$ represents an aromatic ring. m1b represents an integer of 1 to 5.
[2] The semiconductor element according to [1], in which $L^{1a}$ is represented by the following Formula (1a).

Formula (1a) $*-Ar^{1a}-L^{3a}-**$

In Formula (Ia), $L^{3a}$ represents a single bond or a linking group. $Ar^{1a}$ represents an aromatic ring. * indicates the bonding position of the carbon atom to which $R^{1a}$ in the repeating unit (IA) is bonded, and ** indicates the bonding position of $L^{2a}$ in the repeating unit (IA).
[3] The semiconductor element according to [2], in which $Ar^{1a}$ is a benzene ring.
[4] The semiconductor element according to any one of [1] to [3], in which the repeating unit (IA) is a repeating unit (IA-1) represented by the following General Formula (IA-1).

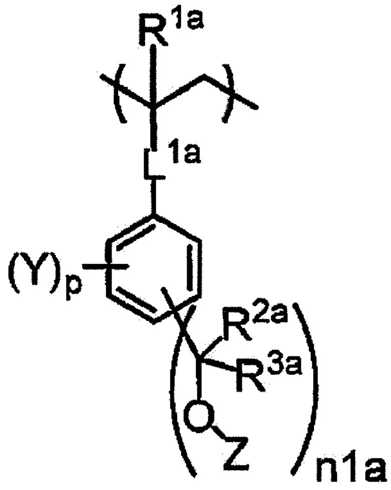

General Formula (IA-1)

In General Formula (IA-1), $L^{1a}$ has the same definition as $L^{1a}$ of General Formula (IA). $R^{2a}$ and $R^{3a}$ each independently represent a hydrogen atom or a methyl group. Z represents a hydrogen atom or a substituent. Y represents a monovalent substituent. n1a represents an integer of 1 to 5. p represents an integer of 0 to 4. In a case where n1a is 2 or more, n1a number of $R^{2a}$'s and $R^{3a}$'s and also Z's may be the same or different from each other, respectively. In a case where p is 2 or more, p number of Y's may be the same or different from each other.

[5] The semiconductor element according to any one of [1] to [3], in which the repeating unit (IA) is a repeating unit (IA-2) represented by the following General Formula (IA-2).

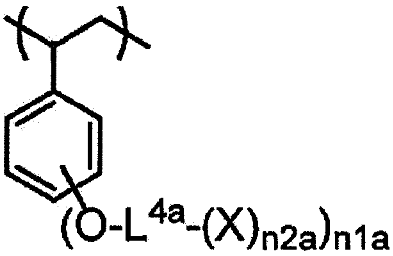

General Formula (IA-2)

In General Formula (IA-2), $L^{4a}$ represents a single bond or a linking group. X represents a crosslinkable group. n2a represents an integer of 1 to 5, and in a case where n2a is 2 or more, n2a number of X's may be the same or different from each other. n1a represents an integer of 1 to 5, and in a case where n1a is 2 or more, n1a number of $(-O-L^{4a}-(X)_{n2a})$'s may be the same or different from each other.

[6] The semiconductor element according to any one of [1] to [5], in which the crosslinked product is a crosslinked product by a crosslinking reaction between the crosslinkable group X of the repeating unit (IA) and the repeating unit (IB).

[7] The semiconductor element according to [6], in which the crosslinked product has a crosslinked portion where a hydroxymethyl group or an alkoxymethyl group as a crosslinkable group is formed by a reaction.

[8] The semiconductor element according to any one of [1] to [7], in which the semiconductor layer contains an organic semiconductor.

In the description of the present invention, when a substituent or linking group or the like represented by a specific symbol (hereinafter, referred to as a substituent or the like) is present in plural number, or when a plurality of substituents or the like are simultaneously defined, this means that each substituent or the like may be the same or different from each other. This also applies to the rule of the number of substituents or the like. Further, in a case where there is a repetition of a plurality of partial structures represented by the same expression in the formula, each partial

structure or repeating unit may be the same or different. In addition, unless otherwise specified, when a plurality of substituents or the like are close (especially adjacent), this means that they may be connected or fused to each other to form a ring.

The expression of a compound in this specification is intended to encompass a relevant compound itself, as well as salts thereof and ions thereof. Furthermore, it is meant to encompass those structures which are partially modified within a range exhibiting the desired effect.

In this specification, when a substituent (the same for a linking group) is denoted without specifying whether it is substituted or unsubstituted, this refers to that the group may have any substituent within the range exhibiting the desired effect. The same definition applies to a compound which is denoted without specifying whether being substituted or unsubstituted.

The numerical range expressed by using "to" in this specification means a range including numerical values shown before and after "to" as the lower limit and the upper limit.

The semiconductor element of the present invention exhibits high carrier mobility and also an excellent on/off ratio.

Further, the insulating layer-forming composition of the present invention is capable of forming an insulating layer having excellent solvent resistance and surface smoothness.

These and other features and advantages of the present invention will become more apparent from the following detailed description, with appropriate reference to the accompanying drawings.

## BRIEF DESCRIPTION OF THE DRAWINGS

Figs. 1A to 1D schematically show a form of an organic thin film transistor which is an example of a semiconductor element of the present invention.

## DESCRIPTION OF THE PREFERRED EMBODIMENTS

[Semiconductor Element]

The semiconductor element of the present invention is not particularly limited as long as it is an element having a semiconductor layer and an insulating layer adjacent to the semiconductor layer. From the viewpoint of improving effects of carrier mobility and on/off ratio, a TFT is preferred, and an organic thin film transistor (referred to as OTFT), which is formed of an organic material, is particularly preferred.

Hereinafter, a description will be made on a TFT as the preferred semiconductor element of the present invention, but the semiconductor element of the present invention is not limited thereto.

The TFT of the present invention has a gate electrode, a semiconductor layer, a gate insulating layer provided between the gate electrode and the semiconductor layer, and a source electrode and a drain electrode provided in contact with the semiconductor layer and connected via the semiconductor layer, on a substrate. In TFTs, semiconductor layer 1 and the gate insulating layer are typically provided adjacent to each other. In such TFTs, an electric current flowing between the source electrode and the drain electrode is controlled in the manner as described above.

The preferred form of the TFT of the present invention will be described with reference to the drawings. The TFT shown in each drawing is a schematic diagram for facilitating the understanding of the present invention, and there is a case where, in the drawings, sizes of individual members, relative magnitude relationship between individual members, or the like has been changed in terms of magnitude for the convenience of explanation, thus not showing actual relationship between individual members. Further, the TFT is not limited to the shape and outer shape shown in these drawings, except for the particulars defined in the present invention. For example, in Figs. 1A and 1B, the gate electrode 5 is not necessarily required to completely cover the substrate 6, and a gate electrode in the form provided at the central portion of the substrate 6 is also preferred as a form of the TFT of the present invention.

Figs. 1A to 1D are each a longitudinal sectional view schematically showing representative preferred forms of TFTs. Referring to Figs. 1A to ID, 1 denotes a semiconductor layer, 2 denotes a gate insulating layer, 3 denotes a source electrode, 4 denotes a drain electrode, 5 denotes a gate electrode, and 6 denotes a substrate.

Further, Fig. 1A shows a bottom gate-bottom contact type TFT, Fig. 1B shows a bottom gate-top contact type TFT, Fig. 1C shows a top gate-bottom contact type TFT, and Fig. 1D shows a top gate-top contact type TFT.

The TFT of the present invention encompasses all of the above-described four forms. Although not shown, there may be a case where an overcoat layer is formed on the top of each TFT in the drawings (top of the opposite side with respect to the substrate 6).

The bottom gate type is one in which a gate electrode 5, a gate insulating layer 2, and a semiconductor layer 1 are arranged in this order on a substrate 6. Meanwhile, the top gate type is one in which a semiconductor layer 1, a gate insulating layer 2, and a gate electrode 5 are arranged in this order on a substrate 6.

In addition, the bottom contact type is one in which a source electrode 3 and a drain electrode 4 are arranged on a substrate 6 side with respect to a semiconductor layer 1 (that is, downward in Figs. 1A to ID). Meanwhile, the top contact type is one in which a source electrode 3 and a drain electrode 4 are arranged on the opposite side of a substrate 6 with respect to a semiconductor layer 1.

In a case where a semiconductor layer 1, a gate insulating layer 2, or the like is formed of an organic material, the TFT is particularly referred to as an OTFT. In this case, a semiconductor layer formed of an organic material is sometimes referred to as an organic semiconductor layer.

[Substrate]

The substrate may be one capable of supporting a TFT and a display panel or the like fabricated thereon. The substrate is not particularly limited as long as it has insulating properties on the surface thereof, is sheet-like, and is of a flat surface.

The material used for the substrate may be an inorganic material. Examples of the substrate made of an inorganic material include various glass substrates such as soda-lime glass and quartz glass, various glass substrates having an insulating film formed on the surface thereof, a silicon substrate having an insulating film formed on the surface thereof, a sapphire substrate, a metal substrate made of various alloys and various metals such as stainless steel, aluminum, or nickel, metal foil, and paper.

In a case where the substrate is formed of a conductive or semi-conductive material such as stainless sheet, aluminum foil, copper foil, or silicon wafer, the substrate is typically used by coating or laminating an insulating polymer material, metal oxide, or the like on the surface thereof.

Further, the material used for the substrate may be an organic material. The substrate made of an organic material may be, for example, a plastic substrate (also referred to as a plastic film or a plastic sheet) having flexibility and constituted of an organic polymer which is exemplified by polymethylmethacrylate (polymethacrylic acid methyl, PMMA), polyvinyl alcohol (PVA), polyvinylphenol (PVP), polyether sulfone (PES), polyimide, polyamide, polyacetal, polycarbonate (PC), polyethylene terephthalate (PET), polyethylene naphthalate (PEN), polyethyl ether ketone, polyolefin, and polycycloolefin. A further example thereof may be a substrate formed of mica.

Use of such a flexible plastic substrate or the like allows for incorporation or integration of a TFT into a display device or electronic device having, for example, a curved shape.

The organic material forming the substrate is preferably a material having a high glass transition point, and preferably a material having a glass transition point of 40°C or higher, from the viewpoint of poor softening during lamination of other layers or during heating. Moreover, a material having a small linear expansion coefficiency is preferred from the viewpoint of hardly undergoing a dimensional change due to heat treatment during manufacture and exhibiting excellent stability of transistor performance. For example, the substrate material is preferably a material having a linear expansion coefficiency of $25\times10^{-5}$cm/cm·°C or less, and more preferably a material having $10\times10^{-5}$cm/cm·°C or less.

Further, the organic material constituting the substrate is preferably a material having resistance to a solvent used at the time of TFT manufacturing, and is also preferably a material having excellent adhesiveness with a gate insulating layer and an electrode.

Furthermore, it is also preferred to use a plastic substrate made of an organic polymer having high gas barrier properties.

It is also preferred that at least one surface of the substrate is provided with a dense silicon oxide film or the like, or is vapor-deposited or laminated with an inorganic material.

The substrate may be, for example, a conductive substrate (a substrate made of a metal such as gold or aluminum, a substrate made of highly oriented graphite, a stainless steel substrate, or the like), in addition to the above-described materials.

The substrate may have functional films such as a buffer layer for improving adhesiveness and flatness, and a barrier film for improving gas barrier properties. Further, a surface treatment layer such as an easily adhesive layer may be formed on the surface of the substrate. In addition, the substrate may be subjected to surface treatment such as corona treatment, plasma treatment, or UV/ozone treatment.

The thickness of the substrate is preferably 10 mm or less, more preferably 2 mm or less, and particularly preferably 1 mm or less. Further, on the other hand, the thickness of the substrate is preferably 0.01 mm or more, and more preferably 0.05 mm or more. Particularly, in a case of a plastic substrate, the thickness thereof is preferably about 0.05 mm to 0.1 mm. In a case of a substrate made of an inorganic material, the thickness thereof is preferably about 0.1 mm to 10 mm.

[Gate Electrode]

The gate electrode that can be used is a conventionally known electrode which is used as a gate electrode of

TFTs. The conductive material constituting the gate electrode (also referred to as an electrode material) is not particularly limited. Examples of the electrode material include a metal such as platinum, gold, silver, aluminum, chromium, nickel, copper, molybdenum, titanium, magnesium, calcium, barium, sodium, palladium, iron, or manganese; a conductive metal oxide such as $InO_2$, $SnO_2$, indium tin oxide (ITO), fluorine-doped tin oxide (FTO), aluminum-doped zinc oxide (AZO), or gallium-doped zinc oxide (GZO); a conductive polymer such as polyaniline, polypyrrole, polythiophene, polyacetylene, or poly(3,4-ethylenedioxythiophene)/polystyrene sulfonic acid (PEDOT/PSS); the above-described conductive polymer to which a dopant, for example an acid such as hydrochloric acid, sulfuric acid, or sulfonic acid, a Lewis acid such as $PF_6$, $AsF_5$, or $FeCl_3$, a halogen atom such as iodine, or a metal atom such as sodium or potassium has been added, and a conductive composite material in which carbon black, graphite powder, metal fine particles, or the like has been dispersed. These materials may be used singly or as a combination of two or more kinds in any combination and in any ratio.

Further, the gate electrode may be a single layer made of the above-described conductive material or may be a structure where two or more layers are laminated.

There is no limitation on the method of forming a gate electrode. An example thereof is a method of patterning a film, which has been formed by physical vapor deposition such as a vacuum vapor deposition method (PVD), a chemical vapor deposition method (CVD method), a sputtering method, a printing method (coating method), a transfer method, a sol-gel method, a plating method, or the like, into a desired shape, as necessary.

In the coating method, a solution, paste or dispersion liquid of the above-described materials is prepared and coated, followed by drying, calcination, photocuring or aging to form a film, or an electrode may be formed directly.

An ink jet printing, screen printing, (inversion) offset printing, letterpress printing, intaglio printing, planographic printing, thermal transfer printing, or microcontact printing method is capable of performing desired patterning, and is preferred from the viewpoints of process simplification, cost reduction, and high speed.

Even in a case of employing a spin coating method, a die coating method, a microgravure coating method, or a dip coating method, patterning may be performed by such a method in combination with the following photolithographic method or the like.

The photolithographic method may be, for example, a method of combining patterning of a photoresist with etching such as wet etching using an etching liquid or dry etching using reactive plasma, a lift-off method, or the like.

The other patterning method may also be a method of irradiating the above-described materials with energy rays such as laser light or an electron beam, followed by polishing, or modifying conductivity of a material.

Further, the patterning method also includes, for example a method of transferring a gate electrode composition printed on a support other than a substrate into an underlayer of the substrate or the like.

The thickness of the gate electrode is arbitrary, but it is preferably 1 nm or more, and particularly preferably 10 nm or more. On the other hand, the thickness of the gate electrode is preferably 500 nm or less, and particularly preferably 200 nm or less.

[Gate Insulating Layer]

The gate insulating layer is not particularly limited as long as it is a layer having insulating properties. The gate insulating layer may be a single layer or may be a multilayer.

<Crosslinked Product of Polymer Compounds>

The gate insulating layer is formed of the crosslinked product of a polymer compound having a repeating unit (IA) represented by the following General Formula (IA) and a repeating unit (IB) represented by the following General Formula (IB).

12

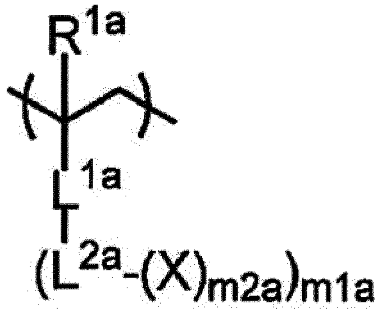

General Formula (IA)

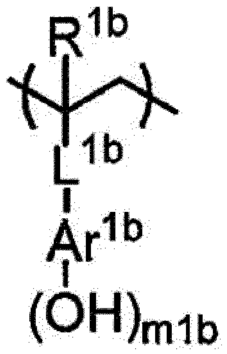

General Formula (IB)

In General Formula (IA), $R^{1a}$ represents a hydrogen atom, a halogen atom, or an alkyl group. $L^{1a}$ and $L^{2a}$ each independently represent a single bond or a linking group. X represents a crosslinkable group as defined above. m2a represents an integer of 1 to 5, and in case where m2a is 2 or more, m2a number of X's may be the same or different from each other. m1a represents an integer of 1 to 5, and in a case where m1a is 2 or more, m1a number of $(-L^{2a}-(X)_{m2a})$'s may be the same or different from each other.

In General Formula (IB), $R^{1b}$ represents a hydrogen atom, a halogen atom, or an alkyl group. $L^{1b}$ represents a single bond or a linking group, and $Ar^{1b}$ represents an aromatic ring. m1b represents an integer of 1 to 5.

The crosslinking reaction of a polymer compound is not particularly limited. For example, the crosslinking reaction may be a crosslinking reaction between repeating units of a polymer compound, or may be a crosslinking reaction between a crosslinking agent and a repeating unit which may exist together. In the present invention, the crosslinking reaction between the repeating unit (IA) and the repeating unit (IB) is preferred in terms of properties of a TFT. In this case, the crosslinking reaction between the repeating units may be an intramolecular reaction or an intermolecular reaction.

The crosslinking portion of the crosslinked product is a portion in which a hydroxymethyl group or an alkoxymethyl group as a crosslinkable group is formed by a reaction, and the crosslinking portion contains residues of a hydroxymethyl group or an alkoxymethyl group (both are methyleneoxy groups).

Formation of a gate insulating layer using the above-mentioned crosslinked product of a polymer compound results in a smooth surface thereof. Although details have not yet been clear, the reason for such smooth surface is assumed to be due to that surface energy of the crosslinked product resulting from the reaction of a"$Ar^{1b}-(OH)_{m1b}$" group of the repeating unit (IB) with the crosslinkable group X of the repeating unit (IA) is low, or that the"$Ar^{1b}-(OH)_{m1b}$" group does not have a protective group, and there is no generation of an adversely-affecting protective group decomposition product (low molecular weight component). Thus, if the surface of a gate insulating film becomes smooth, uniform alignment of a semiconductor provided adjacent thereto becomes easy, and therefore a carrier path is efficiently formed. As a result, it is thought that the carrier mobility of a TFT increases.

Furthermore, a TFT having a gate insulating layer formed of the above-mentioned crosslinked product of a polymer compound exhibits a high on/off ratio and therefore has excellent properties. Although details have not yet been clear, the reason for such excellent properties is considered as follows. That is, from the fact that a polymer compound has a crosslinkable group and a group to be crosslinked which form a bridge in the molecule (side chain), crosslinking reaction of the polymer compound becomes higher, resulting in an improved crosslinking rate of the crosslinked product of the polymer compound. This leads to improvement in film quality of a gate insulating layer, whereby interlayer mixing of the gate insulating layer and the semiconductor layer is inhibited. This may further result in improved insulation performance. As a result, it is considered that the on/off ratio of a TFT increases.

The content of the crosslinked product of a polymer compound in the insulating layer is not particularly limited as long as an insulating layer can be formed. From the viewpoint of carrier mobility and on/off ratio, the content of the crosslinked product is preferably 60 mass% to 100 mass%, more preferably 80 mass% to 100 mass%, and particularly preferably 80 mass% to 95 mass%, with respect to the solid content of the insulating layer.

The gate insulating layer contains one or two or more crosslinked products of polymer compounds.

The gate insulating layer may contain one or two or more foregoing polymer compounds which have not been crosslinked, in addition to the crosslinked product of a polymer compound.

<Repeating Unit (IA)>

A description will be made on the repeating unit (IA) which forms a polymer compound.

The alkyl group of $R^{1a}$ is not particularly limited, but it is preferably an alkyl group having 1 to 6 carbon atoms, more preferably an alkyl group having 1 to 4 carbon atoms, still more preferably methyl or ethyl, and particularly preferably methyl. The substituent which may be taken by the alkyl group includes a substituent T which will be described later.

The halogen atom may be a fluorine atom, a chlorine atom, a bromine atom, or the like, and is preferably a fluorine atom or a chlorine atom.

$R^{1a}$ is particularly preferably a hydrogen atom.

$L^{1a}$ is a single bond or a linking group, preferably a linking group, and more preferably a divalent linking group.

The linking group is not particularly limited, but it is preferably a carbonyl group, a thiocarbonyl group, an alkylene group (preferably having 1 to 10 carbon atoms, and more preferably having 1 to 5 carbon atoms), an aromatic ring, an aliphatic ring, a -O- group, a sulfonyl group, a -NH- group, or a combined group of these groups (preferably having a total number of 1 to 20 carbon atoms, and more preferably having a total number of 1 to 10 carbon atoms).

The aromatic ring may be an aromatic hydrocarbon ring or an aromatic heterocyclic ring. The aromatic ring may be monocyclic or polycyclic, and in a case of being polycyclic, the aromatic ring may be a fused ring. An aromatic hydrocarbon ring and an aromatic heterocyclic ring are preferred, and an aromatic hydrocarbon ring is more preferred. The aromatic hydrocarbon ring is preferably a benzene ring or a naphthalene ring, and particularly preferably a benzene ring. Examples of the aromatic heterocyclic ring include a thiophene ring, a furan ring, a pyrrole ring, a triazine ring, an imidazole ring, a triazole ring, a thiadiazole ring, and a thiazole ring.

The aliphatic ring may be an aliphatic hydrocarbon ring or an aliphatic heterocyclic ring. The aliphatic ring may be monocyclic or polycyclic, and in a case of being polycyclic, the aliphatic ring may be a fused ring. The aliphatic hydrocarbon ring may be cyclohexane or the like. Examples of the aliphatic heterocyclic ring include aliphatic heterocyclic rings among heterocyclic rings shown as a "cyclic structure having a hydroxymethyl group or an alkoxymethyl group" which will be described later.

In a case where the linking group $L^{1a}$ is a "combined group", it is preferably a group containing -CO-O- or a group containing an aromatic ring, and more preferably those represented by the following Formula (1a).

In the present invention, the "group containing XXX" also includes a group consisting only of XXX.

Formula (1a) $*\text{-}Ar^{1a}\text{-}L^{3a}\text{-}**$

In Formula (1a), $L^{3a}$ represents a single bond or a linking group. $Ar^{1a}$ represents an aromatic ring. * indicates the bonding position of the carbon atom to which $R^{1a}$ in the repeating unit (IA) is bonded, and ** indicates the bonding position of $L^{2a}$ in the repeating unit (IA).

$Ar^{1a}$ has the same definition as the aromatic ring of $L^{1a}$ above, and a preferred example thereof is also the same.

$L^{3a}$ has the same definition as $L^{1a}$ above, and is preferably one other than an aromatic ring and an aliphatic ring.

The "combined group" is more preferably a group containing $-Ar^{1a}$-O- or the like, still more preferably a group containing $-Ar^{1a}$-O-CO- and a group containing an $-Ar^{1a}$-O-alkylene group, and particularly preferably a $-Ar^{1a}$-O-alkylene group-O- group. Here, the alkylene group is preferably methylene and ethylene.

In General Formula (IA), $L^{2a}$ is a single bond or a linking group. In a case of a linking group, preferred is a divalent linking group. Here, at least one of $L^{1a}$ or $L^{2a}$ is preferably a linking group.

The linking group $L^{2a}$ is not particularly limited and has the same definition as the linking group $L^{1a}$, but it is preferably a single bond, an aromatic ring, or an aliphatic ring, and more preferably a benzene ring or an aliphatic heterocyclic ring.

The crosslinkable group X is a group that reacts with the repeating unit (IB), and is a hydroxymethyl group, or an alkoxymethyl group.

Example of the alkoxy group of the alkoxymethyl group include alkoxy groups having 1 to 10 carbon atoms (for example, methoxy, ethoxy, propoxy, butoxy, hexyl, and cyclohexyl).

m2a is an integer of 1 to 5, preferably an integer of 2 to 4, and more preferably 2 or 3.

In General Formula (IA), the group represented by $(-L^{2a}-(X)_{m2a})$ may be any combination of the above-mentioned $L^{2a}$ and X, but it is preferably one having a cyclic structure containing a hydroxymethyl group or an alkoxymethyl group. Preferred cyclic structures are shown below, but the invention is not limited thereto.

Further, the following cyclic structures may have a substituent T, and the bonding position of bonding to $L^{1a}$ may be any one of ring-constituting atoms. "O-" in the following cyclic structures indicates "O-$CH_3$".

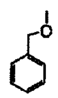
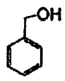
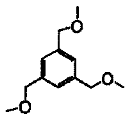
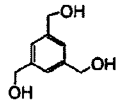
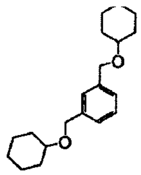
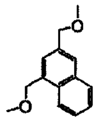

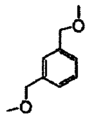
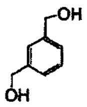
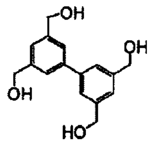
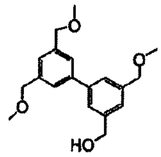
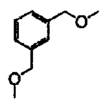
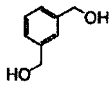

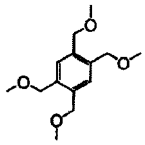
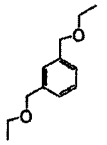
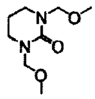
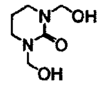
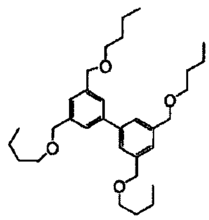

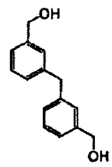
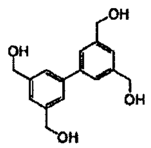
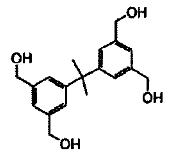
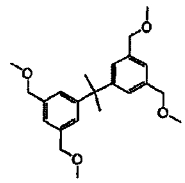

m1a is an integer of 1 to 5, preferably an integer of 1 to 4, and more preferably 1 to 2.

The repeating unit (IA) is preferably a repeating unit (IA-1) represented by the following General Formula (IA-1).

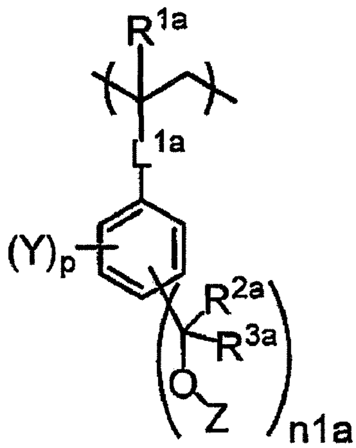

General Formula (IA-1)

In General Formula (IA-1), $L^{1a}$ has the same definition as $L^{1a}$ in General Formula (IA), and the "combined group" is also preferably a group containing a -CO-O-alkylene group, in addition to those described above. Here, the alkylene group is preferably methylene and ethylene.

$R^{2a}$ and $R^{3a}$ each independently represent a hydrogen atom or a methyl group.

Z represents a hydrogen atom an alkyl.

Y represents a monovalent substituent. The monovalent substituent has the same definition as the later-described substituent T.

n1a represents an integer of 1 to 5, preferably an integer of 2 to 4, and more preferably 2 or 3. In a case where n1a is 2 or more, n1a number of $R^{2a}$'s, $R^{3a}$'s, and Z's each may be the same or different from each other.

p represents an integer of 0 to 4, and in a case where p is 2 or more, p number of Y's may be the same or

different from each other.

The repeating unit (IA) is also preferably a repeating unit (IA-2) represented by the following General Formula (IA-2).

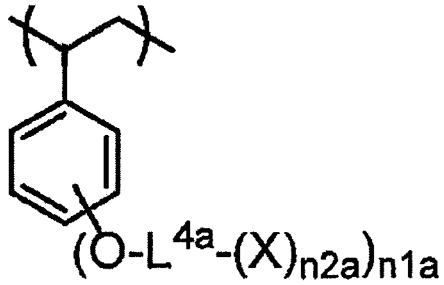

General Formula (IA-2)

In General Formula (IA-2), $L^{4a}$ represents a single bond or a linking group. $L^{4a}$ has the same definition as $L^{2a}$ above, but it is preferably a group other than -O-. $L^{4a}$ is more preferably one in which a group constituted of "benzene ring-O-$L^{4a}$" in General Formula (IA-2) is the same as the preferred "combined group" of $L^{1a}$ above.

X represents a crosslinkable group, and has the same definition as those described above and a preferred one thereof is also the same.

n2a represents an integer of 1 to 5, and has the same definition as m2a above and a preferred one thereof is also the same. In a case where m2a is 2 or more, n2a number of X's may be the same or different from each other.

n1a represents an integer of 1 to 5, and has the same definition as m1a above and a preferred one thereof is also the same. In a case where n1a is 2 or more, n1a number of (-O-$L^{4a}$-$(X)_{n2a}$)'s may be the same or different from each other.

In the repeating unit (IA), repeating unit (IA-1), and repeating unit (IA-2), each of $R^{1a}$ $R^{2a}$, $R^{3a}$, $L^{1a}$, $L^{2a}$, $Ar^{1a}$, $L^{3a}$, $L^{4a}$, and Z may have a substituent. Examples of such a substituent T include an alkyl group (preferably having 1 to 6 carbon atoms), a cycloalkyl group (preferably having 3 to 10 carbon atoms), an aryl group (preferably having 6 to 15 carbon atoms), a halogen atom, a hydroxyl group, an alkoxy group (preferably having 1 to 6 carbon atoms), a carboxyl group, a carbonyl group, a thiocarbonyl group, an alkoxycarbonyl group (preferably having 2 to 7 carbon atoms), an oxo group (=O), and a group formed by combining these groups (preferably having a total number of 1 to 30 carbon atoms, and more preferably having a total number of 1 to 15 carbon atoms).

Specific examples of the repeating unit (IA) represented by General Formula (IA) are shown below, but the present invention is not limited thereto. * indicates the bonding position of the repeating unit (IA).

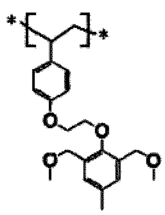
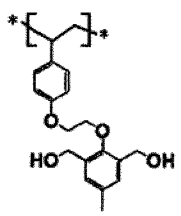
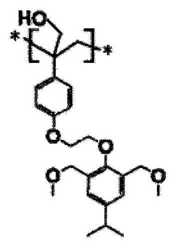
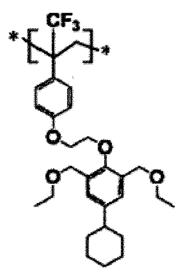

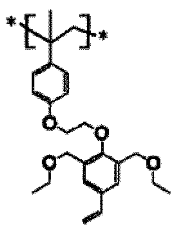
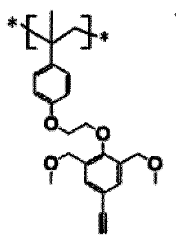

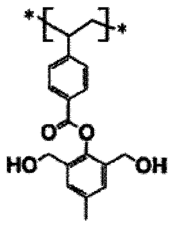
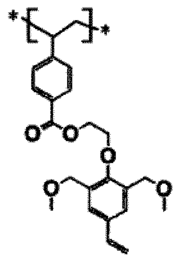

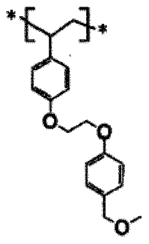
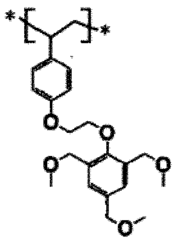

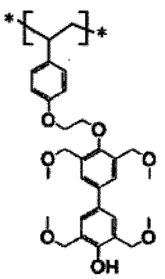
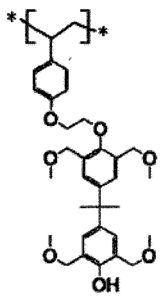
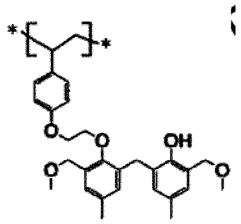

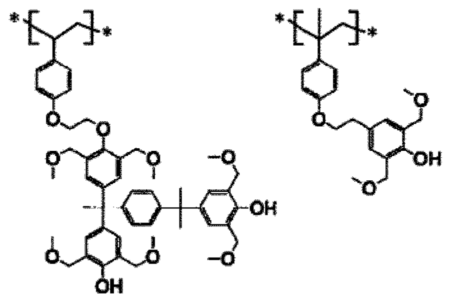
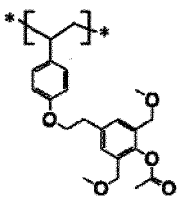

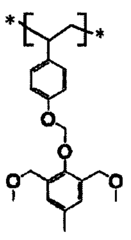
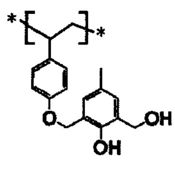
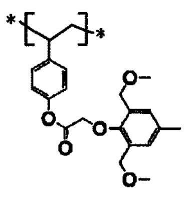
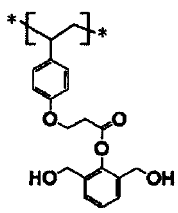

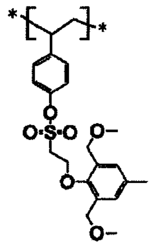
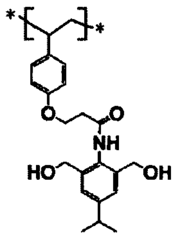
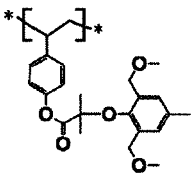

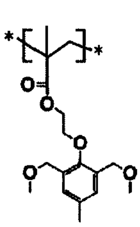
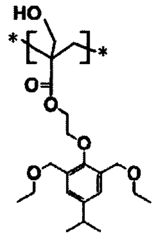
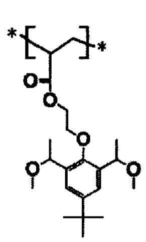
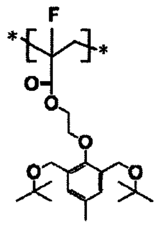

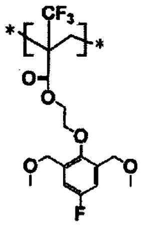
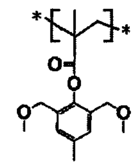
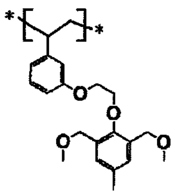
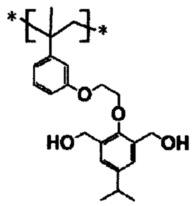

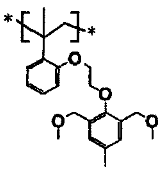
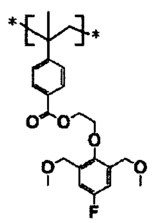
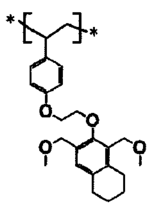
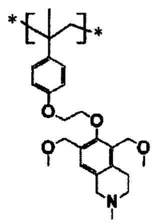

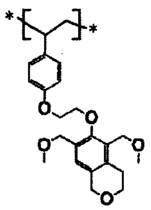
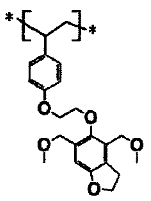
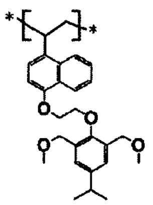
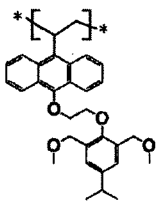

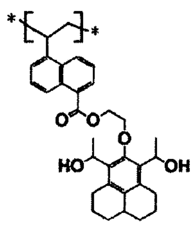
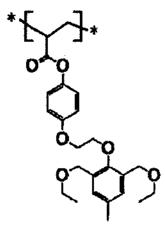
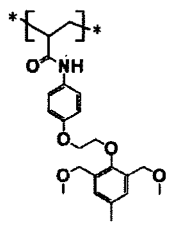
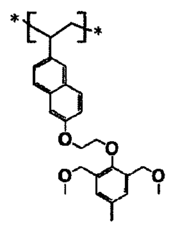

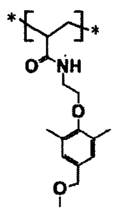
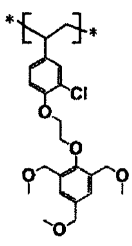
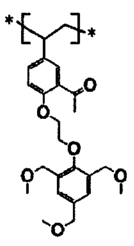
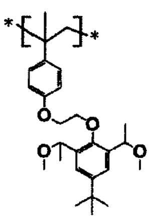

24

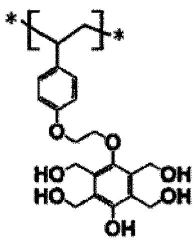
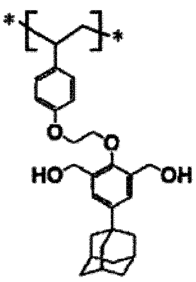
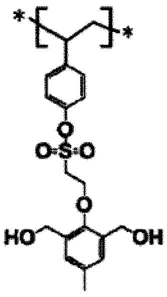

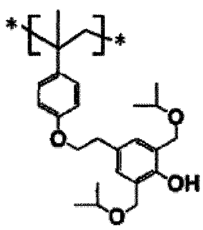
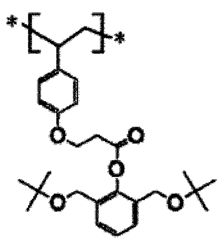
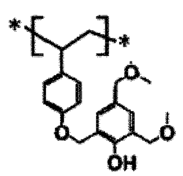

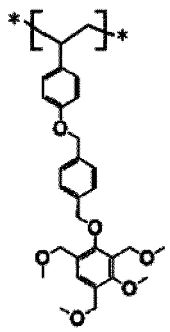
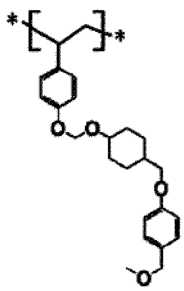
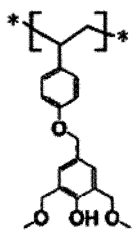
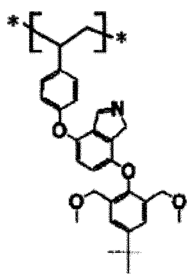

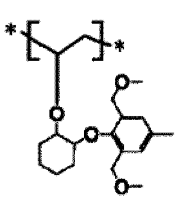
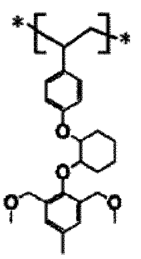
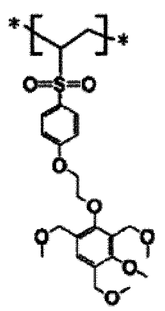
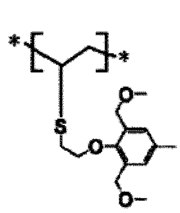

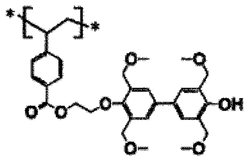 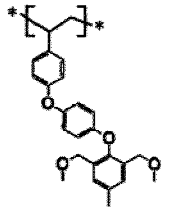

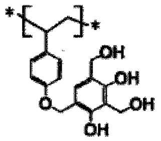 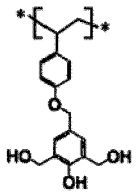 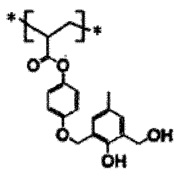

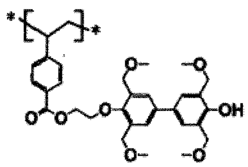 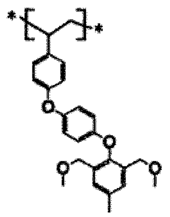

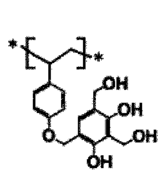 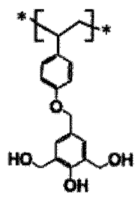 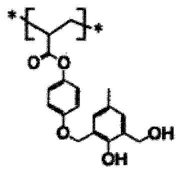

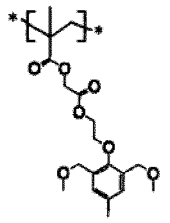 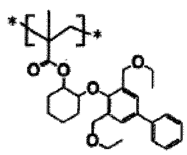 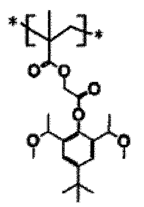 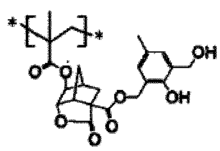

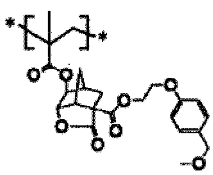 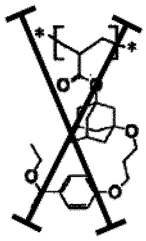 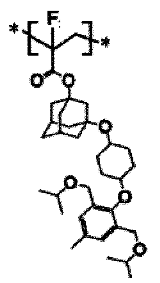 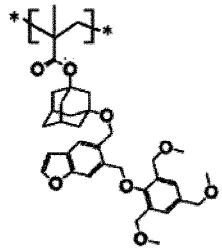

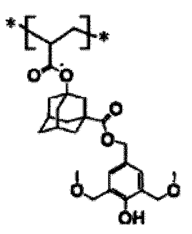
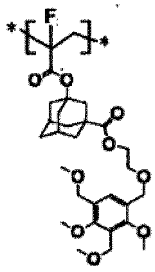
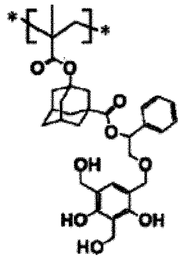

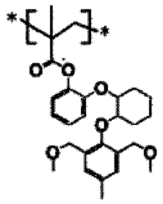
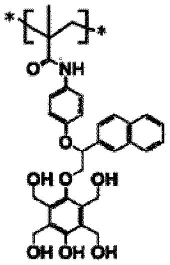
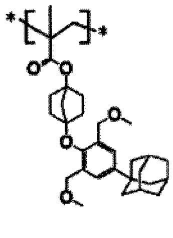
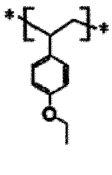
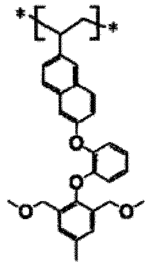

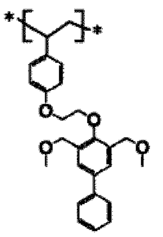
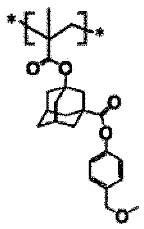
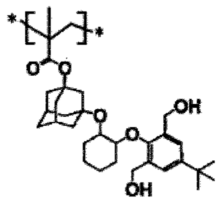
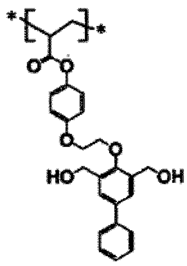

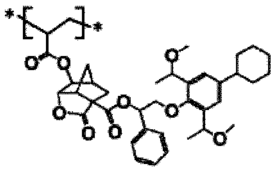
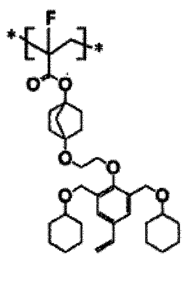

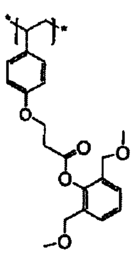
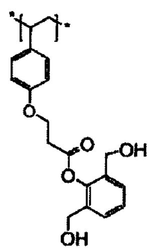
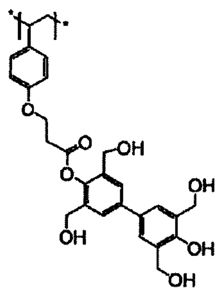
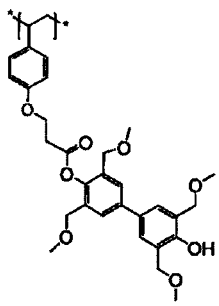

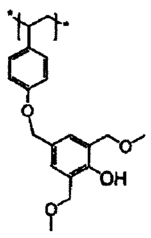
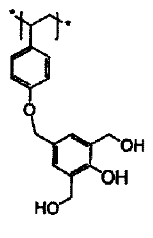
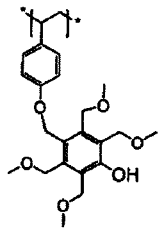
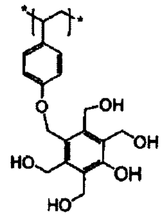

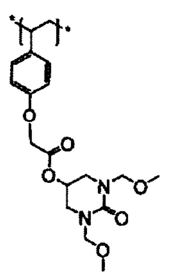
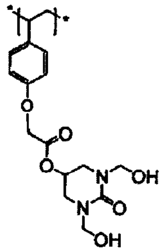

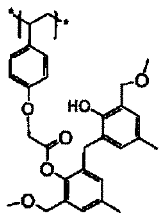
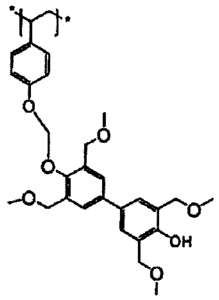
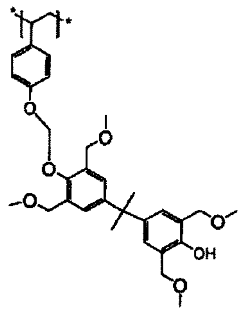

The content of the repeating unit (IA) is preferably 3 mol% to 50 mol%, more preferably 5 mol% to 30 mol%, and still more preferably 10 mol% to 20 mol%, with respect to total repeating units of the polymer compound. Thus, it is possible to form a gate insulating layer exhibiting a smooth surface and also high solvent resistance.

<Repeating Unit (IB)>

A description will be made on the repeating unit (IB) which forms a polymer compound.

In the repeating unit (IB) represented by General Formula (IB), $R^{1b}$ represents a hydrogen atom, a halogen atom, or an alkyl group. The halogen atom or alkyl group has the same definition as the halogen atom or alkyl group of $R^{1a}$ and a preferred one thereof is also the same. $R^{1b}$ is particularly preferably a hydrogen atom.

$L^{1b}$ represents a single bond or a linking group. $L^{1b}$ is preferably a single bond. In a case where $L^{1b}$ is a linking group, the linking group has the same definition as $L^{1a}$, but it is preferably a carbonyl group, a -O- group, a -NH- group, or a group formed by combining these groups (preferably having a total number of 1 to 20 carbon atoms, and more preferably having a total number of 1 to 10 carbon atoms), and more preferably a -CO-O- group or a -CO-NH-group.

$Ar^{1b}$ represents an aromatic ring, and has the same definition as the aromatic ring of $L^{1a}$ and a preferred one thereof is also the same.

m1b represents an integer of 1 to 5, and is preferably an integer of 1 to 3 and more preferably 1.

In the repeating unit (IB) represented by General Formula (IB), the position to which the hydroxyl group is bonded may be any one of ring-constituting atoms of $Ar^{1b}$. In a case where $Ar^{1b}$ is a benzene ring and m1b is 1, the hydroxyl group may be at any one of an ortho-position, a meta-position, and a para-position of the benzene ring, and preferably a para-position of the benzene ring, with respect to the bonding position of the carbon atom to which $R^{1b}$ in the repeating unit (IB) is bonded or the bonding position of the carbon atom to which the linking group $L^{1b}$ in the repeating unit (IB) is bonded.

The repeating unit (IB) is preferably a repeating unit consisting of hydroxystyrene shown below.

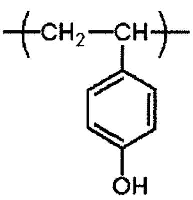 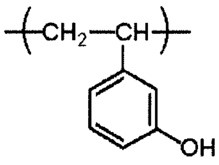 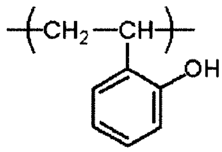

In the repeating unit (IB), each of $R^{1b}$, $L^{1b}$, and $Ar^{1b}$ may have a substituent. Such a substituent has the same definition as the substituent T.

Specific examples of the repeating unit (IB) represented by General Formula (IB) are shown below, but the present invention is not limited thereto. * indicates a bonding position of the repeating units (IB).

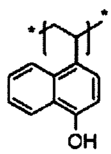 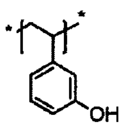 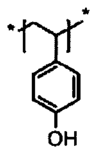 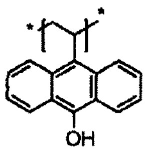 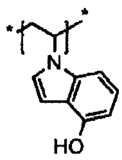 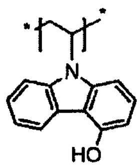

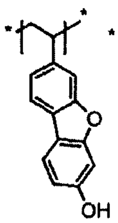 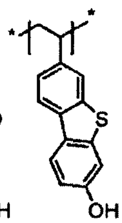 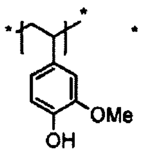 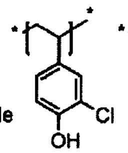 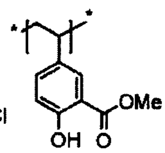 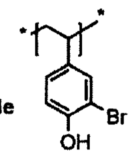

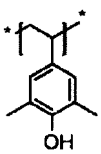 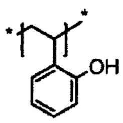 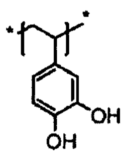 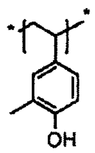 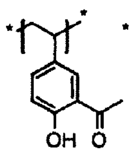 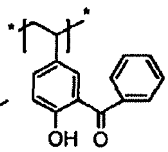

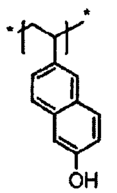 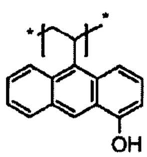 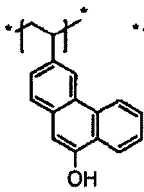 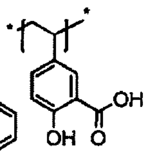 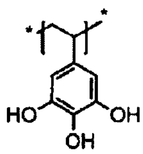 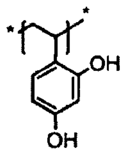

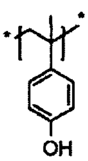 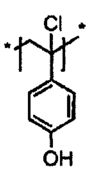 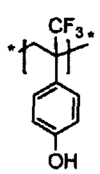 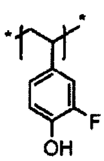 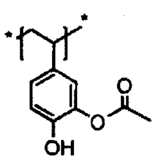 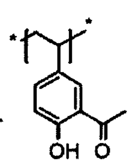 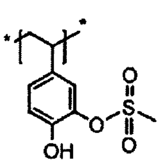

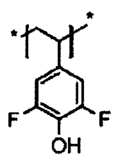 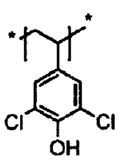 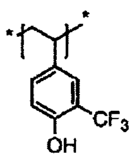 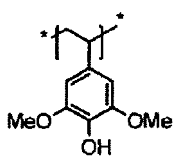

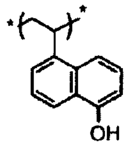 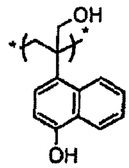 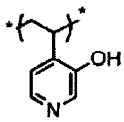 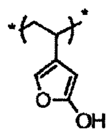

The content of the repeating unit (IB) is preferably 50 mol% to 97 mol%, more preferably 70 mol% to 95 mol%, and still more preferably 80 mol% to 90 mol%, with respect to the total repeating units of the polymer compound. Thus, the crosslinking density of the polymer compound becomes higher, whereby it is possible to form a gate insulating layer exhibiting a smooth surface and also high solvent resistance.

Moreover, the content ratio of repeating unit (IA):repeating unit (IB) in the polymer compound in a molar ratio is preferably 3:97 to 50:50, more preferably 5:95 to 30:70, still more preferably 7:93 to 25:75, and particularly preferably 10:90 to 20:80.

Two or more repeating units (IA) and repeating units (IB) may be respectively contained in the polymer compound.

<Other Repeating Unit>

The polymer compound may contain the other repeating unit, in addition to the repeating unit (IA) and the repeating unit (IB).

The other repeating unit is not particularly limited as long as it is a repeating unit copolymerizable with the repeating unit (IA) and the repeating unit (IB). Examples of the other repeating unit include individual repeating units consisting of (meth)acrylic acid ester, (meth)acrylic acid, N-substituted maleimide, acrylonitrile, (meth)acrylonitrile, vinylnaphthalene, vinylanthracene, indene, and the like.

The other repeating unit does not encompass a repeating unit substituted with an organic group in which a hydrogen atom of a hydroxyl group bonded to $Ar^{1b}$, in the repeating unit (IB), can be eliminated by an acid. The organic group which can be eliminated by an acid may be, for example, an organic group that is eliminated by the action of an acid to generate a "($Ar^{1b}$)-OH" group.

In a case where the polymer compound contains the above-mentioned other repeating unit, the content of the other repeating unit in the polymer compound is preferably 1 mol% to 20 mol%, and more preferably 2 mol% to 10 mol%, with respect to total repeating units constituting the polymer compound.

<Polymer Compound>

The polymer compound is preferably synthesized by modifying a polymer synthesized by a radical polymerization method, a living radical polymerization method, or a living anionic polymerization method with a group containing a crosslinkable group X, for example a $-L^{2a}-(X)_{m2a}$ group, through a polymer reaction.

In particular, in a case of having oxirane or oxetane as a crosslinkable group X, the polymer compound is preferably synthesized by modifying a polymer synthesized by a radical polymerization method, a living radical polymerization method, or a living anionic polymerization method with a group having a polycyclic structure containing alkene, through a polymer reaction, followed by oxidation with an oxidizing agent (for example, aqueous hydrogen peroxide, mCPBA, or the like).

The weight average molecular weight (Mw) of the polymer compound used in the present invention is preferably 1,000 to 200,000, more preferably 2,000 to 100,000, and particularly preferably 2,000 to 50,000.

The dispersity (molecular weight distribution) (Mw/Mn) of the polymer compound is preferably 1.0 to 3.0, more preferably 1.0 to 2.0, and particularly preferably 1.0 to 1.7. According to living polymerization such as living anionic polymerization, the dispersity of the polymer compound becomes uniform, which is thus preferable. The weight average molecular weight and dispersity of the polymer compound are defined as values in terms of polystyrene by GPC measurement.

Specific examples of the polymer compound having the repeating unit (IA) and the repeating unit (IB) represented by the following General Formula (IB) are shown below, but the present invention is not limited thereto. * indicates the bonding position of the repeating unit (IA) and the following General Formula (IB).

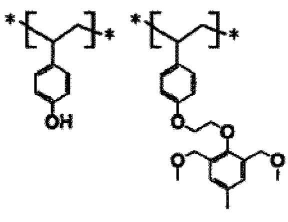
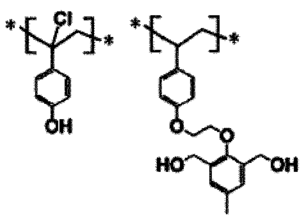
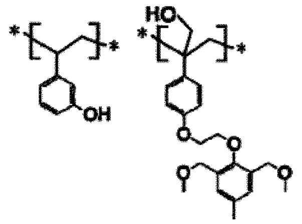

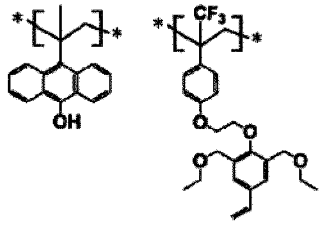

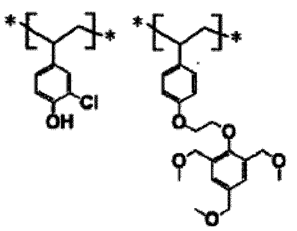
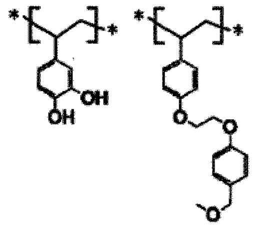
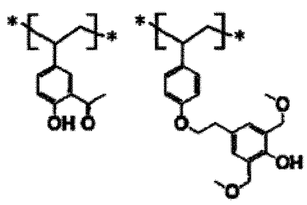

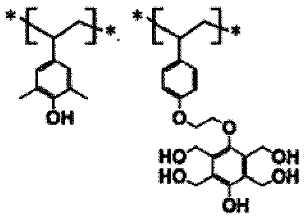
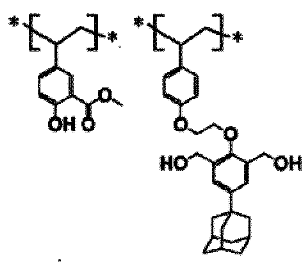
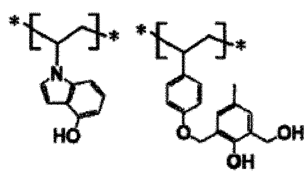

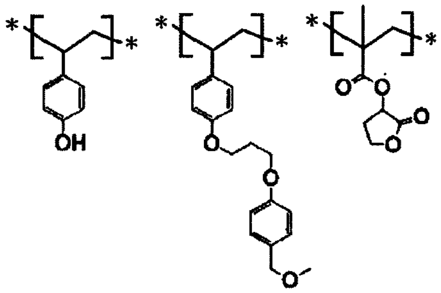
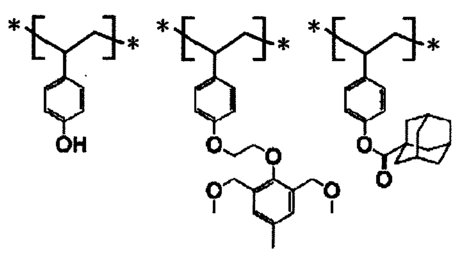

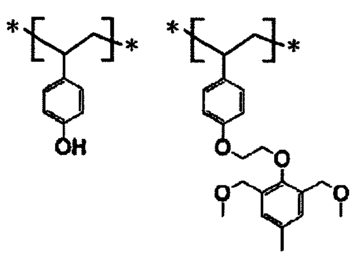
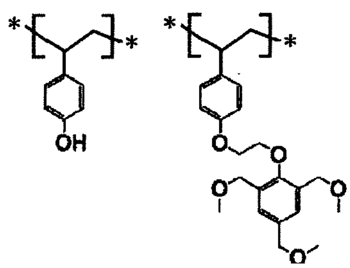

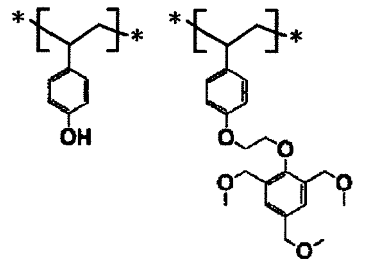

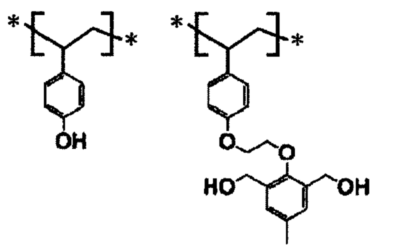

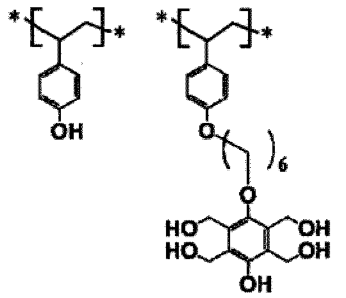

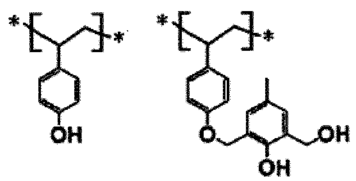

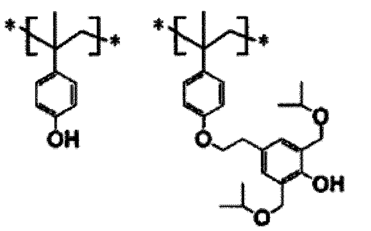

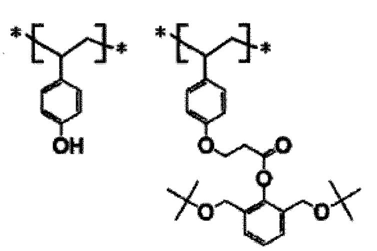

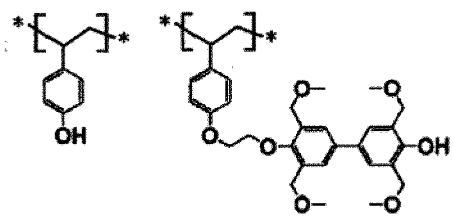

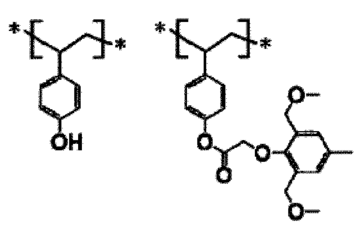

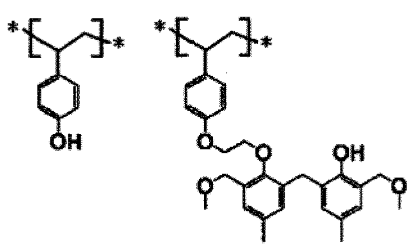

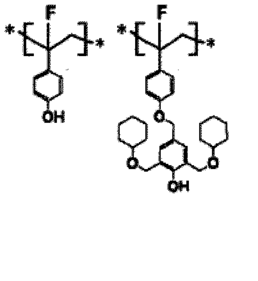

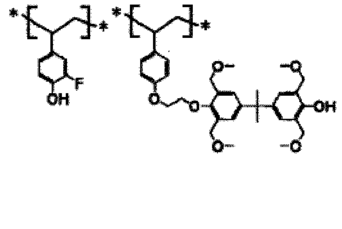

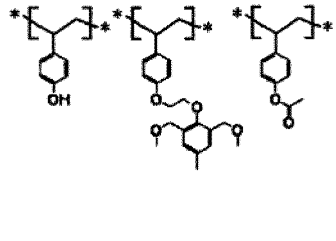

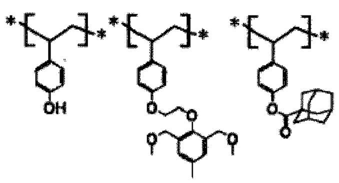

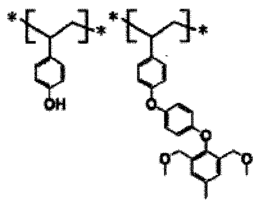

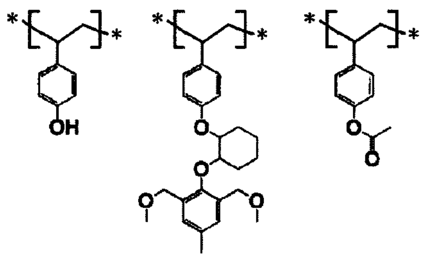

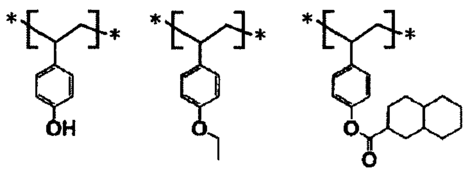

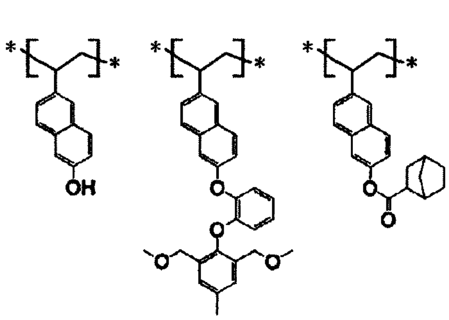

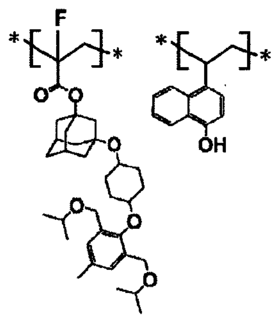

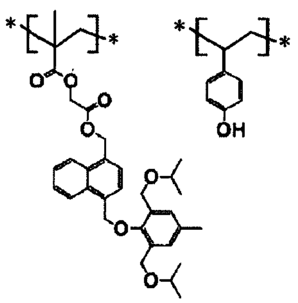

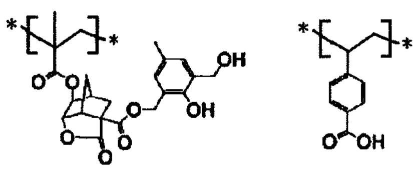

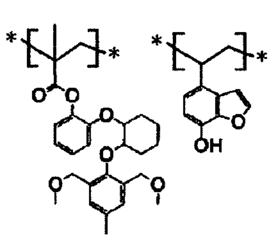

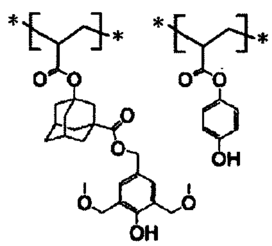

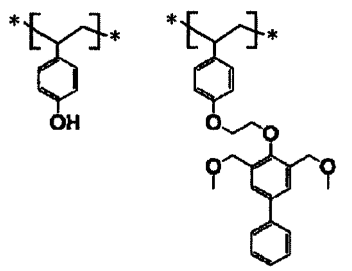

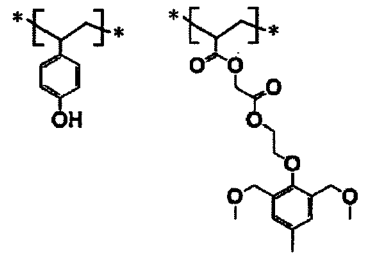

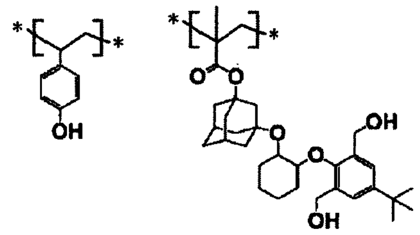

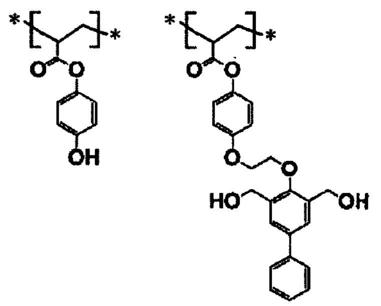

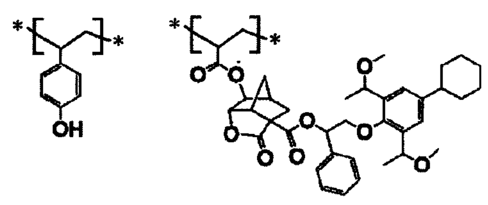

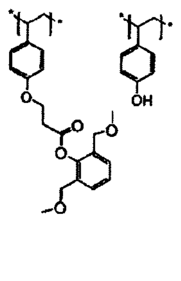

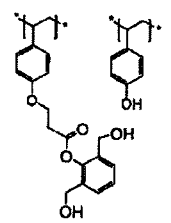

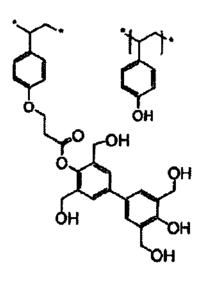

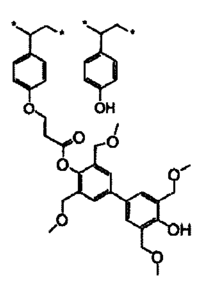

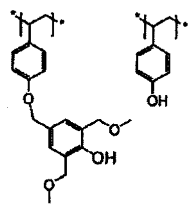

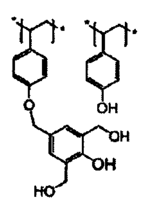

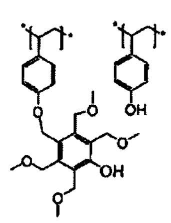

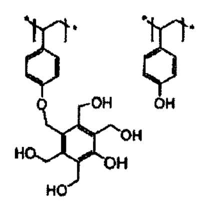

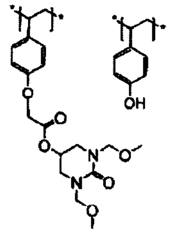

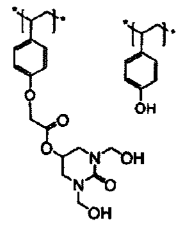

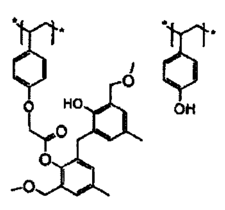

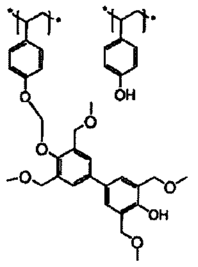

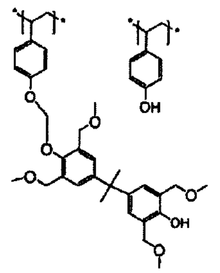

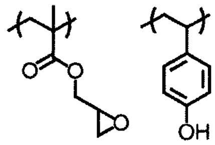

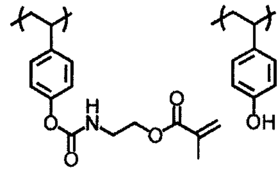

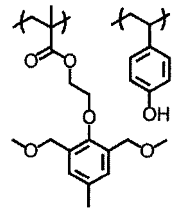

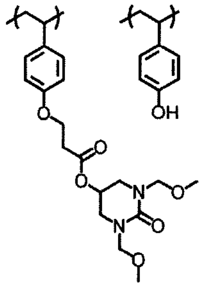

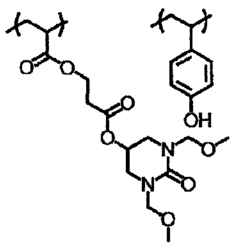

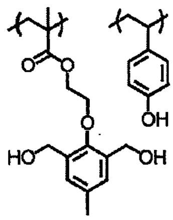

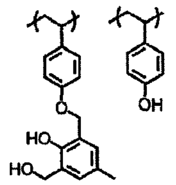

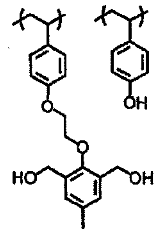

<Crosslinking agent>

In one embodiment of the present invention, the polymer compound may be crosslinked by a crosslinking agent contained in the insulating layer-forming composition. When the polymer compound is crosslinked by a crosslinking agent, solvent resistance and insulation resistance of a gate insulating layer are improved. In this case, the crosslinked product of the polymer compound is also a crosslinked product of the repeating unit (IA) and the repeating unit (IB), and is also a crosslinked product of the repeating unit (IB) and the crosslinking agent.

The crosslinking agent that can be used in the present invention include, for example, those having a functional group reactive with the repeating unit (IB). With regard to the crosslinking type, acid crosslinking, cationic polymerization, radical polymerization, or the like may be used without particular limitation. Specifically, a compound containing a methylol group (referred to as a methylol compound), an epoxy compound, an oxetane compound, a (meth)acrylic acid ester compound, a styrene compound, or the like may be used. Among them, preferred is a methylol compound having hydroxymethyl or alkoxymethyl.

The number of functional groups in the crosslinking agent is not particularly limited, but it is preferably 2 to 6, since the degree of crosslinking is enhanced with an increasing number of functional groups.

The methylol compound is preferably a compound (C) having two or more hydroxymethyl groups or alkoxymethyl groups in the molecule.

Preferred examples of the compound (C) include hydroxymethylated or alkoxymethylated phenol compounds, alkoxymethylated melamine-based compounds, alkoxymethyl glycoluril-based compounds, and alkoxymethylated urea-based compounds. Particularly preferred examples of the compound (C) include a phenol derivative having a molecular weight of 1,200 or less and containing, within the molecule, three to five benzene rings and further a total of two or more

hydroxymethyl groups or alkoxymethyl groups, a melamine-formaldehyde derivative having at least two free N-alkoxymethyl groups, and an alkoxymethyl glycoluril derivative.

The alkoxymethyl group is preferably a methoxymethyl group or an ethoxymethyl group.

Among the compounds (C), a phenol derivative having a hydroxymethyl group may be obtained by reacting a corresponding phenol compound having no hydroxymethyl group with formaldehyde in the presence of a base catalyst. Also, a phenol derivative having an alkoxymethyl group may be obtained by reacting a corresponding phenol derivative having a hydroxymethyl group with an alcohol in the presence of an acid catalyst.

Among the phenol derivatives synthesized as described above, a phenol derivative having an alkoxymethyl group is particularly preferred in view of the sensitivity and preservation stability.

As preferred examples of the compound (C), the above-mentioned alkoxymethylated melamine-based compounds, alkoxymethyl glycoluril-based compounds, and alkoxymethylated urea-based compounds are preferably compounds having an N-hydroxymethyl group or an N-alkoxymethyl group.

Specific examples of such compounds include hexamethoxymethylmelamine, hexaethoxymethylmelamine, tetramethoxymethyl glycoluril, 1,3-bismethoxymethyl-4,5-bismethoxyethyleneurea, and bismethoxymethylurea, which are disclosed in EP0,133,216A, DE3,634,671, DE3,711,264 and EP0,212,482A.

Among these crosslinking agents, particularly preferred are those illustrated below.

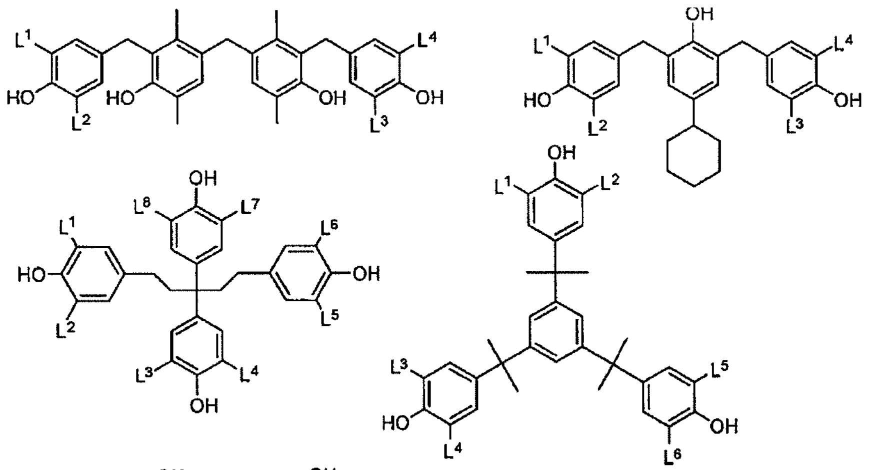

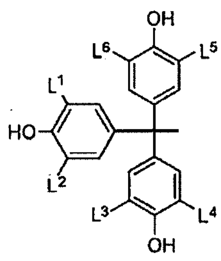

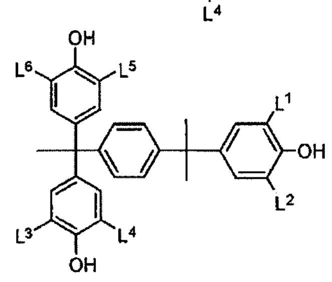

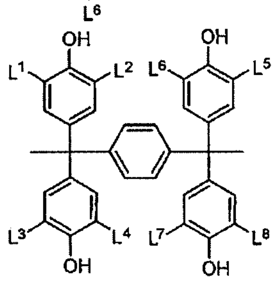

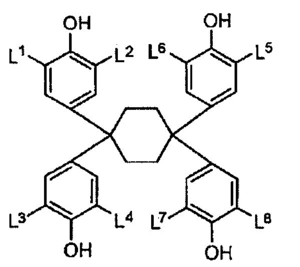

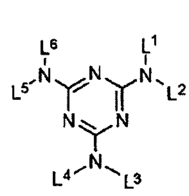

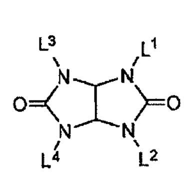

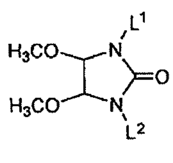

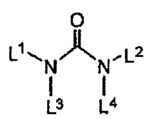

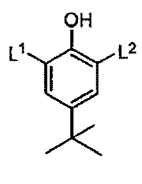

In formulae, $L^1$ to $L^8$ each independently represent a hydrogen atom, a hydroxymethyl group, a methoxymethyl group, an ethoxymethyl group, or an alkyl group having 1 to 6 carbon atoms.

As a crosslinking agent other than the above-mentioned methylol compounds, it is also preferable to use compounds described in paragraphs "0046" to "0061" of JP2006-303465A (the content of which is preferably incorporated herein by reference), and a crosslinking agent, in particular a bifunctional or higher functional epoxy compound and an oxetane compound, described in paragraphs "0032" and "0033" of JP2005-354012A (the content of which is preferably incorporated herein by reference).

The crosslinking using a crosslinking agent may be carried out by generating acid or radicals using light, heat, or both thereof. Examples thereof include crosslinking using an acid, crosslinking using cationic polymerization, and crosslinking using radical polymerization.

In a case where the crosslinking is carried out using radical polymerization, for example, a thermal polymerization initiator (HI) and a photopolymerization initiator (H2) described in paragraphs "0182" to "0186" of JP2013-214649A (the content of which is preferably incorporated herein by reference), a photoradical generator described in paragraphs "0046" to "0051" of JP2011-186069A (the content of which is preferably incorporated herein by reference), and a photoradical polymerization initiator described in paragraphs "0042" to "0056" of JP2010-285518A (the content of which is preferably incorporated herein by reference) can be preferably used as a radical generator which generates radicals by light or heat.

Further, it is also preferable to use a "compound (G) having a number average molecular weight (Mn) of 140 to 5,000, containing a crosslinkable functional group, and containing no fluorine atom" described in paragraphs "0167" to "0177" of JP2013-214649A, the content of which is preferably incorporated herein by reference.

In a case where the crosslinking is carried out using an acid, for example, a photocation polymerization initiator described in paragraphs "0033" and "0034" of JP2010-285518A (the content of which is preferably incorporated herein by reference), and an acid generator, in particular a sulfonium salt or an iodonium salt described in paragraphs "0120" to "0136" of JP2012-163946A (the content of which is preferably incorporated herein by reference) can be preferably used as a photoacid generator which generates an acid by light, in addition to those described above.

For example, a thermal cationic polymerization initiator, in particular an onium salt described in paragraphs "0035" to "0038" of JP2010-285518A (the content of which is preferably incorporated herein by reference), and a catalyst, in particular sulfonic acids and sulfonic acid amine salt described in paragraphs "0034" and "0035" of JP2005-354012A (the content of which is preferably incorporated herein by reference) can be preferably used as a thermal acid generator (catalyst) which generates an acid by heat.

<Formation of Gate Insulating Layer>

The gate insulating layer can be formed by applying an insulating layer-forming composition containing a polymer compound having the repeating unit (IA) and the repeating unit (IB) to result in a crosslinking reaction of these repeating units.

Within the range not impairing the object of the present invention, the insulating layer-forming composition of the present invention may contain a partially crosslinked product in which the above-mentioned repeating unit is partially crosslinked.

In the insulating layer-forming composition of the present invention, it is preferable to avoid heat or light so as to inhibit the generation of a crosslinked product of the above-mentioned polymer compound.

The insulating layer-forming composition may contain the above-mentioned crosslinking agents and catalysts. In the present invention, the crosslinking agents and the catalysts may be respectively used alone or in combination of two or more thereof.

In order to improve the wettability and adhesiveness of the insulating layer-forming composition to a substrate and an electrode, a surfactant or a coupling agent may also be incorporated to the extent that does not impair electrical properties such as insulating properties.

The insulating layer-forming composition may contain a solvent. The solvent is not particularly limited. For example, ethylene glycol monomethyl ether, methyl cellosolve acetate, diethylene glycol monomethyl ether, propylene glycol, propylene glycol monomethyl ether, propylene glycol monobutyl ether, propylene glycol monomethyl ether acetate, toluene, xylene, methyl ethyl ketone, methyl isobutyl ketone, cyclohexanone, ethyl 2-hydroxypropionate, butyl acetate, ethyl lactate, butyl lactate, ethanol, 1-propanol, 2-propanol, 1-butanol, 2-butanol, isobutanol, or the like can be used. These organic solvents may be used alone or in combination of two or more thereof.

Among them, propylene glycol monomethyl ether, propylene glycol monomethyl ether acetate, ethyl lactate, butyl lactate, cyclohexanone, ethanol, or 1-butanol is preferred from the viewpoint of improving levelability.

The content of the polymer compound is preferably 60 mass% to 100 mass%, and more preferably 80 mass% to 100 mass%, with respect to the total solid content of the composition.

In a case where a crosslinking agent is used, the content of the crosslinking agent is preferably 1 mass% to 40 mass%, and more preferably 5 mass% to 20 mass%, with respect to the polymer compound. When the content of

the crosslinking agent is within the above-specified range, the crosslinking density can be increased to thereby improve solvent resistance of a gate insulating layer without causing a decrease in carrier mobility due to the unreacted crosslinking agent.

The method of applying an insulating layer-forming composition may be, for example, a spin casting method, a dipping method, a die coating method, a slit coating method, a dropping method, a printing method such as an offset or screen printing, or an inkjet method. In addition, it is preferable to prevent incorporation of impurities or the like into the insulating layer-forming composition in order to maintain the surface smoothness of the obtained film, and it is preferable to filter the insulating layer-forming composition through a membrane filter or the like before coating thereof.

The conditions for crosslinking and curing the insulating layer-forming composition are not particularly limited. Preferably, in the same manner as in the above-mentioned crosslinking agent, the crosslinking and curing are carried out using a catalyst. Regarding the crosslinking conditions, for example, the heating temperature is preferably 40°C to 300°C and more preferably 60°C to 200°C, and the heating time is preferably 10 minutes to 3 hours and more preferably 5 minutes to 2 hours.

In a case of using a crosslinking agent, it is preferable to carry out the above-mentioned appropriate means for crosslinking a polymer compound. In a case of using a methylol compound as the crosslinking agent, for example, regarding the crosslinking conditions, the heating temperature is preferably 40°C to 300°C and more preferably 60°C to 200°C, and the heating time is preferably 1 minute to 3 hours and more preferably 5 minutes to 2 hours.

The gate insulating layer may be subjected to surface treatment such as corona treatment, plasma treatment, or UV/ozone treatment, and in a case of performing surface treatment, it is preferred for such a treatment not to increase surface roughness. Preferably, arithmetic mean roughness Ra or root mean square roughness $R_{MS}$ of the gate insulating layer surface is 0.5 nm or less.

[Self-Assembled Monolayer (SAM)]

The self-assembled monolayer may be formed on the gate insulating layer.

The compound forming the self-assembled monolayer is not particularly limited as long as it is a compound that self-assembles. For example, one or more compounds represented by the following Formula 1S can be used as the compound that self-assembles.

Formula 1S: $R^{1S}\text{-}X^S$

In Formula IS, $R^{1S}$ represents any one of an alkyl group, an alkenyl group, an alkynyl group, an aryl group, an alkoxy group, an aryloxy group, or a heterocyclic group (thienyl, pyrrolyl, pyridyl, fluorenyl, or the like).

$X^S$ represents an adsorptive or reactive substituent, specifically any one of a $-SiX^4X^5X^6$ group (in which $X^4$ represents a halide group or an alkoxy group, and $X^5$ and $X^6$ each independently represent a halide group, an alkoxy group, an alkyl group, or an aryl group. $X^4$, $X^5$, and $X^6$ are preferably the same from one another, respectively, and more preferably a chloro group, a methoxy group, or an ethoxy group), a phosphonic acid group ($-PO_3H_2$), a phosphinic acid group ($-PRO_2H$ in which R is an alkyl group), a phosphoric acid group, a phosphorous acid group, an amino group, a halide group, a carboxy group, a sulfonic acid group, a boric acid group ($-B(OH)_2$), a hydroxy group, a thiol group, an ethynyl group, a vinyl group, a nitro group, or a cyano group.

$R^{1S}$ is preferably not branched, and for example, a linear normal alkyl (n-alkyl) group, a ter-phenyl group in which three phenyl groups are arranged in series, and a structure in which n-alkyl groups are disposed on both sides of the phenyl group's para-position are preferred. Further, the alkyl chain may have an ether bond therein, or may have a carbon-carbon double bond or triple bond therein.

An adsorptive or reactive substituent $X^S$ interacts with, adsorbs, or reacts with the corresponding reactive site (for example, -OH group) of the gate insulating layer surface to form a bond, whereby the self-assembled monolayer is formed on the gate insulating layer. It is preferred that, with respect to the compound represented by the above-described Formula 1S, the main skeleton is linear and the molecular length is aligned, since molecules are more densely packed to thereby impart a smoother and low surface-energy surface to the self-assembled monolayer.

Particularly preferred specific examples of the compound represented by Formula IS include alkyl trichlorosilane compounds such as methyltrichlorosilane, ethyltrichlorosilane, butyltrichlorosilane, octyltrichlorosilane, decyltrichlorosilane, octadecyltrichlorosilane, and phenethyltrichlorosilane, alkyltrialkoxysilane compounds such as methyltrimethoxysilane, ethyltrimethoxysilane, butyltrimethoxysilane, octyltrimethoxysilane, decyltrimethoxysilane, and octadecyltrimethoxysilane, alkylphosphonic acid, arylphosphonic acid, alkylcarboxylic acid, an alkyl boric acid group, an aryl boric acid group, an alkyl thiol group, and an aryl thiol group.

The self-assembled monolayer can be formed by using a method of vapor-depositing the above-described compound on a gate insulating layer under vacuum, a method of immersing a gate insulating layer in a solution of the above-described compound, a Langmuir-Blodgett method, or the like. Further, for example, the self-assembled monolayer can be formed by treatment of a gate insulating layer with a solution in which 1 mass% to 10 mass% of an alkylchlorosilane compound or an alkylalkoxysilane compound is dissolved in an organic solvent. In the present invention, the method of forming a self-assembled monolayer is not limited thereto.

Examples of a preferred method for obtaining a more dense self-assembled monolayer include methods described in Langmuir 19, 1159 (2003) and J. Phys. Chem. B 110, 21101 (2006).

Specifically, the self-assembled monolayer can be formed by immersing a gate insulation layer in a highly volatile dehydration solvent having the above-described compound dispersed therein to form a film, taking out the gate insulating layer from the solvent, and if necessary, performing a reacting step of the above-described compound with the gate insulating layer such as by annealing, followed by washing with a dehydration solvent and then drying.

The dehydration solvent is not particularly limited, but for example, chloroform, trichlorethylene, anisole, diethyl ether, hexane, and toluene may be used alone or in combination thereof.

Further, it is preferred to dry the film in a dry atmosphere or by spraying of a dry gas. The dry gas to be used is preferably an inert gas such as nitrogen. By using such a method of producing a self-assembled monolayer, a dense and aggregation- or defect-free self-assembled monolayer is formed, whereby the surface roughness of the self-assembled monolayer can be inhibited to be 0.3 nm or less.

[Semiconductor Layer]

The organic semiconductor layer is a layer exhibiting semiconductivity and capable of accumulating carriers.

The semiconductor layer is formed of a semiconductor material. In a case where the semiconductor layer is formed of an organic semiconductor compound (referred to simply as an organic semiconductor), it is referred to as an organic semiconductor layer, and in a case where the semiconductor layer is formed of an inorganic semiconductor compound (referred to simply as an inorganic semiconductor), it is referred to as an inorganic semiconductor layer. In the present invention, the semiconductor layer may be an organic semiconductor layer or an inorganic semiconductor layer.

The organic semiconductors and the inorganic semiconductors to be described hereinafter may be respectively used alone or in combination of two or more thereof. Further, the organic semiconductors and inorganic semiconductors may be used together.

<Organic Semiconductor Layer>

The organic semiconductor layer may be a layer containing an organic semiconductor.

The organic semiconductor is not particularly limited, and examples thereof include an organic polymer and derivatives thereof, a low molecular weight compound, and the like.

The term "low molecular weight compound" as used herein refers to a compound other than an organic polymer and derivatives thereof. In other words, this term refers to a compound having no repeating unit. The molecular weight of the low molecular weight compound is not particularly limited as long as the low molecular weight compound is such a compound. The molecular weight of the low molecular weight compound is preferably 300 to 2,000, and more preferably 400 to 1,000.

The low molecular weight compound includes a fused polycyclic aromatic compound. Examples thereof include acenes such as naphthacene, pentacene (2,3,6,7-dibenzoanthracene), hexacene, heptacene, dibenzopentacene, and tetrabenzopentacene, anthradithiophene, pyrene, benzopyrene, dibenzopyrene, chrysene, perylene, coronene, terrylene, ovalene, quaterrylene, circumanthracene, and derivatives in which a part of carbon atoms thereof is substituted with atoms such as N, S, and O, or derivatives in which at least one hydrogen atom bonded to the above-described carbon atoms is substituted with a functional group such as a carbonyl group (dioxaanthanthrene compounds including peri-xanthenoxanthene and derivatives thereof, triphenodioxazine, triphenodithiazine, hexacene-6,15-quinone, and the like), as well as derivatives in which the above-described hydrogen atom is substituted with another functional group.

Further examples of the low molecular weight compound include metal phthalocyanines typified by copper phthalocyanine; tetrathiapentalene and derivatives thereof; naphthalenetetracarboxylic acid imides such as naphthalene-1,4,5,8-tetracarboxylic acid diimide, N,N'-bis(4-trifluoromethylbenzyl)naphthalene-1,4,5,8-tetracarboxylic acid diimide, N,N'-bis(1H, 1H-perfluorooctyl), N,N'-bis(1H,1H-perfluorobutyl), N,N'-dioctylnaphthalene-1,4,5,8-tetracarboxylic acid diimide derivatives, and naphthalene-2,3,6,7-tetracarboxylic acid diimide; fused ring tetracarboxylic acid diimides such as anthracene tetracarboxylic acid diimides, for example anthracene-2,3,6,7-tetracarboxylic acid diimide; fullerenes such as C60, C70, C76, C78, and C84, and derivatives thereof; carbon nanotubes such as single-wall nanotubes (SWNTs); and pigments such as a merocyanine pigment and a hemicyanine pigment, and derivatives thereof.

Further examples of the low molecular weight compound include polyanthracene, triphenylene, and quinacridone.

Further examples of the low molecular weight compound include 4,4'-biphenyldithiole (BPDT), 4,4'-diisocyanobiphenyl, 4,4'-diisocyano-p-terphenyl, 2,5-bis(5'-thioacetyl-2'-thiophenyl)thiophene, 2,5-bis(5'-thioacetoxyl-2'-thiophenyl)thiophene, 4,4'-diisocyanophenyl, benzidine(biphenyl-4-4'-diamine), tetracyanoquinodimethane (TCNQ), tetrathiafulvalene (TTF) and derivatives thereof, charge-transfer complexes typified by a tetrathiafulvalene (TTF)-TCNQ complex, a bisethylenetetrathiafulvalene (BEDTTTF)-perchloric acid complex, a BEDTTTF-iodine complex, and a TCNQ-iodine complex, biphenyl-4,4'-dicarboxylic acid, 1,4-di(4-thiophenylacetylenyl)-2-ethylbenzene, 1,4-di(4-isocyanophenylacetylenyl)-2-ethylbenzene, 1 ,4-di(4-thiophenylethynyl)-2-ethylbenzene, 2,2"-dihydroxy-1,1':4',1"-terphenyl, 4,4'-biphenyldiethanal, 4,4'-biphenyldiol, 4,4'-biphenyldiisocyanate, 1,4-diacetylenylbenzene, diethylbiphenyl-4,4'-dicarboxylate, benzo[1,2-c;3,4-c';5,6-c"]tris[1,2]dithiol-1,4,7-trithione, α-sexithiophene, tetrathiatetracene, tetraselenotetracene, tetratellurotetracene, poly(3-alkylthiophene), poly(3-thiophene-β-ethane sulfonic acid), poly(N-alkylpyrrole), poly(3-alkylpyrrole), poly(3,4-dialkylpyrrole), poly(2,2'-thienylpyrrole), and poly(dibenzothiophene sulfide).

The organic semiconductor is preferably a low molecular weight compound, and particularly a fused polycyclic aromatic compound is preferred. The fused polycyclic aromatic compound has a high effect of improving carrier mobility and durability, and also exhibits an excellent lowering effect of a threshold voltage.

The fused polycyclic aromatic compound is preferably an acene represented by any one of General Formulae (A1) to (A4) and a compound represented by any one of the following General Formulae (C) to (T), and from the viewpoint of easy uneven distribution with the resin (C), more preferably a compound represented by any one of the following General Formulae (C) to (T).

The acene preferred as the fused polycyclic aromatic compound is an acene represented by the following General Formula (A1) or (A2).

General Formula (A1)

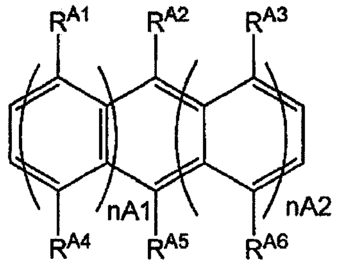

General Formula (A2)

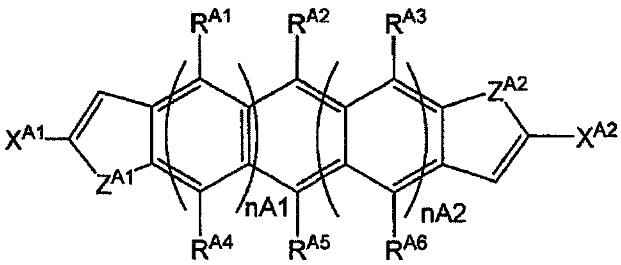

In the formula, $R^{A1}$ to $R^{A6}$, $X^{A1}$, and $X^{A2}$ represent a hydrogen atom or a substituent. $Z^{A1}$ and $Z^{A2}$ represent S, O, Se, or Te.

nA1 and nA2 represent an integer of 0 to 3, provided that there is no case where nA1 and nA2 are 0 at the same time.

The substituents each represented by $R^{A1}$ to $R^{A6}$, $X^{A1}$, and $X^{A2}$ are not particularly limited, but examples thereof include an alkyl group (for example, methyl, ethyl, propyl, isopropyl, tert-butyl, pentyl, tert-pentyl, hexyl, octyl, tert-octyl, dodecyl, tridecyl, tetradecyl, pentadecyl, or the like), a cycloalkyl group (for example, cyclopentyl, cyclohexyl, or the like), an alkenyl group (for example, vinyl, allyl, 1-propenyl, 2-butenyl, 1,3-butadienyl, 2-pentenyl, isopropenyl, or the like), an alkynyl group (for example, ethynyl, propargyl, or the like), an aromatic hydrocarbon group (also referred to as an aromatic carbocyclic group, an aryl group or the like, for example, phenyl, p-chlorophenyl, mesityl, tolyl, xylyl, naphthyl, anthryl, azulenyl, acenaphthenyl, fluorenyl, phenanthryl, indenyl, pyrenyl, biphenylyl, or the like), an aromatic heterocyclic group (also referred to as a heteroaryl group, for example, a pyridyl group, a pyrimidinyl group, a furyl group, a pyrrolyl group, an imidazolyl group, a benzimidazolyl group, a pyrazolyl group, a pyrazinyl group, a triazolyl group (for example, a 1,2,4-triazol-1-yl group, a 1,2,3-triazol-1-yl group, or the like), an oxazolyl group, a benzoxazolyl group, a thiazolyl group, an isoxazolyl group, an isothiazolyl group, a furazanyl group, a thienyl group, a quinolyl group, a benzofuryl group, a dibenzofuryl group, a benzothienyl group, a dibenzothienyl group, an indolyl group, a carbazolyl group, a carbolinyl group, a diazacarbazolyl group (representing a group in which one of carbon atoms constituting the carboline ring of a carbolinyl group is substituted with a nitrogen atom), a quinoxalinyl group, a pyridazinyl group, a triazinyl group, a quinazolinyl group, a phthalazinyl group, or the like), a heterocyclic group (also referred to as a heteroaryl ring group or the like, for example, a pyrrolidyl group, an imidazolidyl group, a morpholyl group, an oxazolidyl group, or the like), an alkoxy group (for example, methoxy, ethoxy, propyloxy, pentyloxy, hexyloxy, octyloxy, dodecyloxy, or the like), a cycloalkoxy group (for example, cyclopentyloxy, cyclohexyloxy, or the like), an aryloxy group (for example, phenoxy, naphthyloxy, or the like), an alkylthio group (for example, methylthio, ethylthio, propylthio, pentylthio, hexylthio, octylthio, dodecylthio, or the like), a cycloalkylthio group (for example, cyclopentylthio, cyclohexylthio, or the like), an arylthio group (for example, phenylthio, naphthylthio, or the like), an alkoxycarbonyl group (for example, methyloxycarbonyl, ethyloxycarbonyl, butyloxycarbonyl, octyloxycarbonyl, dodecyloxycarbonyl, or the like), an aryloxycarbonyl group (for example, phenyloxycarbonyl, naphthyloxycarbonyl, or the like), a sulfamoyl group (for example, aminosulfonyl, methylaminosulfonyl, dimethylaminosulfonyl, butylaminosulfonyl, hexylaminosulfonyl, cyclohexylaminosulfonyl, octylaminosulfonyl, dodecylaminosulfonyl, phenylaminosulfonyl, naphthylaminosulfonyl, 2-pyridylaminosulfonyl, or the like), an acyl group (for example, acetyl, ethylcarbonyl, propylcarbonyl, pentylcarbonyl, cyclohexylcarbonyl, octylcarbonyl, 2-ethylhexylcarbonyl, dodecylcarbonyl, phenylcarbonyl, naphthylcarbonyl, pyridylcarbonyl, or the like), an acyloxy group (for example, acetyloxy, ethylcarbonyloxy, butylcarbonyloxy, octylcarbonyloxy, dodecylcarbonyloxy, phenylcarbonyloxy, or the like), an amide group (for example, methylcarbonylamino, ethylcarbonylamino, dimethylcarbonylamino, propylcarbonylamino, pentylcarbonylamino, cyclohexylcarbonylamino, 2-ethylhexylcarbonylamino, octylcarbonylamino, dodecylcarbonylamino, phenylcarbonylamino, naphthylcarbonylamino, or the like), a carbamoyl group (for example, aminocarbonyl, methylaminocarbonyl, dimethylaminocarbonyl, propylaminocarbonyl, pentylaminocarbonyl, cyclohexylaminocarbonyl, octylaminocarbonyl, 2-ethylhexylaminocarbonyl, dodecylaminocarbonyl, phenylaminocarbonyl, naphthylaminocarbonyl, 2-pyridylaminocarbonyl, or the like), a ureido group (for example, methylureido, ethylureido, pentylureido, cyclohexylureido, octylureido, dodecylureido, phenylureido, naphthylureido, 2-pyridylaminoureido, or the like), a sulfinyl group (for example, methylsulfinyl, ethylsulfinyl, butylsulfinyl, cyclohexylsulfinyl, 2-ethylhexylsulfinyl, dodecylsulfinyl, phenylsulfinyl, naphthylsulfinyl, 2-pyridylsulfinyl, or the like), an alkylsulfonyl group (for example, methylsulfonyl, ethylsulfonyl, butylsulfonyl, cyclohexylsulfonyl, 2-ethylhexylsulfonyl, dodecylsulfonyl, or the like), an arylsulfonyl group (phenylsulfonyl, naphthylsulfonyl, 2-pyridylsulfonyl, or the like), an amino group (for example, amino, ethylamino, dimethylamino, butylamino, cyclopentylamino, 2-ethylhexylamino, dodecylamino, anilino, naphthylamino, 2-pyridylamino, or the like), a halogen atom (for example, a fluorine atom, a chlorine atom, a bromine atom, or the like), a fluorinated hydrocarbon group (for example, fluoromethyl, trifluoromethyl, pentafluoroethyl, pentafluorophenyl, or the like), a cyano group, a nitro group, a hydroxy group, a mercapto group, a silyl group (for example, trimethylsilyl, triisopropylsilyl, triphenylsilyl, phenyldiethyl silyl, or the like), and a group represented by the following General Formula (SG1) (provided that $X^A$ is Ge or Sn).

These substituents may further have plural substituents. Examples of such plural substituents include the above-described substituents represented by $R^{A1}$ to $R^{A6}$.

Among the above-described acenes, more preferred are acenes represented by the following General Formula (A3) or (A4).

General Formula (A3)

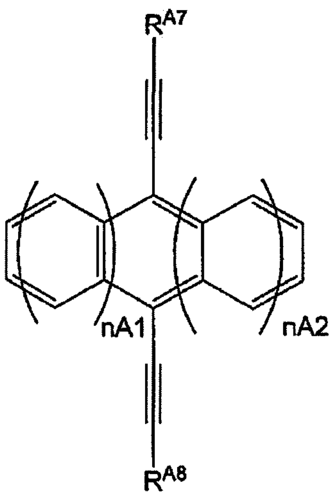

General Formula (A4)

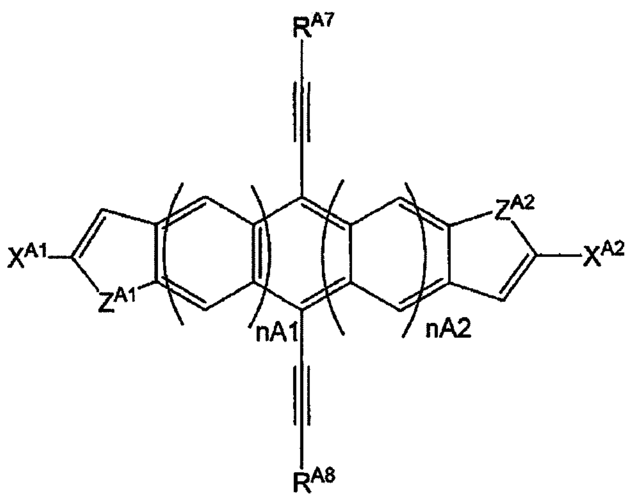

In the formulae, $R^{A7}$, $R^{A8}$, $X^{A1}$, and $X^{A2}$ represent a hydrogen atom or a substituent. $R^{A7}$, $R^{A8}$, $X^{A1}$, and $X^{A2}$ may be the same or different. The substituents represented by $R^{A7}$ and $R^{A8}$ are preferably those enumerated above as the substituents which can be employed as $R^{A1}$ to $R^{A6}$ of General Formulae (A1) and (A2).

$Z^{A1}$ and $Z^{A2}$ represent S, O, Se, or Te.

nA1 and nA2 represent an integer of 0 to 3, provided that there is no case where nA1 and nA2 are 0 at the same time.

In Formula (A3) or (A4), $R^{A7}$ and $R^{A8}$ are preferably those represented by the following General Formula (SG1).

General Formula (SG1)

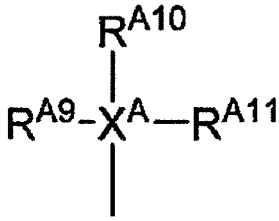

In the formula, $R^{A9}$ to $R^{A11}$ represent a substituent. $X^A$ represents Si, Ge, or Sn. The substituents represented by $R^{A9}$ to $R^{A11}$ are preferably those listed above as the substituent which can be employed as $R^{A1}$ to $R^{A6}$ of General Formulae (A1) and (A2).

Specific examples of the acene or acene derivatives represented by General Formulae (A1) to (A4) are shown below, but the present invention is not limited thereto.

Compound A1

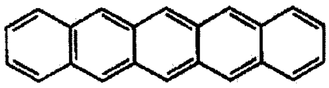

Compound A2

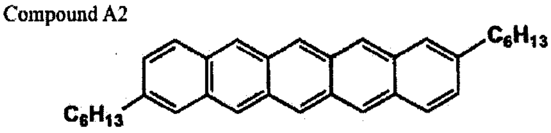

Compound A3

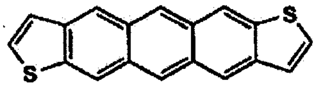

Compound A4

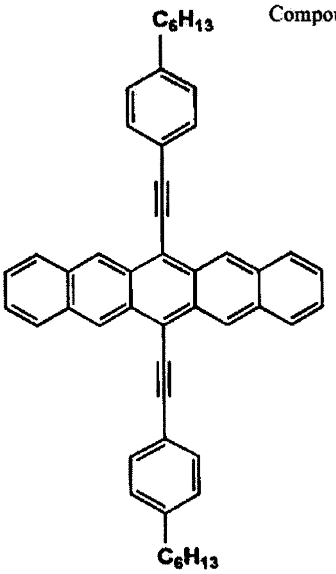

Compound A5

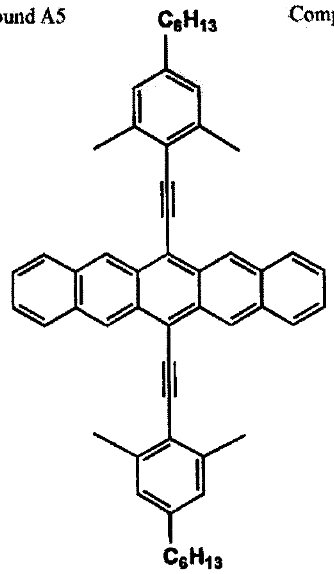

Compound A6

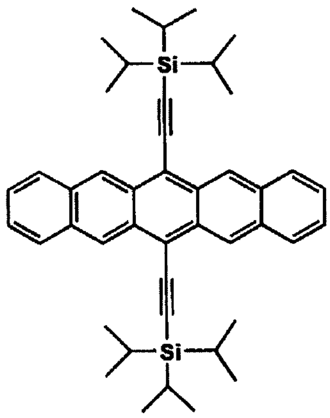

Compound A7

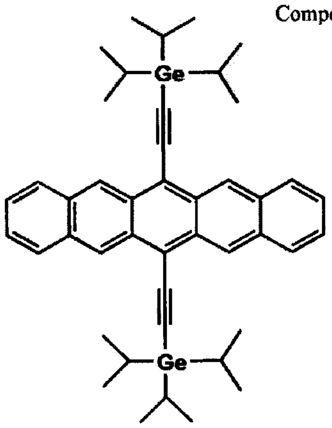

Compound A8

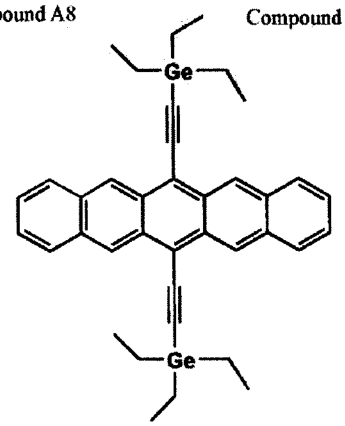

Compound A9

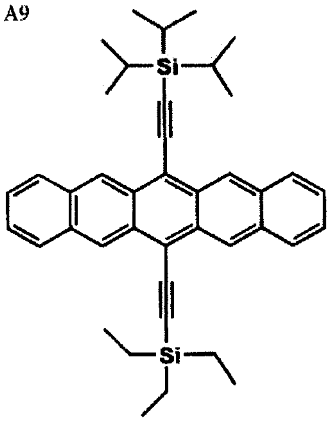

Compound A10

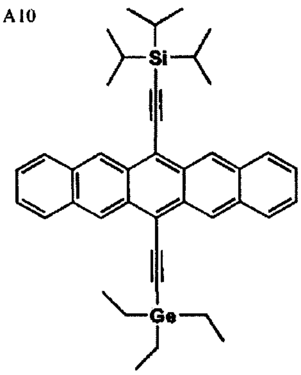

Compound A11

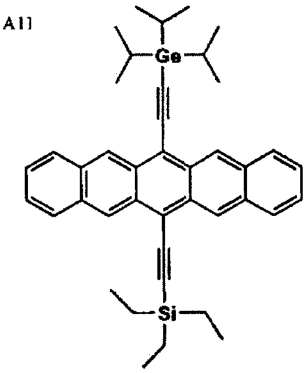

Compound A12

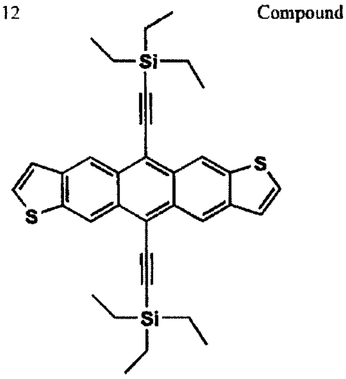

Compound A13

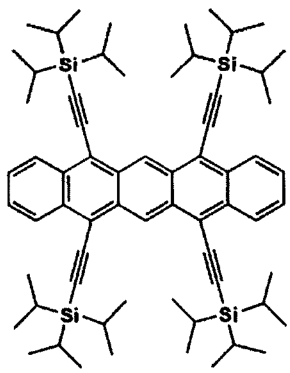

Compound A14

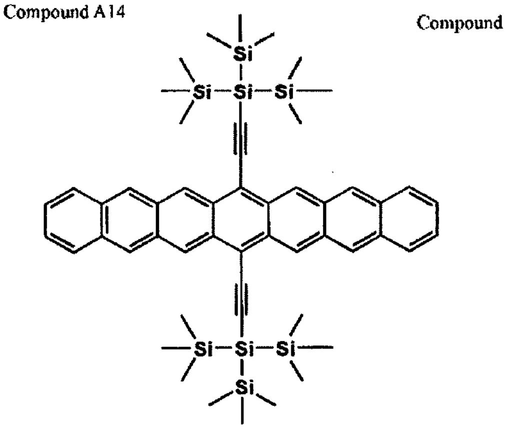

Compound A15

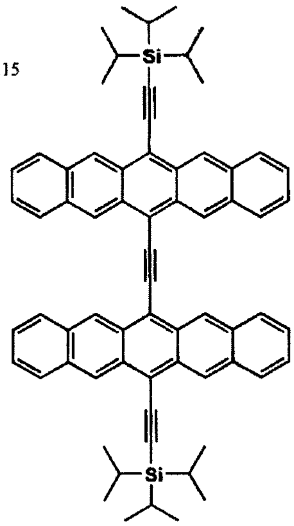

Compound A16

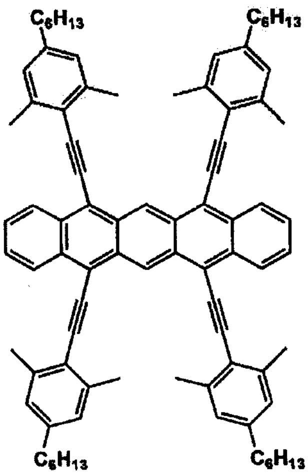

Compound A17

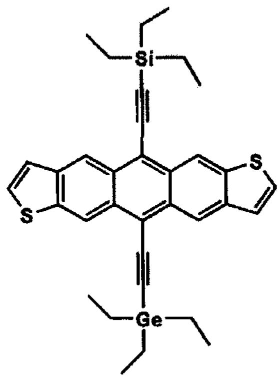

Compound A18

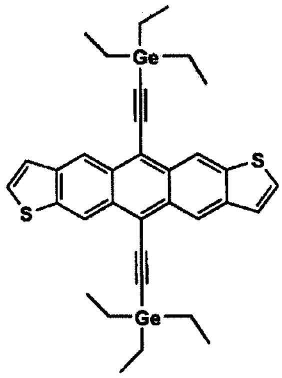

Compound A19

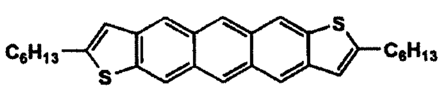

Compound A20

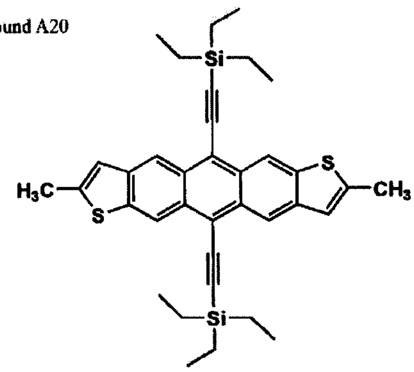

Compound A21
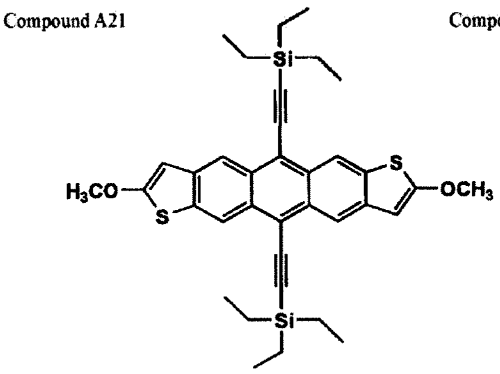
Compound A22
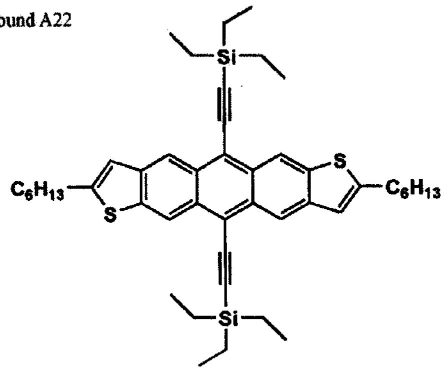

Compound A23
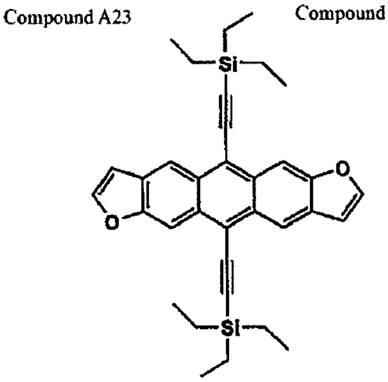
Compound A24
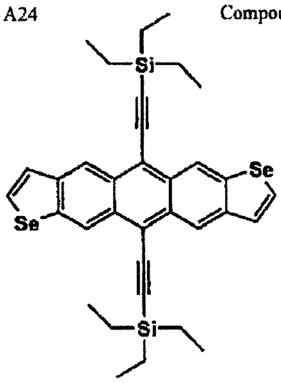
Compound A25
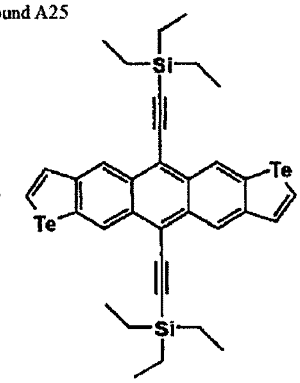

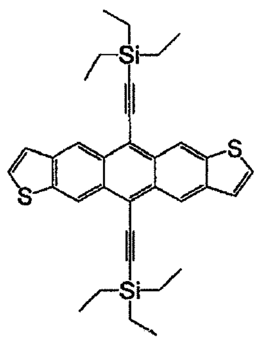
Compound A26
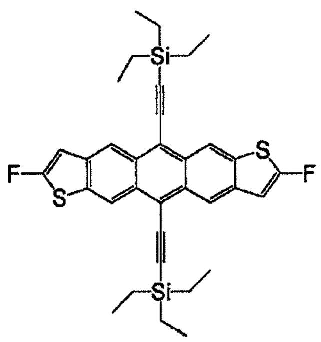
Compound A27

Compounds represented by the following General Formulae (C) to (T) are also preferred as the fused polycyclic aromatic compound.

General Formula (C)
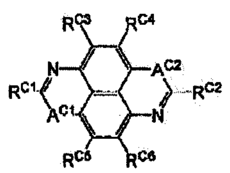
General Formula (D)
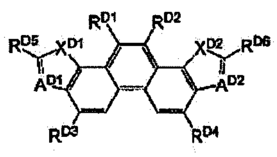
General Formula (E)
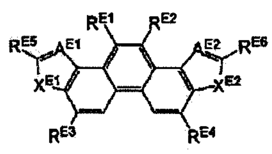

General Formula (F)

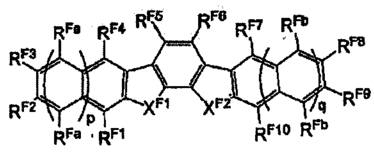

General Formula (G)

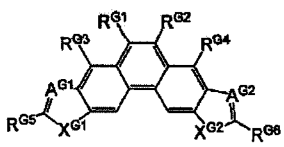

General Formula (H)

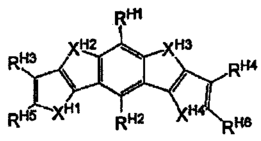

General Formula (J)

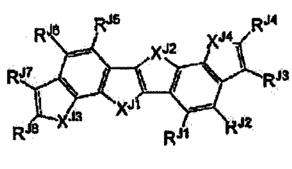

General Formula (K)

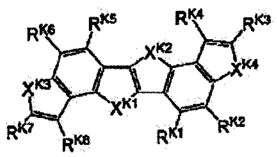

General Formula (L)

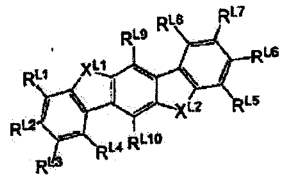

General Formula (M)

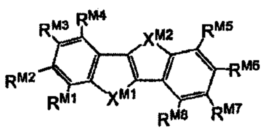

General Formula (N)

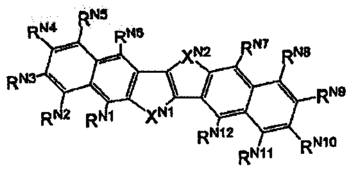

General Formula (P)

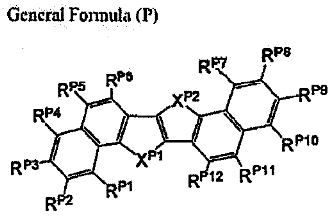

General Formula (Q)

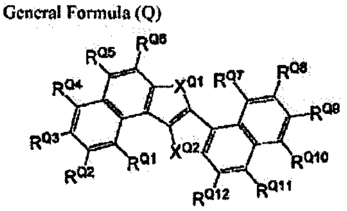

General Formula (R)

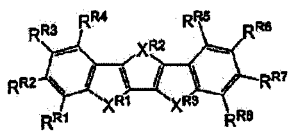

General Formula (S)

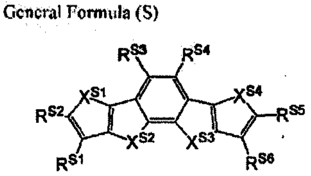

General Formula (T)

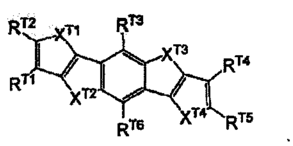

In General Formula (C), $A^{C1}$ and $A^{C2}$ represent an oxygen atom, a sulfur atom, or a selenium atom. Both of $A^{C1}$ and $A^{C2}$ preferably represent an oxygen atom or a sulfur atom, and more preferably a sulfur atom. $R^{C1}$ to $R^{C6}$ represent a hydrogen atom or a substituent. At least one of $R^{C1}$, $R^{C2}$, $R^{C3}$, $R^{C4}$, $R^{C5}$, or $R^{C6}$ is a substituent represented by the following General Formula (W).

In General Formula (D), $X^{D1}$ and $X^{D2}$ represent $NR^{D9}$, an oxygen atom, or a sulfur atom. $A^{D1}$ represents $CR^{D7}$ or an N atom, $A^{D2}$ represents $CR^{D8}$ or an N atom, and $R^{D9}$ represents a hydrogen atom, an alkyl group, an alkenyl group, an alkynyl group, or an acyl group. $R^{D1}$ to $R^{D8}$ represent a hydrogen atom or a substituent, and at least one of $R^{D1}$, $R^{D2}$, $R^{D3}$, $R^{D4}$ $R^{D5}$, $R^{D6}$, $R^{D7}$, or $R^{D8}$ is a substituent represented by the following General Formula (W).

In General Formula (E), $X^{E1}$ and $X^{E2}$ represent an oxygen atom, a sulfur atom, or $NR^{E7}$. $A^{E1}$ and $A^{E2}$ represent $CR^{E8}$ or a nitrogen atom. $R^{E1}$ to $R^{E8}$ represent a hydrogen atom or a substituent. At least one of $R^{E1}$, $R^{E2}$, $R^{E3}$, $R^{E4}$, $R^{E5}$, $R^{E6}$, $R^{E7}$, or $R^{E8}$ is a substituent represented by the following General Formula (W).

In General Formula (F), $X^{F1}$ and $X^{F2}$ represent an oxygen atom, a sulfur atom, or a selenium atom. $X^{F1}$ and $X^{F2}$ preferably represent an oxygen atom or a sulfur atom, and more preferably represent a sulfur atom. $R^{F1}$ to $R^{F10}$, $R^{Fa}$, and $R^{Fb}$ represent a hydrogen atom or a substituent. At least one of $R^{F1}$ to $R^{F10}$, $R^{Fa}$, or $R^{Fb}$ is a substituent represented by General Formula (W). p and q represent an integer of 0 to 2.

In General Formula (G), $X^{G1}$ and $X^{G2}$ represent $NR^{G9}$, an oxygen atom, or a sulfur atom. $A^{G1}$ represents $CR^{G7}$ or an N atom. $A^{G2}$ represents $CR^{G8}$ or an N atom. $R^{G9}$ represents a hydrogen atom, an alkyl group, an alkenyl group, an alkynyl group, an acyl group, an aryl group, or a heteroaryl group. $R^{G1}$ to $R^{G8}$ represent a hydrogen atom or a

substituent. At least one of $R^{G1}$, $R^{G2}$, $R^{G3}$, $R^{G4}$, $R^{G5}$, $R^{G6}$, $R^{G7}$, or $R^{G8}$ is a substituent represented by the following General Formula (W).

In General Formula (H), $X^{H1}$ to $X^{H4}$ represent $NR^{H7}$, an oxygen atom, or a sulfur atom. $X^{H1}$ to $X^{H4}$ preferably represent a sulfur atom. $R^{H7}$ represents a hydrogen atom, an alkyl group, an alkenyl group, an alkynyl group, an acyl group, an aryl group, or a heteroaryl group. $R^{H1}$ to $R^{H6}$ represent a hydrogen atom or a substituent. At least one of $R^{H1}$, $R^{H2}$, $R^{H3}$, $R^{H4}$, $R^{H5}$ or $R^{H6}$ is a substituent represented by the following General Formula (W).

In General Formula (J), $X^{J1}$ and $X^{J2}$ represent an oxygen atom, a sulfur atom, a selenium atom, or $NR^{J9}$. $X^{J3}$ and $X^{J4}$ represent an oxygen atom, a sulfur atom, or a selenium atom. $X^{J1}$, $X^{J2}$, $X^{J3}$, and $X^{J4}$ preferably represent a sulfur atom. $R^{J1}$ to $R^{J9}$ represent a hydrogen atom or a substituent. At least one of $R^{J1}$, $R^{J2}$, $R^{J3}$, $R^{J4}$, $R^{J5}$, $R^{J6}$, $R^{J7}$, $R^{J8}$, or $R^{J9}$ is a substituent represented by the following General Formula (W).

In General Formula (K), $X^{K1}$ and $X^{K2}$ represent an oxygen atom, a sulfur atom, a selenium atom, or $NR^{K9}$. $X^{K3}$ and $X^{K4}$ represent an oxygen atom, a sulfur atom, or a selenium atom. $X^{K1}$, $X^{K2}$, $X^{K3}$, and $X^{K4}$ preferably represent a sulfur atom. $R^{K1}$ to $R^{K9}$ represent a hydrogen atom or a substituent. At least one of $R^{K1}$, $R^{K2}$, $R^{K3}$, $R^{K4}$, $R^{K5}$, $R^{K6}$, $R^{K7}$, $R^{K8}$, or $R^{K9}$ is a substituent represented by the following General Formula (W).

In General Formula (L), $X^{L1}$ and $X^{L2}$ represent an oxygen atom, a sulfur atom, or $NR^{L11}$. $X^{L1}$ and $X^{L2}$ preferably represent an oxygen atom or a sulfur atom. $R^{L1}$ to $R^{L11}$ represent a hydrogen atom or a substituent, and at least one of $R^{L1}$, $R^{L2}$, $R^{L3}$, $R^{L4}$, $R^{L5}$, $R^{L6}$, $R^{L7}$, $R^{L8}$, $R^{L9}$, $R^{L10}$, or $RL^{11}$ is a substituent represented by the following General Formula (W).

In General Formula (M), $X^{M1}$ and $X^{M2}$ represent an oxygen atom, a sulfur atom, a selenium atom, or $NR^{M9}$. $X^{M1}$ and $X^{M2}$ preferably represent a sulfur atom. $R^{M1}$ to $R^{M9}$ represent a hydrogen atom or a substituent. At least one of $R^{M1}$, $R^{M2}$, $R^{M3}$, $R^{M4}$, $R^{M5}$, $R^{M6}$, $R^{M7}$, $R^{M8}$, or $R^{M9}$ is a substituent represented by the following General Formula (W).

In General Formula (N), $X^{N1}$ and $X^{N2}$ represent an oxygen atom, a sulfur atom, a selenium atom, or $NR^{N13}$. $X^{N1}$ and $X^{N2}$ preferably represent a sulfur atom. $R^{N1}$ to $R^{N13}$ represent a hydrogen atom or a substituent. At least one of $R^{N1}$, $R^{N2}$, $R^{N3}$, $R^{N4}$, $R^{N5}$, $R^{N6}$, $R^{N7}$, $R^{N8}$, $R^{N9}$, $R^{N10}$, $R^{N11}$, $R^{N12}$, or $R^{N13}$ is a substituent represented by the following General Formula (W).

In General Formula (P), $X^{P1}$ and $X^{P2}$ represent an oxygen atom, a sulfur atom, a selenium atom, or $NR^{P13}$. $X^{P1}$ and $X^{P2}$ preferably represent a sulfur atom. $R^{P1}$ to $R^{P13}$ represent a hydrogen atom or a substituent. At least one of $R^{P1}$, $R^{P2}$, $R^{P3}$, $R^{P4}$, $R^{P5}$, $R^{P6}$, $R^{P7}$, $R^{P8}$, $R^{P9}$, $R^{P10}$, $R^{P11}$, $R^{P12}$, or $R^{P13}$ is a substituent represented by the following General Formula (W).

In General Formula (Q), $X^{Q1}$ and $X^{Q2}$ represent an oxygen atom, a sulfur atom, a selenium atom, or $NR^{Q13}$. $X^{Q1}$ and $X^{Q2}$ preferably represent a sulfur atom. $R^{Q1}$ to $R^{Q13}$ represent a hydrogen atom or a substituent. At least one of $R^{Q1}$, $R^{Q2}$, $R^{Q3}$, $R^{Q4}$, $R^{Q5}$, $R^{Q6}$, $R^{Q7}$, $R^{Q8}$, $R^{Q9}$, $R^{Q10}$, $R^{Q11}$, $R^{Q12}$, or $R^{Q13}$ is a substituent represented by the following General Formula (W).

In General Formula (R), $X^{R1}$, $X^{R2}$, and $X^{R3}$ represent an oxygen atom, a sulfur atom, a selenium atom, or $NR^{R9}$. $X^{R1}$, $X^{R2}$, and $X^{R3}$ preferably represent a sulfur atom. $R^{R1}$ to $R^{R9}$ represent a hydrogen atom or a substituent. At least one of $R^{R1}$, $R^{R2}$, $R^{R3}$, $R^{R4}$, $R^{R5}$, $R^{R6}$, $R^{R7}$, $R^{R8}$, or $R^{R9}$ is a substituent represented by the following General Formula (W).

In General Formula (S), $X^{S1}$, $X^{S2}$, $X^{S3}$, and $X^{S4}$ represent an oxygen atom, a sulfur atom, a selenium atom, or $NR^{S7}$. $x^{S1}$, $X^{S2}$, $X^{S3}$, and $X^{S4}$ preferably represent a sulfur atom. $R^{S1}$ to $R^{S7}$ represent a hydrogen atom or a substituent. At least one of $R^{S1}$, $R^{S2}$, $R^{S3}$, $R^{S4}$, $R^{S5}$, $R^{S6}$, or $R^{S7}$ is a substituent represented by the following General Formula (W).

In General Formula (T), $X^{T1}$, $X^{T2}$, $X^{T3}$, and $X^{T4}$ represent an oxygen atom, a sulfur atom, a selenium atom, or $NR^{T7}$. $X^{T1}$, $X^{T2}$, $X^{T3}$, and $X^{T4}$ preferably represent a sulfur atom. $R^{T1}$ to $R^{T7}$ represent a hydrogen atom or a substituent. At least one of $R^{T1}$, $R^{T2}$, $R^{T3}$, $R^{T4}$, $R^{T5}$, $R^{T6}$, or $R^{T7}$ is a substituent represented by the following General Formula (W).

In the above-described General Formulae (C) to (T), $R^{C1}$ to $R^{C6}$, $R^{D1}$ to $R^{D8}$, $R^{E1}$ to $R^{E8}$, $R^{F1}$ to $R^{F10}$, $R^{Fa}$ and $R^{Fb}$, $R^{G1}$ to $R^{G8}$, $R^{H1}$ to $R^{H6}$, $R^{J1}$ to $R^{J9}$, $R^{K1}$ to $R^{K9}$, $R^{L1}$ to $R^{L11}$, $R^{M1}$ to $R^{M9}$, $R^{N1}$ to $R^{N13}$, $R^{P1}$ to $R^{P13}$, $R^{Q1}$ to $R^{Q13}$, $R^{R1}$ to $R^{R9}$, $R^{S1}$ to $R^{S7}$, and $R^{T1}$ to $R^{T7}$ (hereinafter referred to as substituents $R^C$ to $R^T$), each of which represents a hydrogen atom or a substituent, will be described below.

Examples of the substituent that can be taken by substituents $R^C$ to $R^T$ include a halogen atom, an alkyl group (an alkyl group having 1 to 40 carbon atoms, such as methyl, ethyl, propyl, butyl, pentyl, hexyl, heptyl, octyl, nonyl, decyl, undecyl, dodecyl, tridecyl, tetradecyl, and pentadecyl, but including 2,6-dimethyloctyl, 2-decyltetradecyl, 2-hexyldodecyl, 2-ethyloctyl, 2-butyldecyl, 1-octylnonyl, 2-octyltetradecyl, 2-ethylhexyl, cycloalkyl, bicycloalkyl, tricycloalkyl, and the like), an alkenyl group (including 1-pentenyl, a cycloalkenyl, a bicycloalkenyl, and the like), an alkynyl group (including 1-pentynyl, trimethylsilylethynyl, triethylsilylethynyl, tri-i-propylsilylethynyl, 2-p-propylphenylethynyl, and the like), an aryl group (including an aryl group having 6 to 20 carbon atoms, such as phenyl, naphthyl, p-pentylphenyl, 3,4-dipentylphenyl, p-heptoxyphenyl, and 3,4-diheptoxyphenyl), a heterocyclic group (which may be referred to as a hetero ring group, and include 2-hexylfuranyl, and the like), a cyano group, a hydroxy group, a nitro group, an acyl group (including hexanoyl, benzoyl, and the like), an alkoxy group (including butoxy and the like), an aryloxy group, a silyloxy group, a heterocyclic oxy group, an acyloxy group, a carbamoyloxy group, an amino group (including an anilino group), an acylamino group, an aminocarbonylamino group (including a ureido group), an alkoxy- and aryloxycarbonylamino group, an alkyl- and arylsulfonylamino group, a mercapto group, an alkyl- and arylthio group (including methylthio, octylthio, and the like), a

heterocyclic thio group, a sulfamoyl group, a sulfo group, an alkyl- and arylsulfinyl group, an alkyl- and arylsulfonyl group, an alkyl- and aryloxycarbonyl group, a carbamoyl group, aryl and heterocyclic azo group, an imido group, a phosphino group, a phosphinyl group, a phosphinyloxy group, a phosphinylamino group, a phosphono group, a silyl group (ditrimethylsiloxymethylbutoxy group, or the like), a hydrazino group, a ureido group, a boronic acid group ($-B(OH)_2$), a phosphato group ($-OPO(OH)_2$), a sulfato group ($-OSO_3H$), and other known substituents.

These substituents may further have the above-described substituents.

Among these, the substituent that can be taken by substituents $R^C$ to $R^T$ is preferably an alkyl group, an aryl group, an alkenyl group, an alkynyl group, a heterocyclic group, an alkoxy group, an alkylthio group, or a group represented by General Formula (W) to be described hereinafter, more preferably an alkyl group having 1 to 12 carbon atoms, an aryl group having 6 to 20 carbon atoms, an alkenyl group having 2 to 12 carbon atoms, an alkynyl group having 2 to 12 carbon atoms, an alkoxy group having 1 to 11 carbon atoms, a heterocyclic group having 5 to 12 carbon atoms, an alkylthio group having 1 to 12 carbon atoms, or a group represented by General Formula (W) to be described hereinafter, and particularly preferably a group represented by General Formula (W) to be described hereinafter.

The alkyl group, alkenyl group, alkynyl group, acyl group, and aryl group of $R^{D9}$, $R^{G9}$, and $R^{H7}$ have the same definitions as the alkyl group, alkenyl group, alkynyl group, acyl group, and aryl group described in the substituents that can be taken by substituents $R^C$ to $R^T$, respectively.

Further, the heteroaryl group has the same definition as the heteroaryl group described for the substituents of $R^{A1}$ to $R^{A6}$.

The group represented by General Formula (W): $-L-R^w$ will be described.

In General Formula (W), L represents a divalent linking group represented by any one of the following General Formulae (L-1) to (L-25), or a divalent linking group in which two or more (preferably two to ten, more preferably two to six, and still more preferably two or three) divalent linking groups represented by any one of the following General Formulae (L-1) to (L-25) are bonded to each other. $R^w$ represents a substituted or unsubstituted alkyl group, a cyano group, a vinyl group, an ethynyl group, an oxyethylene group, an oligooxyethylene group in which the number v of repeats of oxyethylene units is 2 or more, a siloxane group, an oligosiloxane group in which the number of silicon atoms is 2 or more, or a substituted or unsubstituted trialkylsilyl group.

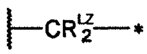 (L-1)

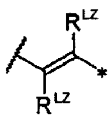 (L-2)

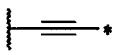 (L-3)

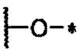 (L-4)

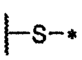 (L-5)

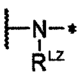 (L-6)

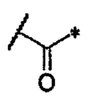 (L-7)

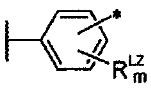 (L-13)

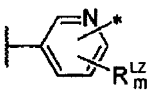 (L-14)

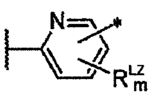 (L-15)

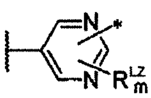 (L-16)

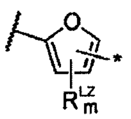 (L-17)

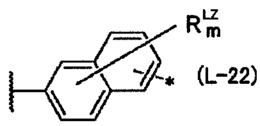 (L-22)

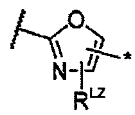 (L-23)

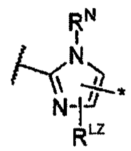 (L-24)

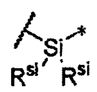 (L-25)

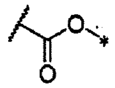
(L-8)

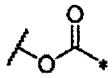
(L-9)

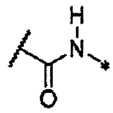
(L-10)

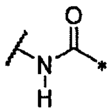
(L-11)

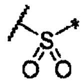
(L-12)

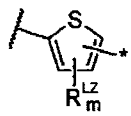
(L-18)

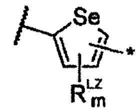
(L-19)

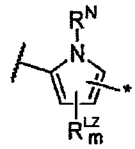
(L-20)

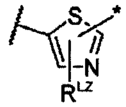
(L-21)

In General Formulae (L-1) to (L-25), the wavy line portion indicates a position of bonding to any one of the rings forming each skeleton represented by the above-described General Formulae (C) to (T). In the present specification, in a case where L represents a divalent linking group in which two or more divalent linking groups represented by any one of General Formulae (L-1) to (L-25) are bonded to each other, a wavy line portion may indicate a position of bonding to any one of the rings forming each skeleton represented by the above-described General Formulae (C) to (T) and a position of bonding to any one of divalent linking groups represented by General Formulae (L-1) to (L-25).

**[0218]** * indicates a position of bonding to $R^W$ or a position of bonding to the wavy line portion of General Formulae (L-1) to (L-25).

m in General Formula (L-13) represents 4, m in General Formulae (L-14) and (L-15) represents 3, m in General Formulae (L-16) to (L-20) represents 2, and m in General Formula (L-22) represents 6.

$R^{LZ}$'s in General Formulae (L-1), (L-2), (L-6), and (L-13) to (L-24) each independently represent a hydrogen atom or a substituent, and each of $R^{LZ}$'s in General Formula (L-1) and (L-2) may be bonded to $R^W$ adjacent to L to form a fused ring.

$R^N$ represents a hydrogen atom or a substituent, and $R^{si}$'s each independently represent a hydrogen atom, an alkyl group, an alkenyl group, or an alkynyl group.

Among them, the divalent linking group represented by General Formulae (L-17) to (L-21), (L-23), and (L-24) is more preferably a divalent linking group represented by the following General Formulae (L-17A) to (L-21A), (L-23A), and (L-24A).

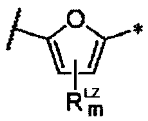
(L-17A)

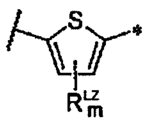
(L-18A)

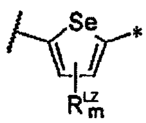
(L-19A)

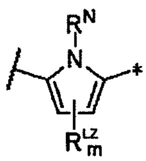
(L-20A)

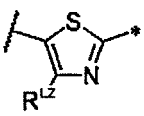
(L-21A)

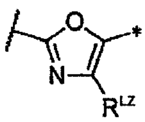
(L-23A)

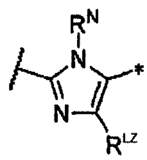
(L-24A)

Here, in a case where a substituted or unsubstituted alkyl group, an oxyethylene group, an oligooxyethylene group in which the number v of repeats of oxyethylene units is 2 or more, a siloxane group, an oligosiloxane group in which the number of silicon atoms is 2 or more, or a substituted or unsubstituted trialkylsilyl group is present at the terminal of the substituent, it may be interpreted as $-R^W$ alone in General Formula (W), or may also be interpreted as

-L-$R^w$ in General Formula (W).

In the present invention, in a case where a substituted or unsubstituted alkyl group having an N number of carbon atoms as the main chain is present at the terminal of the substituent, it is interpreted as -L-$R^w$ in General Formula (W) after containing a linking group as possible as from the terminal of the substituent and is not interpreted as -$R^w$ alone in General Formula (W). Specifically, it is interpreted as a substituent in which "one (L-1) corresponding to L in General Formula (W)" and "a substituted or unsubstituted alkyl group having an N-1 number of carbon atoms as the main chain corresponding to $R^w$ in General Formula (W)" are bonded to each other. For example, in a case where an n-octyl group which is an alkyl group having 8 carbon atoms is present at the terminal of the substituent, it is interpreted as a substituent in which one (L-1) in which two $R^{LZ}$'s are a hydrogen atom and an n-heptyl group having 7 carbon atoms are bonded to each other. Further, in a case where the substituent represented by General Formula (W) is an alkoxy group having 8 carbon atoms, it is interpreted as a substituent in which one linking group represented by General Formula (L-4), which is -O-, one linking group represented by (L-1) in which two $R^{LZ}$'s are hydrogen atoms, and an n-heptyl group having 7 carbon atoms are bonded to each other.

On the other hand, in the present invention, in a case where an oxyethylene group, an oligooxyethylene group in which the number v of repeats of oxyethylene units is 2 or more, a siloxane group, an oligosiloxane group in which the number of silicon atoms is 2 or more, or a substituted or unsubstituted trialkylsilyl group is present at the terminal of the substituent, it is interpreted as -$R^w$ alone in General Formula (W) after containing a linking group as possible as from the terminal of the substituent. For example, in a case where a $-(OCH_2CH_2)-(OCH_2CH_2)-(OCH_2CH_2)-OCH_3$ group is present at the terminal of the substituent, it is interpreted as a substituent of an oligooxyethylene group alone in which the number v of repeats of oxyethylene units is 3.

In a case where L forms a linking group to which divalent linking groups represented by any one of General Formulae (L-1) to (L-25) are bonded to each other, the number of bonding of the divalent linking groups represented by any one of General Formulae (L-1) to (L-25) is 2 to 4, and more preferably 2 or 3.

Examples of the substituent $R^{LZ}$ in General Formulae (L-1), (L-2), (L-6), and (L-13) to (L-24) include those exemplified as the substituents which can be taken by substituents $R^C$ to $R^T$ in General Formulae (C) to (T). Among them, the substituent $R^{LZ}$ in General Formula (L-6) is preferably an alkyl group, and in a case where the substituent $R^{LZ}$ in General Formula (L-6) is an alkyl group, the number of carbon atoms in the alkyl group is preferably 1 to 9, and from the viewpoint of chemical stability and carrier transportability, is more preferably 4 to 9 and still more preferably 5 to 9. In a case where the substituent $R^{LZ}$ in General Formula (L-6) is an alkyl group, the alkyl group is preferably a linear alkyl group from the viewpoint capable of enhancing the carrier mobility.

Examples of $R^N$ include those exemplified as the substituents which can be taken by substituents $R^C$ to $R^T$. Among them, $R^N$ is preferably a hydrogen atom or a methyl group.

$R^{si}$ is preferably an alkyl group. Although the alkyl group which can be taken by $R^{si}$ is not particularly limited, a preferred range of the alkyl group which can be taken by $R^{si}$ is the same as the preferred range of the alkyl group which can be taken by the silyl group in a case where $R^w$ is a silyl group. Although the alkenyl group which can be taken by $R^{si}$ is not particularly limited, it is preferably a substituted or unsubstituted alkenyl group, more preferably a branched alkenyl group, and the number of carbon atoms in the alkenyl group is preferably 2 to 3. Although the alkynyl group which can be taken by $R^{si}$ is not particularly limited, it is preferably a substituted or unsubstituted alkynyl group, more preferably a branched alkynyl group, and the number of carbon atoms in the alkynyl group is preferably 2 to 3.

L is preferably a divalent linking group represented by any one of General Formula (L-1) to (L-5), (L-13), (L-17), or (L-18), or a divalent linking group in which two or more divalent linking groups represented by any one of General Formula (L-1) to (L-5), (L-13), (L-17), or (L-18) are bonded to each other; more preferably a divalent linking group represented by any one of General Formula (L-1), (L-3), (L-13), or (L-18), or a divalent linking group in which two or more divalent linking groups represented by General Formula (L-1), (L-3), (L-13), or (L-18) are bonded to each other; and particularly preferably a divalent linking group represented by General Formula (L-1), (L-3), (L-13), or (L-18), or a divalent linking group in which a divalent linking group represented by any one of General Formula (L-3), (L-13), or (L-18) and a divalent linking group represented by General Formula (L-1) are bonded to each other. In the divalent linking group in which a divalent linking group represented by any one of General Formula (L-3), (L-13), or (L-18) and a divalent linking group represented by General Formula (L-1) are bonded to each other, the divalent linking group represented by General Formula (L-1) is preferably bonded to the $R^w$ side.

From the viewpoint of chemical stability and carrier transportability, particularly preferred is a divalent linking group containing a divalent linking group represented by General Formula (L-1); more particularly preferred is a divalent linking group represented by General Formula (L-1); still more particularly preferred is that L is a divalent linking group represented by General Formulae (L-18) and (L-1) and is bonded to $R^w$ via (L-1), and $R^w$ is a substituted or unsubstituted alkyl group; and even more particularly preferred is that L is a divalent linking group represented by General Formulae (L-18A) and (L-1) and is bonded to $R^w$ via (L-1), and $R^w$ is a substituted or unsubstituted alkyl group.

In General Formula (W), $R^w$ is preferably a substituted or unsubstituted alkyl group. In General Formula (W), in a case where L adjacent to $R^w$ is a divalent linking group represented by General Formula (L-1), $R^w$ is preferably a

substituted or unsubstituted alkyl group, an oxyethylene group, an oligooxyethylene group in which the number v of repeats of oxyethylene units is 2 or more, a siloxane group, or an oligosiloxane group in which the number of silicon atoms is 2 or more, and more preferably a substituted or unsubstituted alkyl group.

In General Formula (W), in a case where L adjacent to $R^w$ is a divalent linking group represented by General Formulae (L-2) and (L-4) to (L-25), $R^w$ is more preferably a substituted or unsubstituted alkyl group.

In General Formula (W), in a case where L adjacent to $R^w$ is a divalent linking group represented by General Formula (L-3), $R^w$ is preferably a substituted or unsubstituted alkyl group, or a substituted or unsubstituted silyl group.

In a case where $R^w$ is a substituted or unsubstituted alkyl group, the number of carbon atoms in the alkyl group is preferably 4 to 17, and from the viewpoint of chemical stability and carrier transportability, is more preferably 6 to 14 and still more preferably 6 to 12. It is preferred that $R^w$ is a long-chain alkyl group falling within the above-specified range, particularly a long-chain linear alkyl group, from the viewpoint of enhancing linearity of the molecule and thus increasing carrier mobility.

In a case where $R^w$ represents an alkyl group, the alkyl group may be a linear alkyl group, a branched alkyl group, or a cyclic alkyl group, but it is preferably a linear alkyl group, from the viewpoint of enhancing linearity of the molecule and thus increasing carrier mobility.

Among them, the combination of $R^w$ and L in General Formula (W) is preferably a combination in which L in General Formulae (C) to (T) is a divalent linking group represented by General Formula (L-1), and $R^w$ is a linear alkyl group having 4 to 17 carbon atoms; or a combination in which L is a divalent linking group in which a divalent linking group represented by any one of General Formula (L-3), (L-13), or (L-18) and a divalent linking group represented by General Formula (L-1) are bonded to each other, and $R^w$ is a linear alkyl group, from the viewpoint of enhancing carrier mobility.

In a case where L is a divalent linking group represented by General Formula (L-1), and $R^w$ is a linear alkyl group having 4 to 17 carbon atoms, $R^w$ is more preferably a linear alkyl group having 6 to 14 carbon atoms from the viewpoint of enhancing carrier mobility, and particularly preferably a linear alkyl group having 6 to 12 carbon atoms.

In a case where L is a divalent linking group in which a divalent linking group represented by any one of General Formula (L-3), (L-13), or (L-18) and a divalent linking group represented by General Formula (L-1) are bonded to each other, and $R^w$ is a linear alkyl group, $R^w$ is more preferably a linear alkyl group having 4 to 17 carbon atoms, still more preferably a linear alkyl group having 6 to 14 carbon atoms from the viewpoint of chemical stability and carrier transportability, and particularly preferably a linear alkyl group having 6 to 12 carbon atoms from the viewpoint of enhancing carrier mobility.

On the other hand, $R^w$ is preferably a branched alkyl group from the viewpoint of enhancing solubility in an organic solvent.

In a case where $R^w$ is an alkyl group having a substituent, the substituent may be a halogen atom or the like, and is preferably a fluorine atom. Incidentally, in a case where $R^w$ is an alkyl group having a fluorine atom, hydrogen atoms of the alkyl group may be completely substituted with fluorine atoms to form a perfluoroalkyl group, provided that $R^w$ is preferably an unsubstituted alkyl group.

In a case where $R^w$ is an ethyleneoxy group or an oligoethyleneoxy group, the term "oligooxyethylene group" represented by $R^w$, as used herein, refers to a group represented by $-(OCH_2CH_2)_vOY$ (in which the number v of repeats of oxyethylene units represents an integer of 2 or more, and terminal Y represents a hydrogen atom or a substituent). In a case where Y at the terminal of the oligooxyethylene group is a hydrogen atom, $R^w$ becomes a hydroxy group. The number v of repeats of oxyethylene units is preferably 2 to 4, and more preferably 2 to 3. It is preferred that the terminal hydroxy group of the oligooxyethylene group is blocked, that is, Y represents a substituent. It this case, the hydroxy group is blocked with an alkyl group having 1 to 3 carbon atoms, that is, Y is preferably an alkyl group having 1 to 3 carbon atoms, more preferably a methyl group or an ethyl group, and particularly preferably a methyl group.

In a case where $R^w$ is a siloxane group or an oligosiloxane group, the number of repeats of siloxane units is preferably 2 to 4, and more preferably 2 to 3. In addition, it is preferred that a hydrogen atom or an alkyl group is bonded to Si atoms. In a case where an alkyl group is bonded to Si atoms, the number of carbon atoms in the alkyl group is preferably 1 to 3. For example, a methyl group or an ethyl group is preferably bonded to Si atoms. The same alkyl groups may be bonded to Si atoms, or different alkyl groups or hydrogen atoms may be bonded to Si atoms. Moreover, all of the siloxane units constituting the oligosiloxane group may be the same or different, but they are preferably the same.

In a case where L adjacent to $R^w$ is a divalent linking group represented by General Formula (L-3), $R^w$ is also preferably a substituted or unsubstituted silyl group. In a case where $R^w$ is a substituted or unsubstituted silyl group, inter alia, it is preferred that $R^w$ is a substituted silyl group. The substituent for the silyl group is not particularly limited, but it is preferably a substituted or unsubstituted alkyl group, and more preferably a branched alkyl group. In a case where $R^w$ is a trialkylsilyl group, the number of carbon atoms in the alkyl group bonded to Si atoms is preferably 1 to 3. For example, a methyl group, an ethyl group, or an isopropyl group is preferably bonded to Si atoms. The same or different alkyl groups may be bonded to Si atoms. In a case where $R^w$ is a trialkylsilyl group which further has a substituent on the alkyl group, such a substituent is not particularly limited.

In General Formula (W), the total number of carbon atoms contained in L and $R^w$ is preferably 5 to 18. If the total number of carbon atoms contained in L and $R^w$ is higher than or equal to the lower limit of the above-specified range, the carrier mobility is increased to thereby lower a driving voltage. If the total number of carbon atoms contained in L and $R^w$ is lower than or equal to the upper limit of the above-specified range, solubility in an organic solvent increases.

The total number of carbon atoms contained in L and $R^w$ is preferably 5 to 14, more preferably 6 to 14, particularly preferably 6 to 12, and more particularly preferably 8 to 12.

Among substituents $R^C$ to $R^T$ in each compound represented by General Formulae (C) to (T), the number of groups represented by General Formula (W) is preferably 1 to 4, more preferably 1 or 2, and particularly preferably 2, from the viewpoint of increasing carrier mobility and enhancing solubility in an organic solvent.

There is no particular limitation on the position of a group represented by General Formula (W), among substituents $R^C$ to $R^T$.

In the compound represented by General Formula (C), it is preferred that one of $R^{C1}$, $R^{C2}$, $R^{C3}$, and $R^{C6}$ is a group represented by General Formula (W), and it is more preferred that both of $R^{C1}$ and $R^{C2}$ or both of $R^{C3}$ and $R^{C6}$ are a group represented by General Formula (W).

In the compound represented by General Formula (D), it is preferred that $R^{D6}$ is a group represented by General Formula (W), and it is more preferred that both of $R^{D5}$ and $R^{D6}$ are a group represented by General Formula (W).

In the compound represented by General Formula (E), it is preferred that $R^{E6}$ is a group represented by General Formula (W), and it is more preferred that both of $R^{E5}$ and $R^{E6}$ are a group represented by General Formula (W). Further, in a case where $R^{E5}$ and $R^{E6}$ are a substituent other than the group represented by General Formula (W), it is also preferred that two $R^{E7}$'s are a group represented by General Formula (W).

In the compound represented by General Formula (F), it is preferred that at least one of $R^{F2}$, $R^{F3}$, $R^{F8}$, or $R^{F9}$ is a substituent represented by General Formula (W).

In the compound represented by General Formula (G), it is preferred that $R^{G5}$ or $R^{G6}$ is a group represented by General Formula (W), from the viewpoint of increasing carrier mobility and enhancing solubility in an organic solvent.

In the compound represented by General Formula (H), it is preferred that $R^{H4}$ or $R^{H6}$ is a group represented by General Formula (W), and it is more preferred that $R^{H4}$ or $R^{H6}$, and $R^{H3}$ or $R^{H5}$ are a group represented by General Formula (W).

In the compound represented by General Formula (J), it is preferred that $R^{J8}$ is a group represented by General Formula (W), and it is more preferred that both of $R^{J8}$ and $R^{J4}$ are a group represented by General Formula (W).

In the compound represented by General Formula (K), it is preferred that $R^{K7}$ is a group represented by General Formula (W), and it is more preferred that both of $R^{K7}$ and $R^{K3}$ are a group represented by General Formula (W).

In the compound represented by General Formula (L), it is more preferred that at least one of $R^{L2}$, $R^{L3}$, $R^{L6}$, or $R^{L7}$ is a group represented by General Formula (W).

In the compound represented by General Formula (M), it is preferred that $R^{M2}$ is a group represented by General Formula (W), and it is more preferred that both of $R^{M2}$ and $R^{M6}$ are a group represented by General Formula (W).

In the compound represented by General Formula (N), it is preferred that $R^{N3}$ is a group represented by General Formula (W), and it is more preferred that both of $R^{N3}$ and $R^{N9}$ are a group represented by General Formula (W).

In the compound represented by General Formula (P), it is preferred that $R^{P2}$ or $R^{P3}$ is a group represented by General Formula (W), and it is more preferred that both of $R^{P2}$ and $R^{P8}$ or both of $R^{P3}$ and $R^{P9}$ are a group represented by General Formula (W).

In the compound represented by General Formula (Q), it is preferred that $R^{Q3}$ is a group represented by General Formula (W), and it is more preferred that both of $R^{Q3}$ and $R^{Q9}$ are a group represented by General Formula (W).

In the compound represented by General Formula (R), it is preferred that $R^{R2}$ is a group represented by General Formula (W), and it is more preferred that both of $R^{R2}$ and $R^{R7}$ are a group represented by General Formula (W).

In the compound represented by General Formula (S), it is preferred that $R^{S2}$ is a group represented by General Formula (W), and it is more preferred that both of $R^{S2}$ and $R^{S5}$ are a group represented by General Formula (W).

In the compound represented by General Formula (T), it is preferred that $R^{T2}$ is a group represented by General Formula (W), and it is more preferred that both of $R^{T2}$ and $R^{T5}$ are a group represented by General Formula (W).

The number of substituents other than the group represented by General Formula (W), among substituents $R^C$ to $R^T$, is preferably 0 to 4, and more preferably 0 to 2.

Hereinafter, specific examples of each compound represented by General Formula (C) to General Formula (T) are shown, but compounds that can be used in the present invention should not be construed to be limited thereby.

Specific examples of compound C represented by General Formula (C) are shown below.

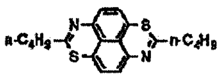

Compound C1

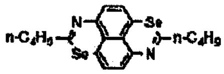

Compound C2

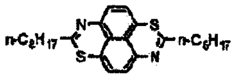

Compound C3

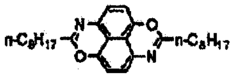

Compound C4

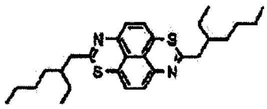

Compound C5

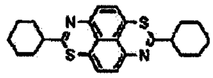

Compound C6

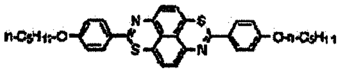

Compound C7

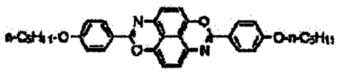

Compound C8

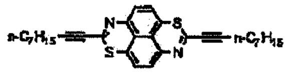

Compound C9

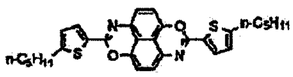

Compound C10

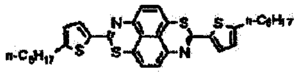

Compound C11

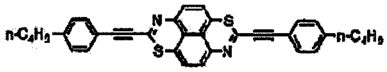

Compound C12

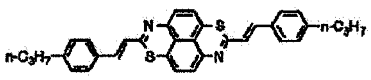

Compound C13

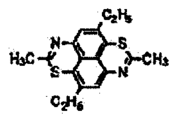

Compound C14

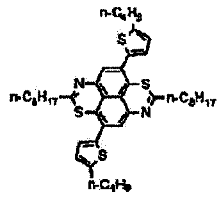

Compound C15

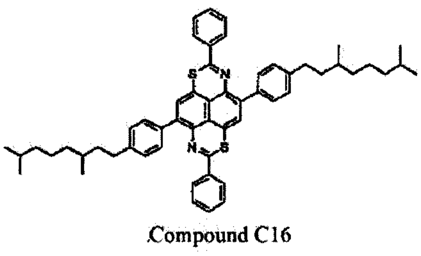

Compound C16

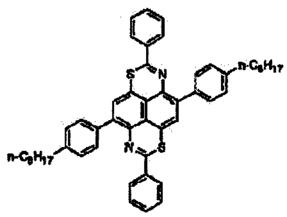

Compound C17

The compound represented by Formula (C) preferably has a molecular weight of 3,000 or less, more preferably 2,000 or less, still more preferably 1,000 or less, and particularly preferably 850 or less. If the molecular weight is within the above-specified range, it is possible to increase solubility in a solvent.

On the other hand, the molecular weight is preferably 300 or more, more preferably 350 or more, and still more preferably 400 or more, from the viewpoint of film quality stability of a thin film.

Specific examples of compound D represented by General Formula (D) are shown below.

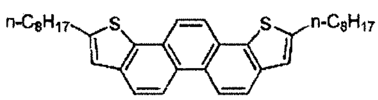

Compound D1

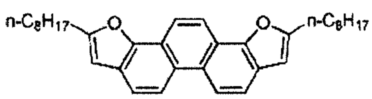

Compound D2

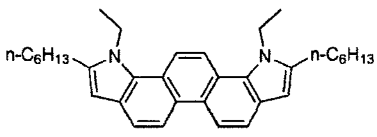
Compound D3

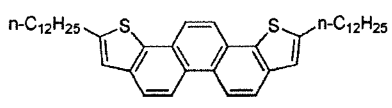
Compound D4

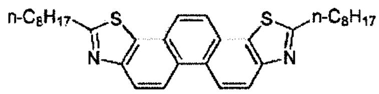
Compound D5

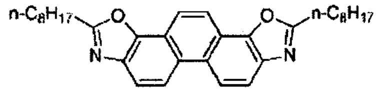
Compound D6

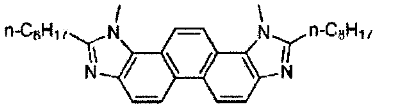
Compound D7

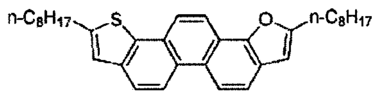
Compound D8

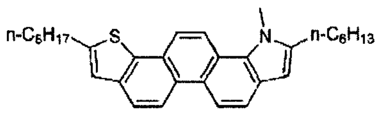
Compound D9

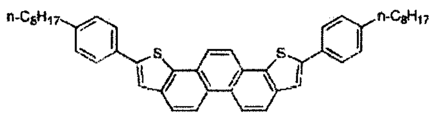
Compound D10

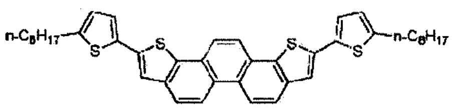
Compound D11

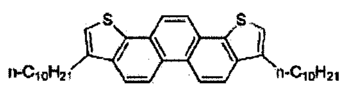
Compound D12

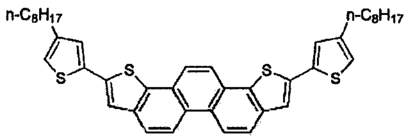
Compound D13

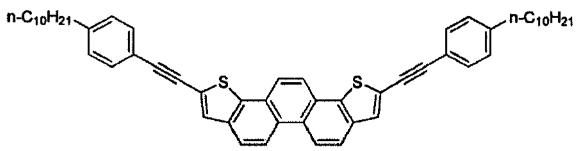
Compound D14

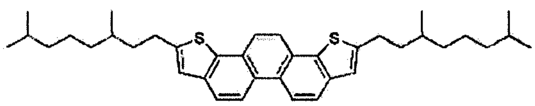
Compound D15

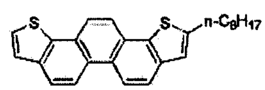
Compound D16

With regard to the molecular weight of the compound represented by General Formula (D), the upper limit thereof is preferably the same as that of the compound represented by General Formula (C), whereby solubility in a solvent can be increased. On the other hand, the molecular weight is preferably 400 or more, more preferably 450 or more, and still more preferably 500 or more, from the viewpoint of film quality stability of a thin film.

Specific examples of each of compound E represented by General Formula (E), compound F represented by General Formula (F), compound G represented by General Formula (G), and compound H represented by General Formula (H) are shown in order.

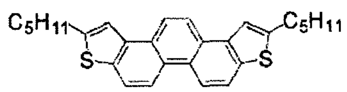

Compound E1

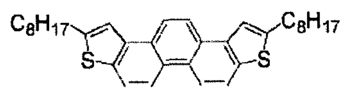

Compound E2

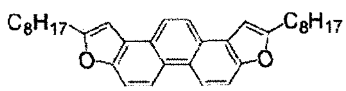

Compound E3

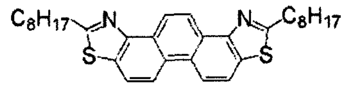

Compound E4

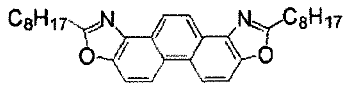

Compound E5

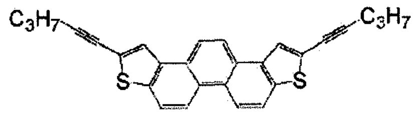

Compound E6

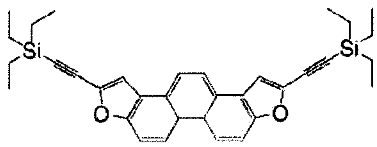

Compound E7

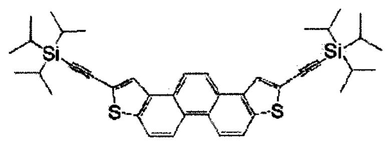

Compound E8

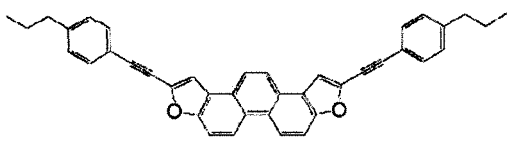

Compound E9

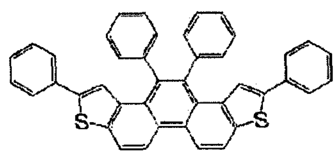

Compound E10

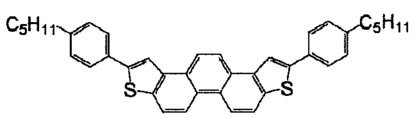

Compound E11

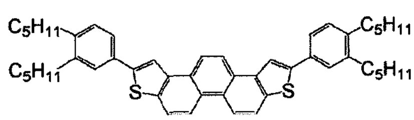

Compound E12

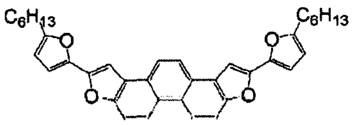

Compound E13

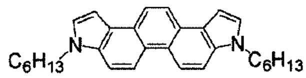

Compound E14

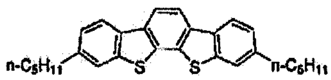

Compound F1

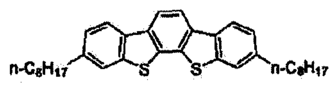

Compound F2

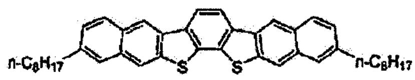

Compound F3

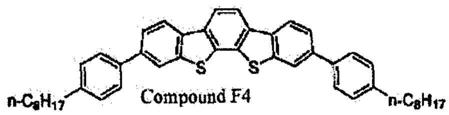

Compound F4

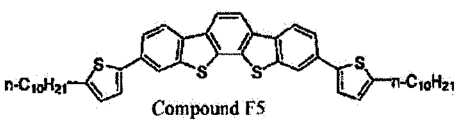

Compound F5

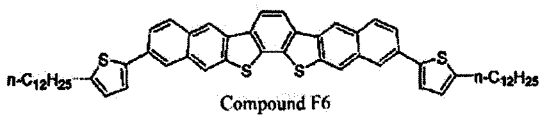

Compound F6

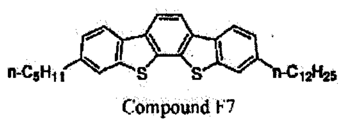

Compound F7

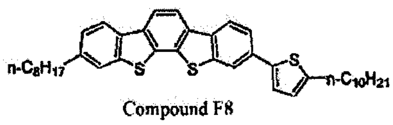

Compound F8

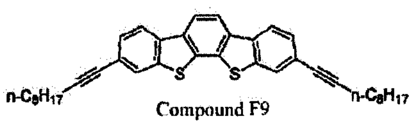

Compound F9

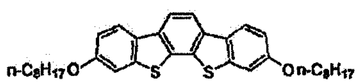

Compound F10

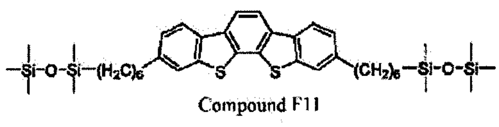

Compound F11

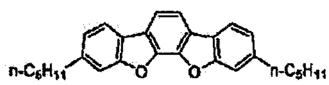

Compound F12

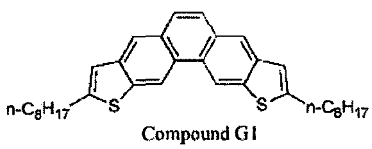

Compound G1

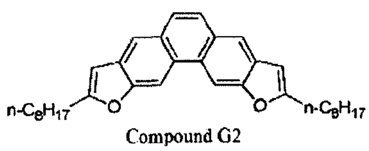

Compound G2

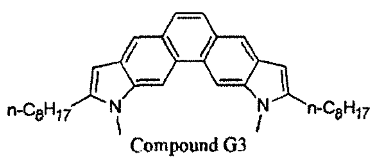

Compound G3

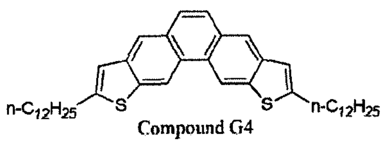

Compound G4

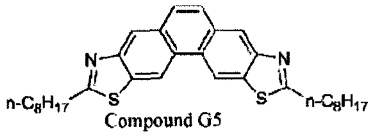
Compound G5

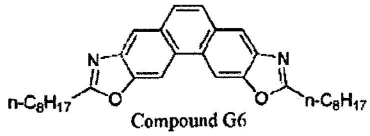
Compound G6

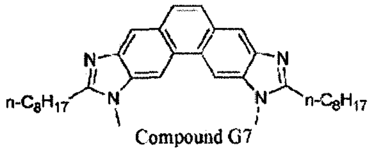
Compound G7

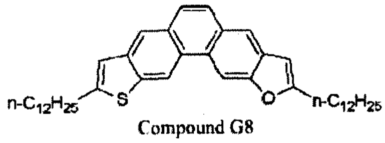
Compound G8

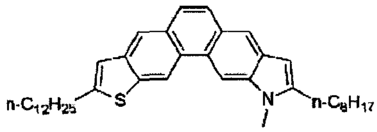
Compound G9

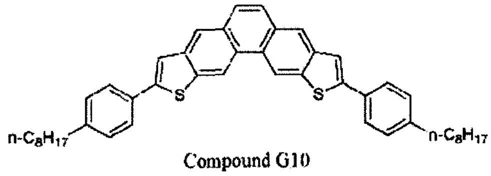
Compound G10

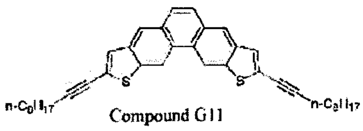
Compound G11

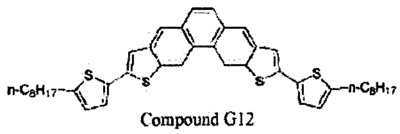
Compound G12

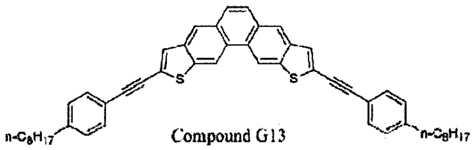
Compound G13

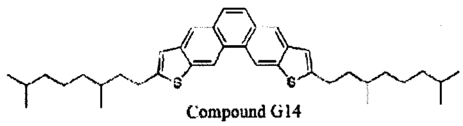
Compound G14

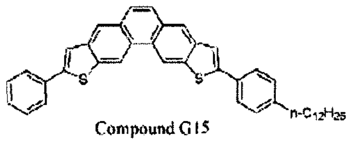
Compound G15

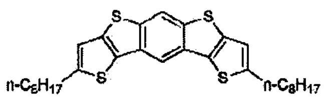
Compound H1

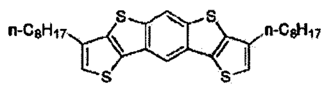
Compound H2

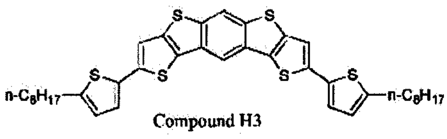
Compound H3

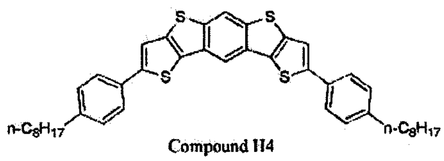
Compound H4

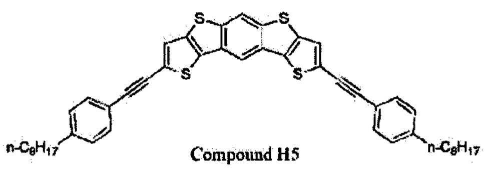
Compound H5

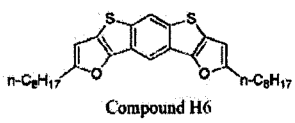
Compound H6

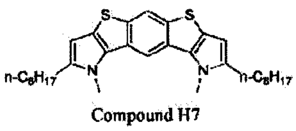
Compound H7

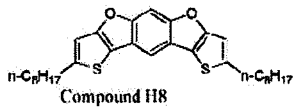
Compound H8

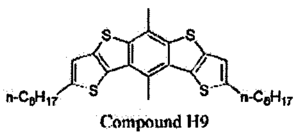
Compound H9

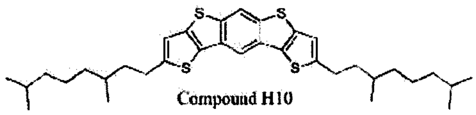
Compound H10

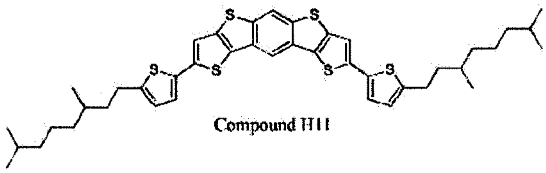
Compound H11

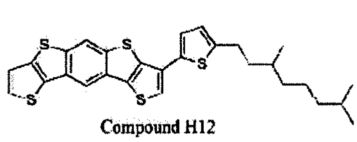
Compound H12

With regard to the molecular weight of compound E, compound F, compound G, and compound H, the upper limit of the molecular weight for each compound is preferably the same as that of the compound represented by General Formula (C), whereby solubility in a solvent can be increased. On the other hand, the lower limit of the molecular weight is the same as that of the compound represented by General Formula (D), from the viewpoint of film quality stability of a thin film.

Specific examples of compound J and compound K represented by General Formula (J) and General Formula (K) are shown below.

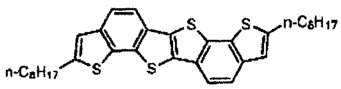
Compound J1

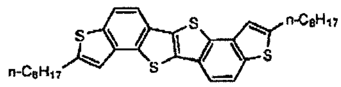
Compound K1

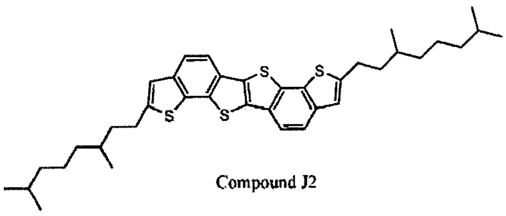
Compound J2

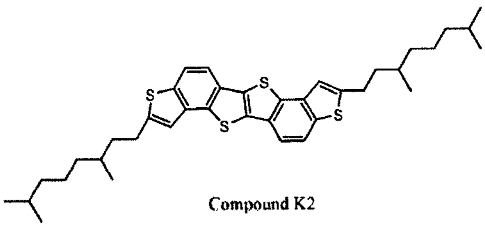
Compound K2

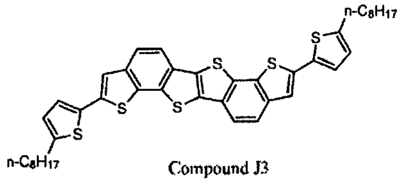
Compound J3

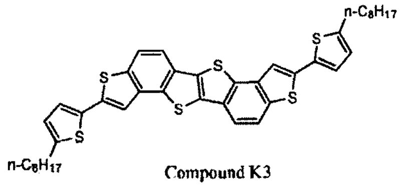
Compound K3

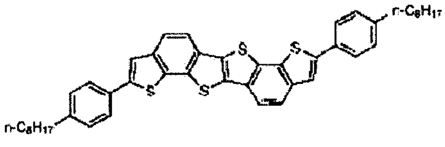
Compound J4

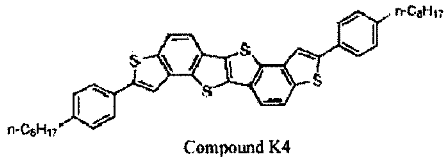
Compound K4

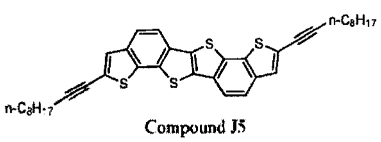

Compound J5

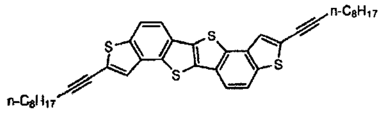

Compound K5

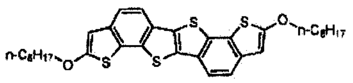

Compound J6

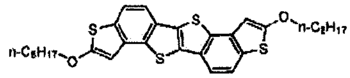

Compound K6

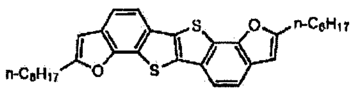

Compound J7

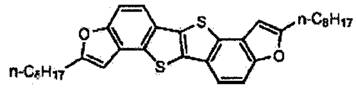

Compound K7

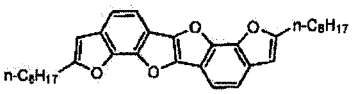

Compound J8

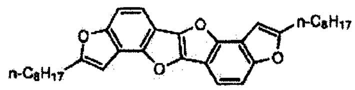

Compound K8

With regard to the molecular weight of compound J and compound K, the upper limit of the molecular weight for each compound is preferably the same as that of compound C represented by General Formula (C), whereby solubility in a solvent can be increased. On the other hand, the lower limit of the molecular weight is the same as that of the compound represented by General Formula (D), from the viewpoint of film quality stability of a thin film.

Specific examples of each of compound L represented by General Formula (L), compound M represented by General Formula (M), compound N represented by General Formula (N), compound P represented by General Formula (P), and compound Q represented by General Formula (Q) are shown in order.

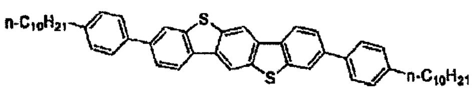

Compound L1

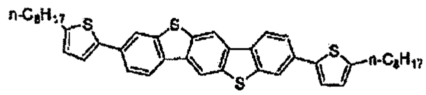

Compound L2

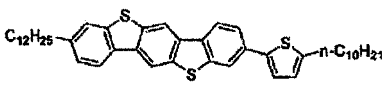

Compound L3

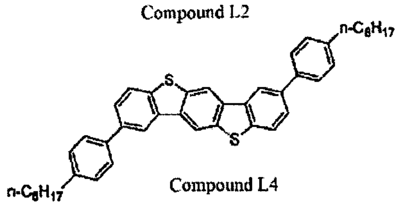

Compound L4

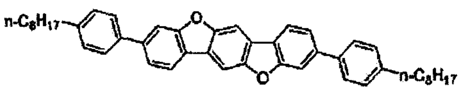

Compound L5

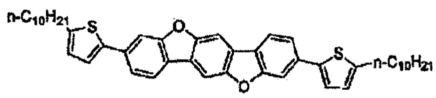

Compound L6

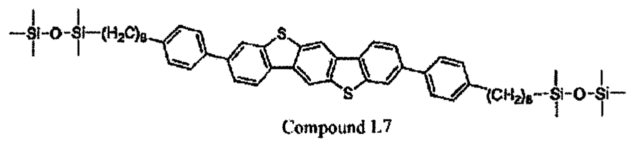

Compound L7

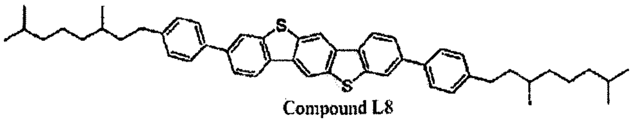

Compound L8

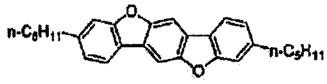

Compound L9

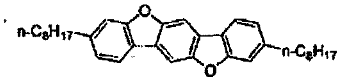

Compound L10

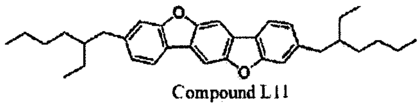

Compound L11

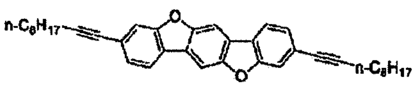

Compound L12

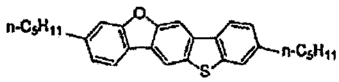

Compound L13

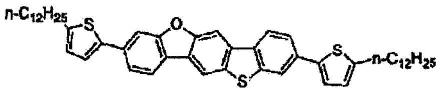

Compound L14

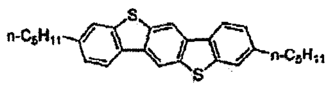

Compound L15

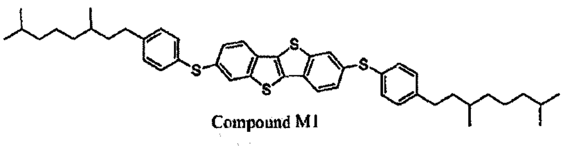

Compound M1

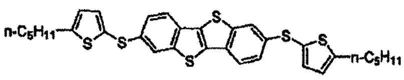

Compound M2

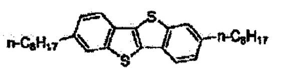

Compound M3
(C8BTBT)

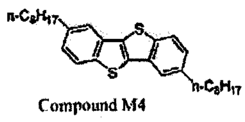

Compound M4

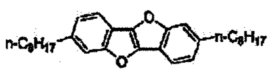

Compound M5

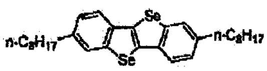

Compound M6

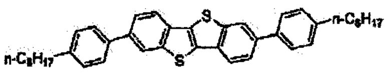

Compound M7

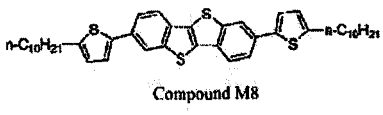

Compound M8

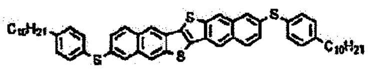

Compound N1

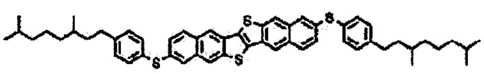

Compound N2

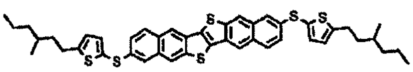

Compound N3

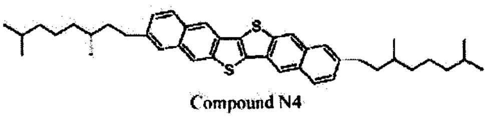

Compound N4

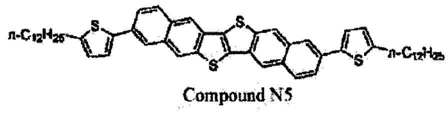

Compound N5

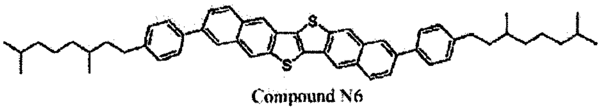

Compound N6

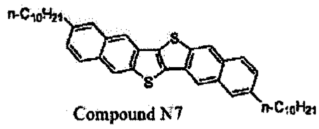

Compound N7

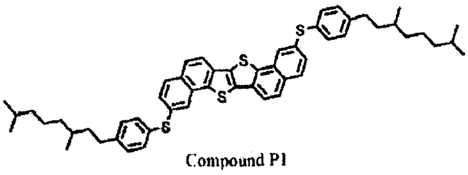

Compound P1

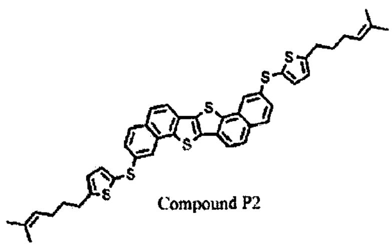

Compound P2

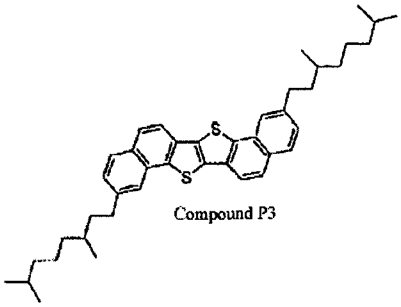

Compound P3

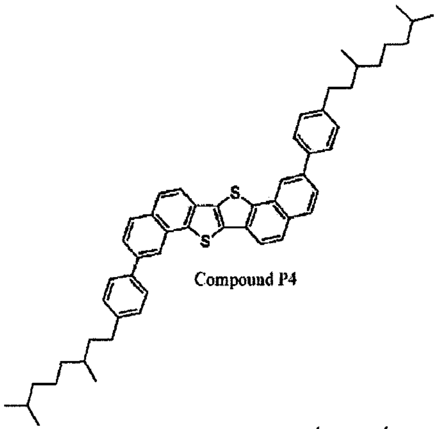

Compound P4

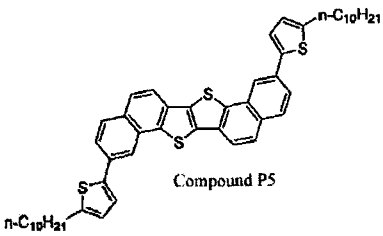

Compound P5

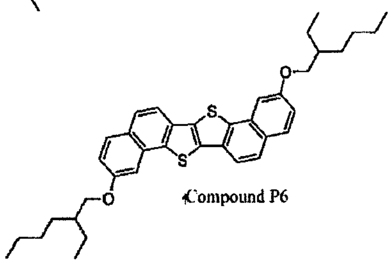

Compound P6

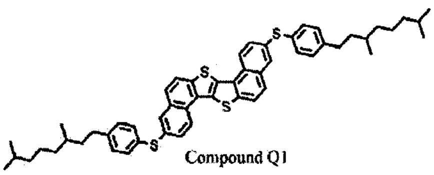

Compound Q1

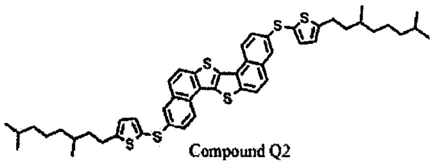

Compound Q2

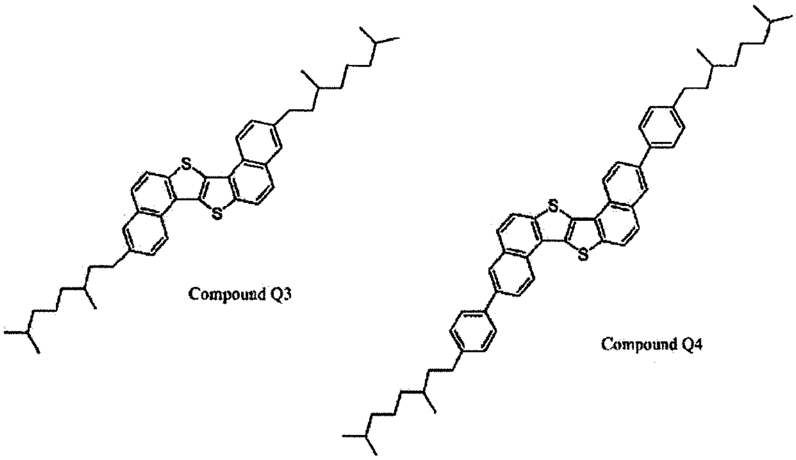

Compound Q3

Compound Q4

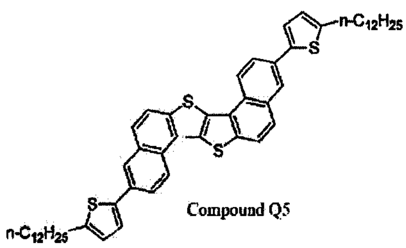

Compound Q5

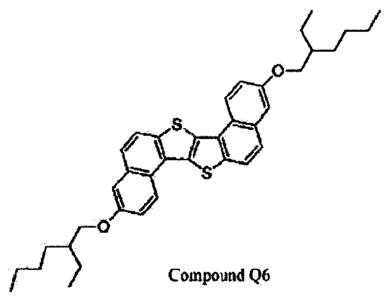

Compound Q6

With regard to the molecular weight of compound L, compound M, compound N, compound P, and compound Q, the upper limit of the molecular weight for each compound is preferably the same as that of compound C represented by General Formula (C), whereby solubility in a solvent can be increased. On the other hand, the lower limit of the molecular weight is the same as that of the compound represented by General Formula (D), from the viewpoint of film quality stability of a thin film.

Specific examples of each of compound R represented by General Formula (R), compound S represented by General Formula (S), and compound T represented by General Formula (T) are shown in order.

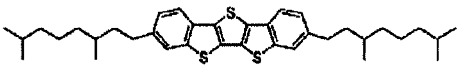

Compound R1

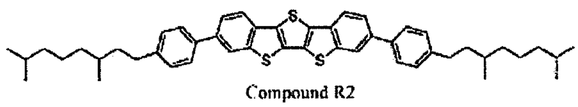

Compound R2

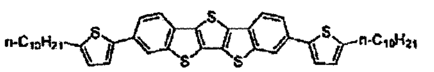

Compound R3

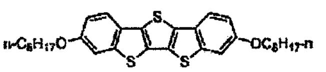

Compound R4

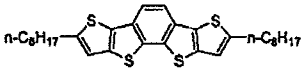

Compound S1

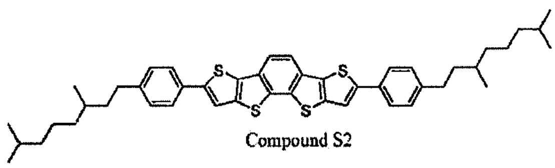

Compound S2

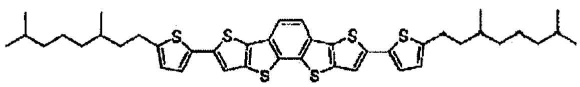

Compound S3

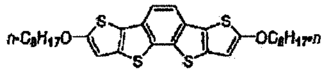

Compound S4

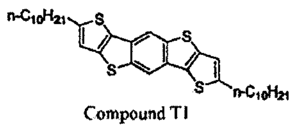

Compound T1

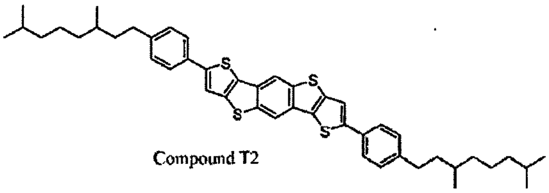

Compound T2

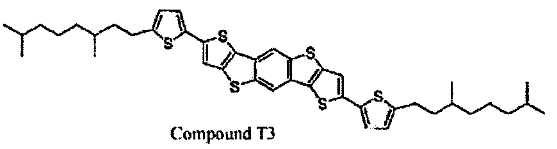

Compound T3

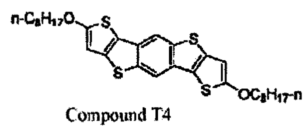

Compound T4

With regard to the molecular weight of compound R, compound S, and compound T, the upper limit of the molecular weight for each compound is preferably the same as that of compound C represented by General Formula (C), whereby solubility in a solvent can be increased. On the other hand, the lower limit of the molecular weight is the same as that of the compound represented by General Formula (D), from the viewpoint of film quality stability of a thin film.

Examples of the organic polymer and derivatives thereof include polymers such as polypyrrole and derivatives thereof, polydiketopyrrole and derivatives thereof, polythiophene and derivatives thereof, isothianaphthene such as polyisothianaphthene, thienylenevinylene such as polythienylenevinylene, poly(p-phenylenevinylene), polyaniline and derivatives thereof, polyacetylene, polydiacetylene, polyazulene, polypyrene, polycarbazole, polyselenophene, polyfuran, poly(p-phenylene), polyindole, polypyridazine, polytellurophene, polynaphthalene, polyvinylcarbazole, polyphenylene sulfide, and polyvinylene sulfide; and polymers of fused polycyclic aromatic compounds.

The polythiophene and derivatives thereof are not particularly limited, but examples thereof include poly-3-hexylthiophene (P3HT), polyethylenedioxythiophene, and poly(3,4-ethylenedioxythiophene)/polystyrenesulfonic acid (PEDOT/PSS), each of where hexyl groups are introduced into polythiophene.

Further examples thereof include oligomers (for example, oligothiophene) having the same repeating units as in those polymers.

Further, the organic polymer includes, for example, a polymer compound where the compound represented by the following General Formulae (C) to (T) has a repeating structure.

Examples of such a polymer compound include pendant polymers where the compound represented by General Formulae (C) to (T) is bonded to a $\pi$ conjugated polymer representing a repeating structure via at least one or more arylene groups or heteroarylene groups (thiophene, bithiophene, or the like), or the compound represented by General Formulae (C) to (T) is bonded to a polymer main chain via a side chain. The polymer main chain is preferably polyacrylate, polyvinyl, polysiloxane, or the like, and the side chain is preferably an alkylene group, a polyethylene oxide group, or the like. In a case of a pendant polymer, the polymer main chain may be one where at least one of substituents $R^C$, $R^D$, $R^E$, $R^F$, $R^G$, $R^H$, $R^I$, $R^J$, $R^K$, $R^L$, $R^M$, $R^N$, $R^O$, $R^P$, $R^Q$, $R^R$, $R^S$, or $R^T$ has a group derived from a polymerizable group, and which is formed by polymerization of such a group.

These organic polymers preferably have a weight-average molecular weight of 30,000 or more, more preferably 50,000 or more, and still more preferably 100,000 or more. When the weight-average molecular weight is higher than or equal to the above-specified lower limit, an intermolecular interaction can be enhanced, and thus high mobility can be obtained.

In addition to the above-mentioned organic polymers, it is also preferable to further use the other resin (D). Examples of the resin (D) include insulating polymers such as polystyrene, poly-$\alpha$-methylstyrene, polycarbonate, polyarylate, polyester, polyamide, polyimide, polyurethane, polysiloxane, polysilsesquioxane, polysulfone, polymethacrylate typified by polymethylmethacrylate, polyacrylate typified by polymethylacrylate, cellulose typified by triacetylcellulose, polyethylene, polypropylene, polyvinyl phenol, polyvinyl alcohol, and polyvinyl butyral, and copolymers obtained by copolymerizing two or more of these constituting components.

In a case where the resin (D) is used, the mass proportion of the organic polymer relative to the total amount of the organic polymer and the resin (D) is preferably 10 mass% or more and less than 100 mass%, and preferably 20 mass% or more and less than 100 mass%.

The total content of the organic polymer and the resin (D) in the organic semiconductor layer is preferably 1 mass% to 80 mass%, more preferably 5 mass% to 60 mass%, and still more preferably 10 mass% to 50 mass%.

When the organic semiconductor layer is formed on the gate insulating layer by a wet method (wet coating method), it is easy to obtain a high-performance OTFT in a simple manner and at low cost, and it is also suitable for achieving a large area of an OTFT. Thus, a wet method is preferred as the method of forming an organic semiconductor layer.

The wet method is not particularly limited. For example, the organic semiconductor layer may be formed by applying a semiconductor material using a spin coating method, an inkjet method, a nozzle printing method, a stamp printing method, a screen printing method, a gravure printing method, an electrospray deposition method, or the like, followed by drying.

In a case where the organic semiconductor layer is formed on the gate insulating layer by a wet coating method, from the viewpoint of an OTFT being prone to high performance, it is preferred that the organic semiconductor layer has been subjected to crystallization treatment, and it is particularly preferred that the organic semiconductor layer has been subjected to crystallization treatment by heating or laser irradiation.

The method for crystallization treatment is not particularly limited, and examples thereof include heating using a hot plate, an oven, or the like and laser irradiation. With regard to the heating temperature, a high temperature is preferred from the viewpoint that crystallization easily progresses and, on the other hand, a low temperature is preferred from the viewpoint that the heat hardly affects a substrate or the like. Specifically, the heating temperature is preferably 50°C or higher and particularly preferably 100°C or higher and, on the other hand, the heating temperature is preferably 300°C or lower and particularly preferably 250°C or lower.

<Inorganic Semiconductor Layer>

The inorganic semiconductor material for forming a semiconductor layer is not particularly limited, but a coating-type semiconductor is preferred, and a preferred example of which includes an oxide semiconductor.

The oxide semiconductor is not particularly limited as long as it is constituted of a metal oxide. A semiconductor layer constituted of the oxide semiconductor is preferably formed using an oxide semiconductor precursor, that is, a material which is converted into a semiconductor material constituted of a metal oxide by conversion treatment such as thermal oxidation.

The oxide semiconductor is not particularly limited, but examples thereof include indium gallium zinc oxide, indium gallium oxide, indium tin zinc oxide, gallium zinc oxide, indium tin oxide, indium zinc oxide, tin zinc oxide, zinc oxide, and tin oxide, for example $InGaZnO_x$, $InGaO_x$, $InSnZnO_x$, $GaZnO_x$, $InSnO_x$, $InZnO_x$, $SnZnO_x$ (all of which have $x>0$), ZnO, and $SnO_2$.

Examples of the oxide semiconductor precursor include metal nitrates, metal halides, and alkoxides. The metal contained in the above-described oxide semiconductor precursor may be, for example, at least one selected from the group consisting of Li, Be, B, Na, Mg, Al, Si, K, Ca, Sc, Ti, V, Cr, Mn, Fe, Co, Ni, Cu, Zn, Ga, Ge, Rb, Sr, Y, Zr, Nb, Mo, Cd, In, Ir, Sn, Sb, Cs, Ba, La, Hf, Ta, W, Tl, Pb, Bi, Ce, Pr, Nd, Pm, Eu, Gd, Tb, Dy, Ho, Er, Tm, Yb, and Lu.

Specific examples of the oxide semiconductor precursor include indium nitrate, zinc nitrate, gallium nitrate, tin nitrate, aluminum nitrate, indium chloride, zinc chloride, tin (II) chloride, tin (IV) chloride, gallium chloride, aluminum chloride, tri-i-propoxyindium, diethoxyzinc, bis(dipivaloylmethanato)zinc, tetraethoxytin, tetra-i-propoxytin, tri-i-propoxygallium, and tri-i-propoxyaluminum.

The inorganic semiconductor layer can be provided by a known method.

The film thickness of the semiconductor layer is arbitrary, but it is preferably 1 nm or more, and more preferably 10 nm or more. Further, the film thickness of the semiconductor layer is preferably 10 μm or less, more preferably 1 μm or less, and particularly preferably 500 nm or less.

[Source Electrode and Drain Electrode]

In the TFT of the present invention, the source electrode is an electrode into which an electric current flows through the wiring from the outside. In addition, the drain electrode is an electrode which transmits an electric current to the outside through the wiring, and is typically provided in contact with the semiconductor layer.

As a material for the source electrode and the drain electrode, it is possible to use a conductive material used in a conventional organic thin film transistor, examples of which include the conductive materials illustrated in the above-described gate electrode, and the like materials.

The source electrode and the drain electrode can be respectively formed by the same method as the above-described method of forming a gate electrode.

A lift-off method or an etching method may be employed as the above-described photolithographic method.

In particular, since the gate insulating layer exhibits excellent resistance to an etching solution and a stripping solution, the source electrode and the drain electrode can be suitably formed also by an etching method. The etching method is a method of removing an unnecessary portion by etching after the formation of a conductive material into a film. If patterning is carried out by the etching method, the conductive material remaining on the underlayer during the removal of a resist is stripped and re-deposition of the resist residues and removed conductive materials into the underlayer can be prevented, resulting in an excellent shape of an electrode edge part. In this regard, the etching method is preferred over a lift-off method.

The lift-off method is a method of forming a film of a conductive material only in the portion onto which a resist is not applied, by applying the resist onto a portion of the underlayer, forming a film of the conductive material thereon, and eluting or stripping the resist or the like using a solvent to thereby remove conductive materials on the resist.
The thickness of each of the source electrode and the drain electrode is arbitrary, but it is preferably 1 nm or more, and particularly preferably 10 nm or more. In addition, the thickness of each of the source electrode and the drain electrode is preferably 500 nm or less, and particularly preferably 300 nm or less.
The spacing (channel length) between the source electrode and the drain electrode is arbitrary, but it is preferably 100 μm or less, and particularly preferably 50 μm or less. The channel width is preferably 5,000 μm or less, and particularly preferably 1,000 μm or less.

[Overcoat Layer]

The TFT of the present invention may have an overcoat layer. The overcoat layer is a layer which is usually formed as a protective layer on the surface of a TFT. The overcoat layer may be of a single-layer structure or a multilayer structure.
The overcoat layer may be an organic overcoat layer or an inorganic overcoat layer.
The material for forming the organic overcoat layer is not particularly limited, but examples thereof include organic polymers such as polystyrene, an acrylic resin, polyvinyl alcohol, polyolefin, polyimide, polyurethane, polyacenaphtylene, and an epoxy resin, and derivatives obtained by introducing a crosslinkable group, a water-repellent group, or the like into these organic polymers. These organic polymers and derivatives thereof may also be used in combination with a crosslinking component, a fluorine compound, a silicon compound, or the like.
The material for forming the inorganic overcoat layer is not particularly limited, but examples thereof include metal oxides such as silicon oxide and aluminum oxide, and metal nitrides such as silicon nitride.
These materials may be used singly or as a combination of two or more kinds in any combination and in any ratio.
There is no limitation on the method for forming an overcoat layer, and the overcoat layer can be formed by various known methods.
For example, the organic overcoat layer can be formed by, for example, a method of applying a solution containing a material for the overcoat layer, followed by drying, exposure, development to perform patterning, and the like, in which the solution containing a material for the overcoat layer is applied onto a layer serving as the underlayer, and then the overcoat layer is dried. In addition, the patterning of the overcoat layer may also be directly formed by a printing method, an inkjet method, or the like. Moreover, the overcoat layer may be crosslinked by exposing or heating after patterning of the overcoat layer.
On the other hand, the inorganic overcoat layer can be formed by a dry method such as a sputtering method or a vapor deposition method, or a wet method such as a sol-gel method.

[Other Layers]

The TFT of the present invention may be provided with layers or members other than the above-described layers.
The other layers or members may include, for example, a bank and the like. The bank can be used for the purpose of damming a discharge liquid at a predetermined position or the like, when forming a semiconductor layer, an overcoat layer, or the like by an inkjet method or the like. Therefore, the bank usually has liquid repellency. The method of forming a bank includes, for example, a method of patterning by a photolithographic method or the like and then performing liquid repellency treatment such as by a fluorine plasma method, a method of curing a photosensitive composition or the like containing a liquid repellent component such as a fluorine compound, and the like methods.
In a case of the organic thin film transistor of the present invention, since the gate insulating layer is an organic layer, the latter method of curing a photosensitive composition containing a liquid repellent component is preferred because there is no possibility of the gate insulating layer being affected by liquid repellency treatment. It may use a technique allowing the underlayer to have a contrast of liquid repellency without using a bank, thereby rendering it to have the same role as the bank.

[Production Method]

The TFT of the present invention can be produced by the film formation or provision of a gate electrode, a gate insulating layer, a semiconductor layer, a source electrode, a drain electrode, and the like on a substrate by the method described above.
In particular, the use of an organic material as the material for forming a gate insulating layer or a semiconductor layer allows for production of a TFT exhibiting the above-mentioned excellent properties while taking advantages of a solution coating method.

[Display Panel]

An example of use applications of the organic thin film transistor of the present invention may be a display panel. Examples of the display panel include a liquid crystal panel, an organic EL panel, and an electronic paper panel.

EXAMPLES

Hereinafter, the present invention will be described in more detail with reference to Examples, but the present invention is not limited thereto.

Polymer compounds AP1 to AP18 used in each Example are shown below. Each polymer compound was synthesized by the above-mentioned method.

For each polymer compound, the weight average molecular weight (Mw, in terms of standard polystyrene) was measured by gel permeation chromatography (GPC, manufactured by Tosoh Corporation; HLC-8120; Tskgel Multipore HXL-M) using THF as a solvent.

Further, the composition ratio (molar ratio) of each polymer compound was calculated by $^{1}$H-NMR or $^{13}$C-NMR using an NMR measuring device (manufactured by Bruker BioSpin Corporation; AVANCEIII400 type). In addition, the description of the composition ratio corresponds to the description of a repeating unit shown in a chemical formula.

The results obtained are shown below.

| Polymer compound | Chemical formula | Composition ratio (molar ratio) | Weight average molecular weight |
|---|---|---|---|
| AP1 | 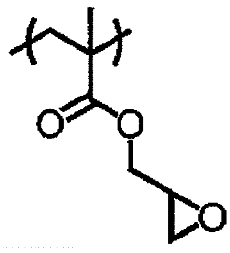 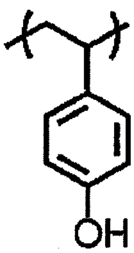 | 15/85 | 4,000 |
| AP2 | 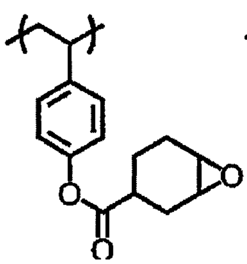 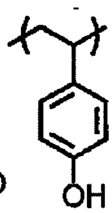 | 15/85 | 3,800 |
| AP3 | 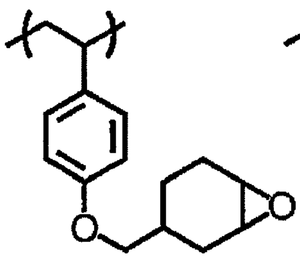 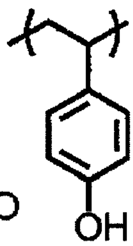 | 15/85 | 4,200 |
| AP4 | 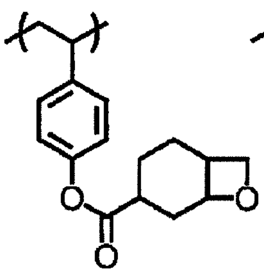 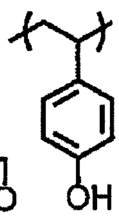 | 15/85 | 3,900 |

(continued)

| Polymer compound | Chemical formula | Composition ratio (molar ratio) | Weight average molecular weight |
|---|---|---|---|
| AP5 | 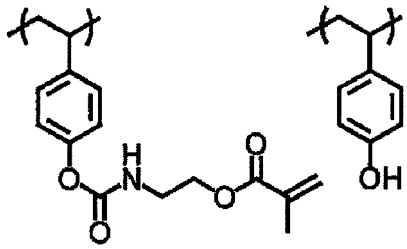 | 15/85 | 4,000 |
| AP6 | 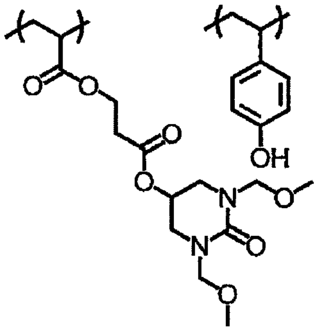 | 15/85 | 4,000 |

| Polymer compound | Chemical formula | Composition ratio (molar ratio) | Weight average molecular weight |
|---|---|---|---|
| AP7 | 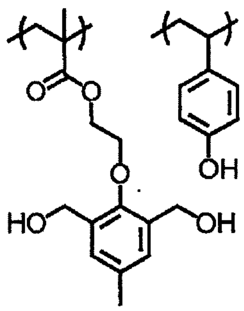 | 15/85 | 4,000 |
| AP8 | 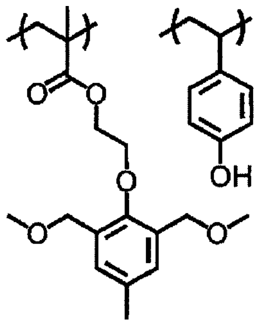 | 15/85 | 4,000 |

(continued)

| Polymer compound | Chemical formula | Composition ratio (molar ratio) | Weight average molecular weight |
|---|---|---|---|
| AP9 | 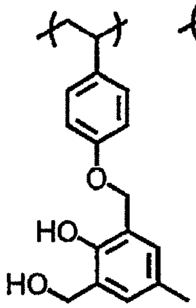 | 15/85 | 3,700 |
| AP10 | 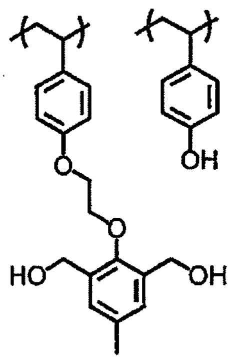 | 15/85 | 3,700 |
| AP11 | 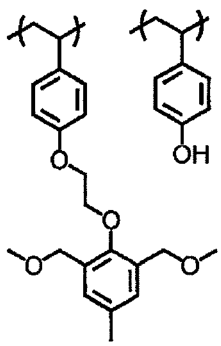 | 5/95 | 4,000 |
| AP12 | | 15/85 | 4,500 |
| AP13 | | 25/75 | 5,000 |
| AP14 | | 35/65 | 5,500 |

| Polymer compound | Chemical formula | Composition ratio (molar ratio) | Weight average molecular weight |
|---|---|---|---|
| AP15 | 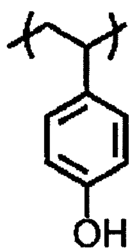 | 100 | 2,500 |

(continued)

| Polymer compound | Chemical formula | Composition ratio (molar ratio) | Weight average molecular weight |
|---|---|---|---|
| AP16 | 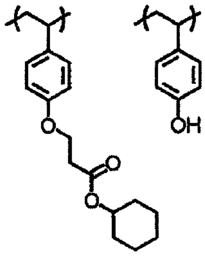 | 15/85 | 4,000 |
| AP17 | 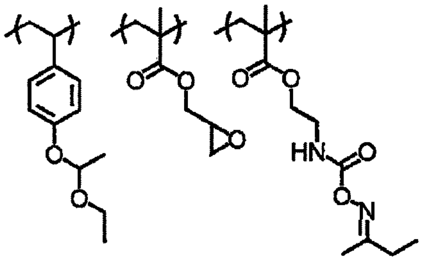 | 50/30/20 | 25,500 |
| AP18 | 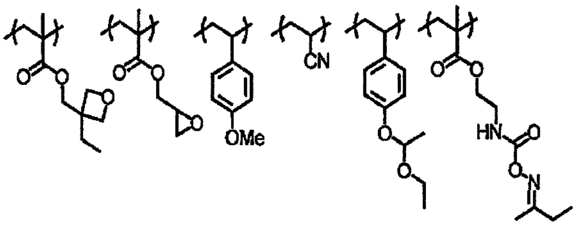 | 25/5/25/20/15/10 | 95,000 |

A crosslinking agent CA1 is shown below.

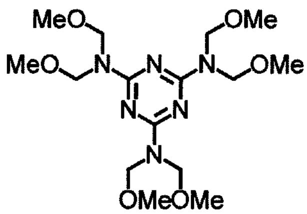

In each Example, the above-mentioned compound A6 and the following compound C16 were used as an organic semiconductor.

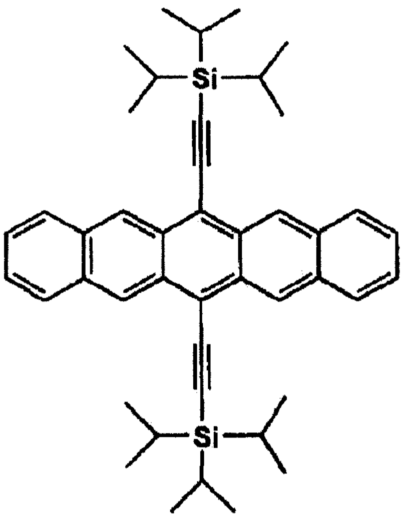

Compound A6

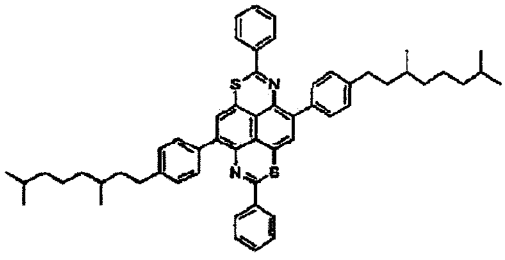

Compound C16

The compound A6 was synthesized in accordance with a known method.

Compound C16 is a compound represented by General Formula (C), and was synthesized according to the following synthesis method of Compound C1 shown below.

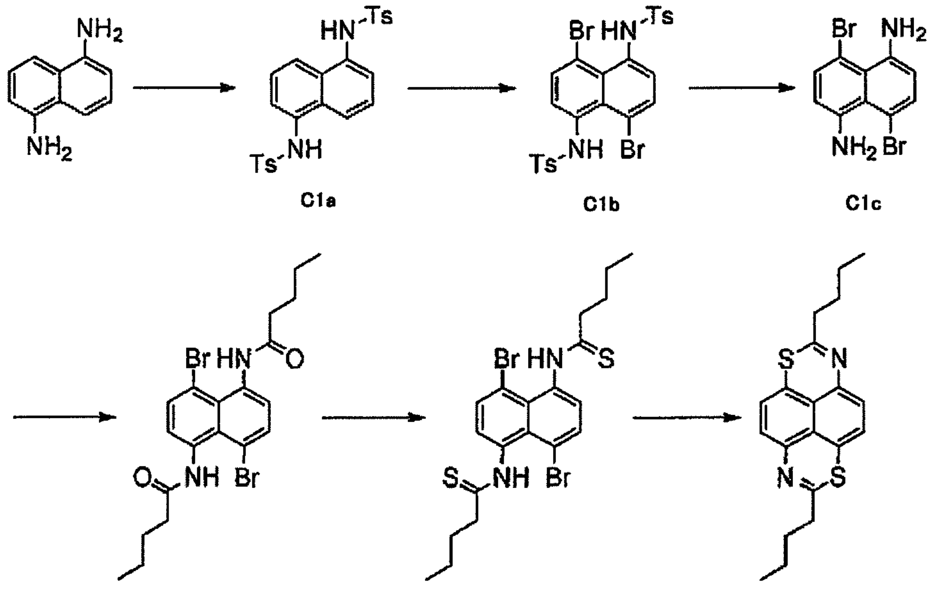

C1a C1b C1c

C1d C1e Compound C1

(Synthesis of Compound C1a)

p-Toluenesulfonyl chloride (34 g) was added slowly to a pyridine solution (125 mL) of 1,5-diaminonaphthalene (10 g) which was then stirred at room temperature for 2 hours. The reaction liquid was poured into ice water, and the precipitate was filtered under reduced pressure. The resulting crude crystal was washed with methanol to give Compound C1a (29 g)

(Synthesis of Compound C1b)

A glacial acetic acid solution of Compound C1a (10 g) was stirred with heating at 95°C, and bromine (2 mL) diluted with 10 mL of glacial acetic acid was slowly added dropwise thereto. The reaction liquid was reacted for 10 minutes, followed by allowing to cool, and filtered to obtain a crude crystal as a gray solid. The crude crystal was re-crystallized in nitrobenzene to give Compound C1b (6.8 g).

(Synthesis of Compound C1c)

A concentrated sulfuric acid solution of Compound C1b (5 g) was stirred at room temperature for 24 hours. The reaction liquid was poured into ice water, and the precipitated solid was recovered by filtration. The solid was dispersed again in ice water, and neutralized with ammonia water to give Compound C1c (0.5 g).

(Synthesis of Compound C1d)

At room temperature, pentanoyl chloride (valeric acid chloride) (2.6 mL) was added dropwise to a pyridine solution of Compound C1c (2 g) which was then stirred for 2 hours. The reaction liquid was poured into ice water, and the solid was filtered under reduced pressure. The solid was dispersed in methanol, stirred for 1 hour, and then filtered to give Compound C1d (1.39 g).

(Synthesis of Compound C1e)

Compound C1d (1.2 g) and Lawesson's reagent (1.48 g) were added to a mixed solution of THF (360 mL) and toluene (72 mL), and stirred for 3 hours while heating under reflux. Only THF was removed by evaporation to make a toluene solution which was then stirred for 1 hour at 60°C. Thereafter, the insoluble matter was filtered to give Compound C1e (0.5 g).

(Synthesis of Compound C1)

Compound C1e (0.4 g) and cesium carbonate (1.33 g) were reacted in dimethyl acetamide at 120°C for 2 hours. The reaction liquid was poured into water and the precipitate was filtered. The filtered solid was repeatedly recrystallized in THF to synthesize a target compound C1 (0.12 g). Identification of the resulting compound C1 was carried out by $^1$H-NMR and mass spectrum.

[Example 1]

[Preparation of Bottom Gate Type OTFT]

A bottom gate-top contact type OTFT shown in Fig. 1B was prepared.

An ITO electrode-attached glass substrate, in which an indium tin oxide (ITO) film having a film thickness of 100 nm was formed on a glass substrate having a thickness of 0.7 mm, was washed with acetone and isopropyl alcohol, and then dried. This was used as a substrate 6.

An insulating layer-forming composition was prepared at the time of forming a gate insulating layer 2. That is, 5 g of a polymer compound shown in Table 1 below and a crosslinking agent CA1 having a content indicated in Table 1 below were respectively dissolved in a mixed solvent of 1-butanol/ethanol = 1/1 (volume ratio). This solution was filtered through a polytetrafluoroethylene (PTFE) membrane filter of φ0.2 μm to prepare an insulating layer-forming composition.

The insulating layer-forming composition was applied onto the ITO electrode (gate electrode 5) of the glass substrate 6 by a spin coating method, and heated for 30 minutes at 180°C by air dryer to provide a gate insulating layer 2 having a thickness of 300 nm.

As the coating solution for forming an organic semiconductor layer, a coating solution in which an organic semiconductor shown in Table 1 has been dissolved at a compound concentration of 1 mass% in 1 mL of toluene was prepared. This coating solution was applied onto the gate insulating layer 2 to a layer thickness of 150 nm after drying, by a spin coating method (rotating speed: 500 rpm) at 25°C. This was followed by heating on a hot plate for 30 minutes at 150°C to form an organic semiconductor layer 1.

Then, electrodes made of comb-like arranged chromium/gold (gate width W = 100 mm, and gate length L = 100 μm) were formed as a source electrode 3 and a drain electrode 4 as shown in Fig. 1B, by a vacuum deposition method using a metal deposition mask.

In this manner, OTFTs (Sample Nos. 1-1 to 1-16 and c1-1 to c1-4 for comparison) shown in Fig. 1B were respectively prepared.

[Evaluation of Gate Insulating Layer]

Gate insulating layers formed in the same manner as in each of the above-mentioned samples or insulating layers formed by the following method were evaluated for properties thereof. The results are shown in Table 1.

(Measurement of Specific Permittivity)

On each of gate insulating layers formed in the same manner as in each of the above-mentioned samples, a gold electrode having a thickness of 100 nm was formed by vacuum deposition. Using the resulting structure as a sample, the specific permittivity was measured by a dielectric measurement system Model 126096W (manufactured by Solartron Co., Ltd.).

(Measurement of Volume Resistivity)

On each of gate insulating layers formed in the same manner as in each of the above-mentioned samples, a gold electrode having a thickness of 100 nm was formed by vacuum deposition. Using the resulting structure as a sample, the volume resistivity (Ω·cm) was measured by a Model 6517B Electrometer/Resistance Meter (manufactured by Keithley Inc.).

(Evaluation of Surface Smoothness)

The insulating layer-forming composition used for each of the above-mentioned samples was spin-coated on a silicon wafer, and then prebaked on a hot plate at 90°C for 2 minutes to form a film having a thickness of 300 nm. This was followed by heating for 1 hour at 130°C in air to thereby obtain a sample constituted of a silicon wafer on which an insulating layer was formed.

The surface of the insulating layer of the obtained sample was observed under an atomic force microscope (AMF) to measure surface roughness (arithmetic mean roughness Ra). The measured Ra was evaluated according to the following evaluation standard. The evaluation results of the sample were taken as an evaluation of a gate insulating layer of an OTFT. In this test, the evaluation is required to be A or B, and preferably A.

A: Less than or equal to 0.5 nm
B: Greater than 0.5 nm and less than or equal to 1.0 nm
C: Greater than 1.0 nm and less than or equal to 1.5 nm
D: Greater than 1.5 nm

(Evaluation of Solvent Resistance)

Glass substrates on which each of gate insulating layers was formed in the same manner as in each of the above-mentioned samples were immersed in toluene for 12 hours to measure a layer thickness of the gate insulating layer before and after immersion thereof. Thickness variations before and after immersion were calculated from the following equation and evaluated according to the following evaluation standard. In this test, the evaluation is required to be A, $A^-$, or B, preferably A or $A^-$, and more preferably A.

Film thickness variation before and after immersion (%) = film thickness after immersion (μm)/film thickness before immersion (μm) × 100

A: Greater than or equal to 95% and less than or equal to 100%
$A^-$: Greater than 90% and less than or equal to 95%
B: Greater than 80% and less than or equal to 90%
C: Greater than 60% and less than or equal to 80%
D: Less than or equal to 60%

[Evaluation of TFTs]

The following evaluation was carried out for properties of each of prepared OTFTs. The results are shown in Table 1.

(Measurement of Carrier Mobility μ)

A voltage of -40 V was applied between the source electrode 3 and the drain electrode 4 of each OTFT, and gate voltage Vg was varied within the range of 40 V to -40 V to calculate carrier mobility μ ($cm^2/Vs$) using the following equation expressing drain current Id. Then, the evaluation was carried out according to the following evaluation standard. In this test, the evaluation is required to be A, $A^-$, or B, preferably A or $A^-$, and more preferably A.

$$Id=(w/2L)\mu Ci(Vg-Vth)^2$$

In the equation, L represents a gate length, w represents a gate width, Ci represents capacitance per unit area of a gate insulating layer 2, Vg represents a gate voltage, and Vth represents a threshold voltage.

A: Greater than 0.7 $cm^2/Vs$ and less than or equal to 0.8 $cm^2/Vs$
$A^-$: Greater than 0.5 $cm^2/Vs$ and less than or equal to 0.7 $cm^2/Vs$
B: Greater than 0.3 $cm^2/Vs$ and less than or equal to 0.5 $cm^2/Vs$
$B^-$: Greater than 0.1 $cm^2/Vs$ and less than or equal to 0.3 $cm^2/Vs$
C: Greater than 0.05 $cm^2/Vs$ and less than or equal to 0.10 $cm^2/Vs$
D: Greater than or equal to 0.01 $cm^2/Vs$ and less than or equal to 0.05 $cm^2/Vs$

(Measurement of On/Off Ratio)

The (maximum value of |Id|)/(minimum value of |Id|) when fixing a voltage applied between the source electrode 3 and the drain electrode 4 of each OTFT to -40 V and varying gate voltage Vg from 40 V to -40 V was taken as the on/off ratio. In this test, the evaluation is required to be A, $A^-$, or B, preferably A or $A^-$, and more preferably A.

A: Greater than or equal to $1 \times 10^7$
$A^-$: Greater than or equal to $5\times10^6$ and less than $1\times10^7$
B: Greater than or equal to $1\times10^6$ and less than $5\times10^6$
$B^-$: Greater than or equal to $5\times10^5$ and less than $1\times10^6$
C: Greater than or equal to $1\times10^5$ and less than $5\times10^5$
D: Less than $1\times10^5$

[Table 1]

| Sample No. | Insulating layer-forming composition | | | | Evaluation of gate insulating layer | | | | Evaluation of OTFT | | Remarks |
|---|---|---|---|---|---|---|---|---|---|---|---|
| | Polymer compound | Crosslinking agent | Content of crosslinking agent (mass%) | Organic semiconductor | Specific permittivity | Volume resistivity | Surface smoothness | Solvent resistance | Mobility | On/Off ratio | |
| 1-1* | AP1 | No | 0 | A6 | 3.7 | $3\times10^{16}$ | B | B | B | B | Invention |
| 1-2* | AP2 | No | 0 | A6 | 3.7 | $3\times10^{16}$ | B | B | B | B | Invention |
| 1-3* | AP3 | No | 0 | A6 | 3.7 | $3\times10^{16}$ | B | B | B | B | Invention |
| 1-4* | AP4 | No | 0 | A6 | 3.7 | $3\times10^{16}$ | B | B | B | B | Invention |
| 1-5* | AP5 | No | 0 | A6 | 3.7 | $1\times10^{16}$ | B | B | B | B | Invention |
| 1-6 | AP6 | No | 0 | A6 | 3.7 | $6\times10^{16}$ | B | $A^-$ | B | B | Invention |
| 1-7 | AP6 | Yes | 15 | A6 | 3.7 | $3\times10^{16}$ | B | B | B | B | Invention |
| 1-8 | AP7 | No | 0 | A6 | 3.7 | $6\times10^{16}$ | B | $A^-$ | B | B | Invention |
| 1-9 | AP8 | No | 0 | A6 | 4.0 | $6\times10^{16}$ | A | $A^-$ | $A^-$ | B | Invention |
| 1-10 | AP9 | No | 0 | A6 | 4.0 | $6\times10^{16}$ | A | $A^-$ | A | B | Invention |
| 1-11 | AP10 | No | 0 | A6 | 4.0 | $6\times10^{16}$ | A | $A^-$ | $A^-$ | B | Invention |
| 1-12 | AP11 | No | 0 | A6 | 4.0 | $6\times10^{16}$ | A | $A^-$ | $A^-$ | B | Invention |
| 1-13 | AP12 | No | 0 | A6 | 4.1 | $6\times10^{16}$ | A | $A^-$ | $A^-$ | $A^-$ | Invention |
| 1-14 | AP13 | No | 0 | A6 | 4.2 | $6\times10^{16}$ | A | $A^-$ | $A^-$ | B | Invention |
| 1-15 | AP14 | No | 0 | A6 | 4.4 | $6\times10^{16}$ | A | $A^-$ | $A^-$ | B | Invention |
| 1-16 | AP13 | No | 0 | C16 | 4.2 | $8\times10^{16}$ | A | A | A | A | Invention |
| C1-1 | AP15 | Yes | 15 | A6 | 3.5 | $3\times10^{15}$ | C | C | C | C | Comparative Example |
| C1-2 | AP16 | Yes | 15 | C16 | 3.5 | $3\times10^{15}$ | C | D | D | D | Comparative Example |
| C1-3 | AP17 | No | 0 | C16 | 3.5 | $3\times10^{15}$ | C | C | C | C | Comparative Example |

(continued)

| Sample No. | Insulating layer-forming composition | | | | Evaluation of gate insulating layer | | | | Evaluation of OTFT | | Remarks |
|---|---|---|---|---|---|---|---|---|---|---|---|
| | Polymer compound | Crosslinking agent | Content of crosslinking agent (mass%) | Organic semiconductor | Specific permittivity | Volume resistivity | Surface smoothness | Solvent resistance | Mobility | On/Off ratio | |
| C1-4 | AP18 | No | 0 | C16 | 3.5 | $2\times10^{15}$ | C | C | C | C | Comparative Example |
| *Reference | | | | | | | | | | | |

As shown in Table 1, when an insulating layer-forming composition containing polymer compounds AP1 to AP14 having the repeating unit (IA) represented by General Formula (IA) and the repeating unit (IB) represented by General Formula (IB) is used to crosslink these polymer compounds, the gate insulating layer 2 having excellent surface smoothness could be formed. Further, the gate insulating layer 2 exhibited high insulating properties due to increased volume resistivity while maintaining a small specific permittivity. In addition, the gate insulating layer 2 also exhibited excellent solvent resistance.

As seen from the above, the gate insulating layer 2 formed of the insulating layer-forming composition of the present invention contains a cured product of the above-mentioned polymer compound to thereby achieve both of high surface smoothness and high insulating properties. Therefore, all of OTFTs of the present invention having the gate insulating layer 2 provided adjacent to a semiconductor layer have high carrier mobility $\mu$ and on/off ratio, and excellent performance, as compared to comparative OTFTs having a gate insulating layer formed of a cured product of a polymer compound which does not have the repeating units represented by General Formula (IA) and General Formula (IB).

It has been found that the polymer compound having the repeating unit (IA) and the repeating unit (IB) is capable of forming a cured product by crosslinking of these repeating units (IA), and has also the above-mentioned performance improving effect of OTFTs even without crosslinking using a crosslinking agent.

Further, it has been found that the above-mentioned performance improving effect of OTFTs according to the invention is further increased when a polymer compound has the repeating unit (IA-1) represented by General Formula (IA-1) or the repeating unit (IA-2) represented by General Formula (IA-2).

Focusing on the repeating unit (IA), the performance of OTFTs has tended to increase in the order of polymer compounds AP12>AP9 and AP10>AP8>AP7>AP6.

[Example 2]

[Preparation and Evaluation of Bottom Gate Type OTFT With Change of Organic Semiconductor]

In Example 2, bottom gate type OTFTs were prepared using organic semiconductors other than the above-mentioned organic semiconductors, and were evaluated for properties thereof and the like.

That is, OTFTs shown in Fig. 1B were respectively prepared in the same manner as in Example 1, except that the above-mentioned A26, A27, C1, C4, C7, D1, E2, F2, F5, F10, G12, G14, H10, H11, J2, J3, K2, K3, L2, L5, L6, L8, L9, L15, M3, M8, N4, P3, Q3, R1, S1, or T1 was used as the organic semiconductor in Example 1.

For each of the thus-prepared OTFTs, carrier mobility $\mu$ and an on/off ratio were evaluated in the same manner as in Example 1. As a result, any of TFTs had excellent properties similar to Example 1.

Explanation of References

1: Semiconductor layer (Organic semiconductor layer)
2: Gate insulating layer
3: Source electrode
4: Drain electrode
5: Gate electrode
6: Substrate

## Claims

**1.** A semiconductor element comprising:

a semiconductor layer; and
an insulating layer adjacent to the semiconductor layer,
wherein the insulating layer is formed of a crosslinked product of a polymer compound having a repeating unit (IA) represented by the following General Formula (IA) and a repeating unit (IB) represented by the following General Formula (IB),

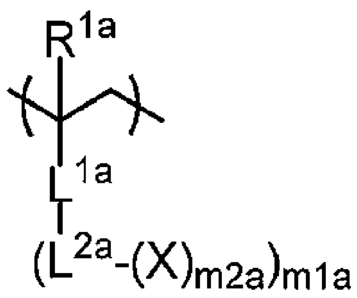

General Formula (IA)

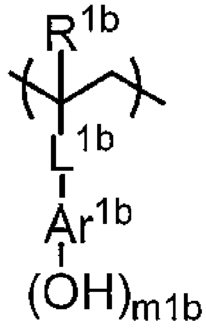

General Formula (IB)

in General Formula (IA), $R^{1a}$ represents a hydrogen atom, a halogen atom, or an alkyl group, $L^{1a}$ and $L^{2a}$ each independently represent a single bond or a linking group, X represents a crosslinkable group which is a hydroxymethyl group or an alkoxymethyl group, m2a represents an integer of 1 to 5, and in a case where m2a is 2 or more, m2a number of X's may be the same or different from each other, and m1a represents an integer of 1 to 5, and in a case where m1a is 2 or more, m1a number of $(-L^{2a}-(X)_{m2a})$'s may be the same or different from each other, and
in General Formula (IB), $R^{1b}$ represents a hydrogen atom, a halogen atom, or an alkyl group, $L^{1b}$ represents a single bond or a linking group, $Ar^{1b}$ represents an aromatic ring, and mlb represents an integer of 1 to 5.

**2.** The semiconductor element according to claim 1, wherein $L^{1a}$ is represented by the following Formula (1a),

Formula (1a) $*-Ar^{1a}-L^{3a}-**$

in Formula (1a), $L^{3a}$ represents a single bond or a linking group, $Ar^{1a}$ represents an aromatic ring, * indicates the bonding position of the carbon atom to which $R^{1a}$ in the repeating unit (IA) is bonded, and ** indicates the bonding position of $L^{2a}$ in the repeating unit (IA).

**3.** The semiconductor element according to claim 2, wherein $Ar^{1a}$ is a benzene ring.

**4.** The semiconductor element according to any one of claims 1 to 3, wherein the repeating unit (IA) is a repeating unit (IA-1) represented by the following General Formula (IA-1),

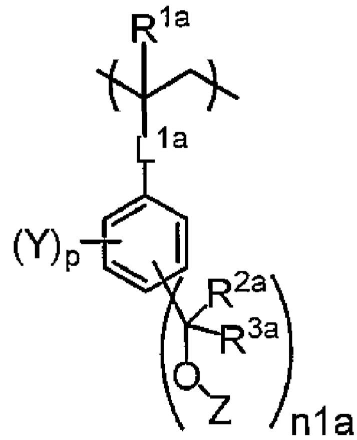

General Formula (IA-1)

in General Formula (IA-1), $L^{1a}$ has the same definition as $L^{1a}$ of General Formula (IA), $R^{2a}$ and $R^{3a}$ each independently represent a hydrogen atom or a methyl group, Z represents a hydrogen atom or an alkyl group, Y represents a monovalent substituent, n1a represents an integer of 1 to 5, p represents an integer of 0 to 4, in a case where n1a is 2 or more, n1a number of $R^{2a}$'s and $R^{3a}$'s and also Z's may be the same or different from each other, respectively,

and in a case where p is 2 or more, p number of Y's may be the same or different from each other.

**5.** The semiconductor element according to any one of claims 1 to 3, wherein the repeating unit (IA) is a repeating unit (IA-2) represented by the following General Formula (IA-2),

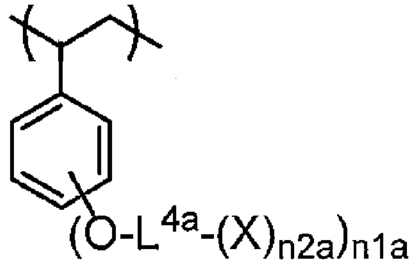

General Formula (IA-2)

in General Formula (IA-2), $L^{4a}$ represents a single bond or a linking group, X represents a crosslinkable group which is a hydroxymethyl group or an alkoxymethyl group, n2a represents an integer of 1 to 5, and in a case where n2a is 2 or more, n2a number of X's may be the same or different from each other, and n1a represents an integer of 1 to 5, and in a case where n1a is 2 or more, n1a number of $(\text{-O-}L^{4a}\text{-}(X)_{n2a})$'s may be the same or different from each other.

**6.** The semiconductor element according to any one of claims 1 to 5, wherein the crosslinked product is a crosslinked product by a crosslinking reaction between the crosslinkable group X of the repeating unit (IA) and the repeating unit (IB).

**7.** The semiconductor element according to claim 6, wherein the crosslinked product has a crosslinked portion where a hydroxymethyl group or an alkoxymethyl group as a crosslinkable group is formed by a reaction.

**8.** The semiconductor element according to any one of claims 1 to 7, wherein the semiconductor layer contains an organic semiconductor.

**Patentansprüche**

**1.** Halbleiterelement, enthaltend:

eine Halbleiterschicht und
eine Isolationsschicht, die zu der Halbleiterschicht benachbart ist,
worin die Isolationsschicht aus einem vernetzten Produkt einer Polymerverbindung mit einer Wiederholungseinheit (IA) mit der folgenden allgemeinen Formel (IA) und einer Wiederholungseinheit (IB) mit der folgenden allgemeinen Formel (IB) gebildet ist,

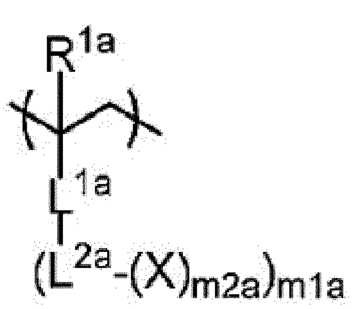

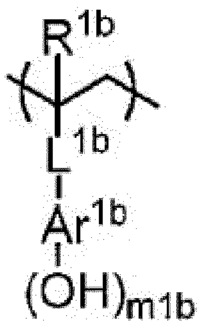

Allgemeine Formel (IA)  Allgemeine Formel (IB)

worin in der allgemeinen Formel (IA) $R^{1a}$ ein Wasserstoffatom, Halogenatom oder Alkylgruppe ist, $L^{1a}$ und $L^{2a}$ jeweils unabhängig eine Einfachbindung oder Bindegruppe sind, X eine vernetzbare Gruppe ist, die eine Hydroxymethyl- oder Alkoxymethylgruppe ist, m2a eine ganze Zahl von 1 bis 5 ist und wenn m2a 2 oder mehr ist, können m2a-Zahl von X gleich oder verschieden voneinander sein, und m1a eine ganze Zahl von 1 bis 5 ist und wenn m1a 2 oder mehr ist, können mla-Zahlen von $(-L^{2a}-(X)_{m2a})$ gleich oder verschieden voneinander sein, und

worin in der allgemeinen Formel (IB) $R^{1b}$ ein Wasserstoffatom, Halogenatom oder eine Alkylgruppe ist, $L^{1b}$ eine Einfachbindung oder Bindegruppe ist, $Ar^{1b}$ ein aromatischer Ring ist und m1b eine ganze Zahl von 1 bis 5 ist.

**2.** Halbleiterelement gemäß Anspruch 1, worin $L^{1a}$ durch die folgende Formel (1a) dargestellt ist,

Formel (1a) $*-Ar1^{a}-L^{3a}-**$

worin in der Formel (1a) $L^{3a}$ eine Einfachbindung oder Bindegruppe ist, $Ar^{1a}$ ein aromatischer Ring ist, * die Bindeposition des Kohlenstoffatoms anzeigt, an das $R^{1a}$ in der Wiederholungseinheit (IA) gebunden ist, und ** die Bindeposition von $L^{2a}$ in der Wiederholungseinheit (IA) zeigt.

**3.** Halbleiterelement gemäß Anspruch 2, worin $Ar^{1a}$ ein Benzolring ist.

**4.** Halbleiterelement gemäß einem der Ansprüche 1 bis 3, worin die Wiederholungseinheit (IA) eine Wiederholungseinheit (IA-1) mit der folgenden allgemeinen Formel (IA-1) ist

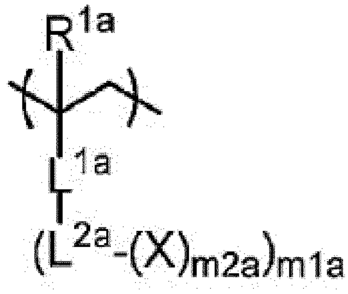

Allgemeine Formel (IA-1)

worin in der allgemeinen Formel (IA-1) $L^{1a}$ die gleiche Definition wie $L^{1a}$ der allgemeinen Formel (IA) aufweist, $R^{2a}$ und $R^{3a}$ jeweils unabhängig ein Wasserstoffatom oder eine Methylgruppe sind, Z ein Wasserstoffatom oder Alkylgruppe ist, Y ein monovalenter Substituent ist, n1a eine ganze Zahl von 1 bis 5 ist, p eine ganze Zahl von 0 bis 4 ist, wenn n1a 2 oder mehr ist, können n1a-Zahlen von $R^{2a}$ und $R^{3a}$ und ebenfalls Z gleich oder verschieden voneinander sein und wenn p 2 oder mehr ist, können p-Zahlen von Y gleich oder verschieden voneinander sein.

**5.** Halbleiterelement gemäß einem der Ansprüche 1 bis 3, worin die Wiederholungseinheit (IA) eine Wiederholungseinheit (IA-2) mit der folgenden allgemeinen Formel (IA-2) ist

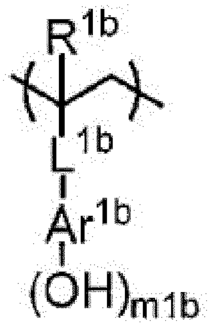

Allgemeine Formel (IA-2)

worin in der allgemeinen Formel (IA-2) $L^{4a}$ eine Einfachbindung oder Bindegruppe ist, X eine vernetzbare Gruppe ist, die eine Hydroxymethyl- oder Alkoxymethylgruppe ist, n2a eine ganze Zahl von 1 bis 5 ist und wenn n2a 2 oder mehr ist, können die n2a-Zahlen von X gleich oder verschieden voneinander sein und worin n1a reine ganze Zahl von 1 bis 5 ist, und wenn n1a 2 oder mehr ist, können n1a-Zahlen von $(-O-L^{4a}-(X)_{n2a})$ gleich oder verschieden voneinander sein.

**6.** Halbleiterelement gemäß einem der Ansprüche 1 bis 5, worin das vernetzte Produkt ein vernetztes Produkt durch eine Vernetzungsreaktion zwischen der vernetzbaren Gruppe X der Wiederholungseinheit (IA) und der Wiederholungseinheit (IB) ist.

**7.** Halbleiterelement gemäß Anspruch 6, worin das vernetzte Produkt einen vernetzten Bereich hat, worin eine Hydroxymethyl- oder Alkoxymethylgruppe als vernetzbare Gruppe durch eine Reaktion gebildet ist.

**8.** Halbleiterelement gemäß einem der Ansprüche 1 bis 7, worin die Halbleiterschicht einen organischen Halbleiter enthält.

## Revendications

**1.** Élément semi-conducteur comprenant :

une couche semi-conductrice ; et
une couche isolante adjacente à la couche semi-conductrice,
dans lequel la couche isolante est formée d'un produit réticulé d'un composé polymère présentant une unité de répétition (IA) représentée par la Formule Générale (IA) suivante et une unité de répétition (IB) représentée par la Formule Générale (IB) suivante,

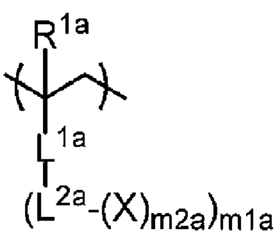

Formule Générale (IA)

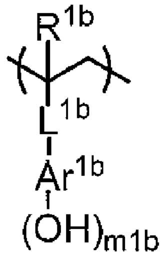

Formule Générale (IB)

dans la Formule Générale (IA), $R^{1a}$ représente un atome d'hydrogène, un atome d'halogène, ou un groupe alkyle, $L^{1a}$ et $L^{2a}$ représentent chacun indépendamment une simple liaison ou un groupe de liaison, X représente un groupe réticulable qui est un groupe hydroxyméthyle ou un groupe alcoxyméthyle, m2a représente un entier de 1 à 5, et dans un cas où m2a est 2 ou plus, les nombres m2a des X peuvent être identiques ou différents, et m1a représente un entier de 1 à 5, et dans un cas où m1a est 2 ou plus, les nombres m1a de $(-L^{2a}-(X)_{m2a})$ peuvent être identiques ou différents, et
dans la Formule Générale (IB), $R^{1b}$ représente un atome d'hydrogène, un atome d'halogène, ou un groupe alkyle, $L^{1b}$ représente une simple liaison ou un groupe de liaison, $Ar^{1b}$ représente un cycle aromatique, et m1b représente un entier de 1 à 5.

**2.** Élément semi-conducteur selon la revendication 1, dans lequel $L^{1a}$ est représenté par la Formule (1a) suivante,

Formule (1a) $*-Ar^{1a}-L^{3a}-**$

dans la Formule (1a), $L^{3a}$ représente une simple liaison ou un groupe de liaison, $Ar^{1a}$ représente un cycle aromatique, * indique la position de liaison de l'atome de carbone auquel $R^{1a}$ dans l'unité de répétition (IA) est lié, et ** indique la position de liaison de $L^{2a}$ dans l'unité de répétition (IA).

**3.** Élément semi-conducteur selon la revendication 2, dans lequel $Ar^{1a}$ est un cycle de benzène.

4. Élément semi-conducteur selon l'une quelconque des revendications 1 à 3, dans lequel l'unité de répétition (IA) est une unité de répétition (IA-1) représentée par la Formule Générale (IA-1) suivante,

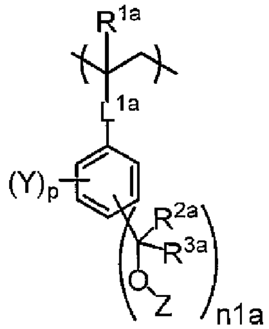

Formule Générale (IA-1)

dans la Formule Générale (IA-1), $L^{1a}$ a la même définition que $L^{1a}$ de la Formule Générale (IA), $R^{2a}$ et $R^{3a}$ représentent chacun indépendamment un atome d'hydrogène ou un groupe méthyle, Z représente un atome d'hydrogène ou un groupe alkyle, Y représente un substituant monovalent, n1a représente un entier de 1 à 5, p représente un entier de 0 à 4, dans un cas où n1a est 2 ou plus, les nombres n1a des $R^{2a}$ et $R^{3a}$ et également Z peuvent être identiques ou différents, respectivement, et dans un cas où p est 2 ou plus, les nombres p des Y peuvent être identiques ou différents.

5. Élément semi-conducteur selon l'une quelconque des revendications 1 à 3, dans lequel l'unité de répétition (IA) est une unité de répétition (IA-2) représentée par la Formule Générale (IA-2) suivante,

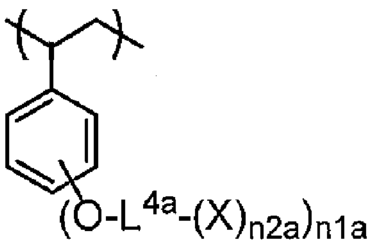

Formule Générale (IA-2)

dans la Formule Générale (IA-2), $L^{4a}$ représente une simple liaison ou un groupe de liaison, X représente un groupe réticulable qui est un groupe hydroxyméthyle ou un groupe alcoxyméthyle, n2a représente un entier de 1 à 5, et dans un cas où n2a est 2 ou plus, les nombres n2a des X peuvent être identiques ou différents, et n1a représente un entier de 1 à 5, et dans un cas où n1a est 2 ou plus, les nombres n1a de $(-O-L^{4a}-(X)_{n2a})$ peuvent être identiques ou différents.

6. Élément semi-conducteur selon l'une quelconque des revendications 1 à 5, dans lequel le produit réticulé est un produit réticulé par une réaction de réticulation entre le groupe réticulable X de l'unité de répétition (IA) et l'unité de répétition (IB).

7. Élément semi-conducteur selon la revendication 6, dans lequel le produit réticulé présente une partie réticulée où un groupe hydroxyméthyle ou un groupe alcoxyméthyle en tant que groupe réticulable est formé par une réaction.

8. Élément semi-conducteur selon l'une quelconque des revendications 1 à 7, dans lequel la couche semi-conductrice contient un semi-conducteur organique.

FIG. 1A

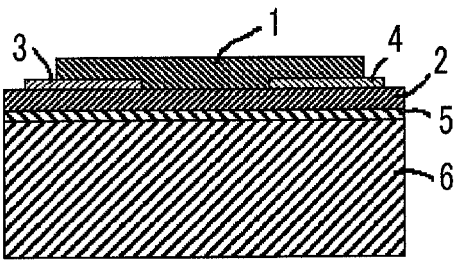


FIG. 1B

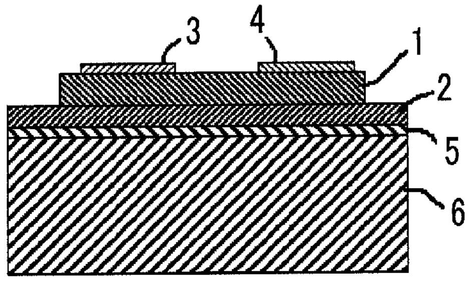


FIG. 1C

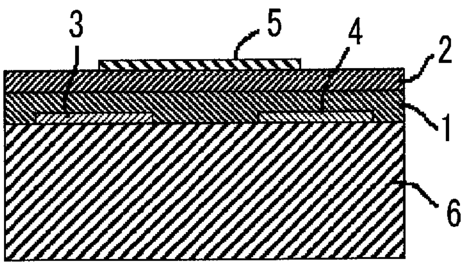


FIG. 1D

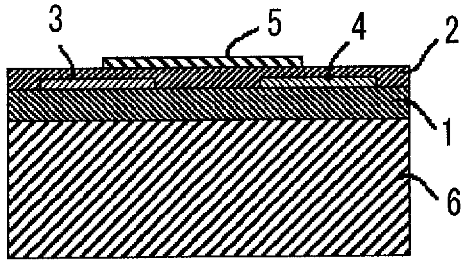

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013102116 A
- WO 2014017268 A1
- JP 2013140336 A
- US 6686124 B1
- DE 102010034577 A1
- EP 0133216 A
- DE 3634671
- DE 3711264
- EP 0212482 A
- JP 2006303465 A
- JP 2005354012 A
- JP 2013214649 A
- JP 2011186069 A
- JP 2010285518 A
- JP 2012163946 A


### Non-patent literature cited in the description


- *Langmuir,* 2003, vol. 19, 1159
- *J. Phys. Chem. B,* 2006, vol. 110, 21101